(19)

Europäisches
Patentamt
European
Patent Office
Office européen
des brevets

(11) **EP 4 421 789 A1**

(12) **EUROPEAN PATENT APPLICATION**
published in accordance with Art. 153(4) EPC

(43) Date of publication:
**28.08.2024 Bulletin 2024/35**

(21) Application number: **23806714.4**

(22) Date of filing: **27.04.2023**

(51) International Patent Classification (IPC):
*G09G 3/32* (2016.01)     *H10K 50/80* (2023.01)

(86) International application number:
**PCT/CN2023/091300**

(87) International publication number:
**WO 2023/221762 (23.11.2023 Gazette 2023/47)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **19.05.2022 PCT/CN2022/093952
25.07.2022 CN 202210874018**

(71) Applicants:
• **BOE Technology Group Co., Ltd.**
**Chaoyang District,**
**Beijing 100015 (CN)**
• **Chengdu BOE Optoelectronics Technology Co.,
Ltd.**
**Chengdu, Sichuan 611731 (CN)**

(72) Inventors:
• **WANG, Mengqi**
**Beijing 100176 (CN)**
• **YU, Ziyang**
**Beijing 100176 (CN)**
• **JIANG, Zhiliang**
**Beijing 100176 (CN)**
• **HU, Ming**
**Beijing 100176 (CN)**
• **QIU, Haijun**
**Beijing 100176 (CN)**

(74) Representative: **Durán-Corretjer, S.L.P.**
**Còrsega, 329**
**(Paseo de Gracia/Diagonal)**
**08037 Barcelona (ES)**

(54) **DISPLAY SUBSTRATE AND DRIVE METHOD AND PREPARATION METHOD THEREFOR, AND DISPLAY APPARATUS**

(57)     A display substrate and a drive method therefor, and a display apparatus. The display substrate comprises a plurality of circuit units, a plurality of data signal lines (60) and a plurality of data connection lines (70), wherein the data connection lines (70) comprise a first connection line (71) and a second connection line (72); at least one circuit unit comprises a data connection electrode (81); at least one circuit unit comprises a fan-out connection electrode (83); the second connection line (72) is connected to the first connection line (71) by means of the fan-out connection electrode (83); the first connection line (71) is connected to the data signal lines (60) by means of the data connection electrode (81); there is a first distance between the data connection electrode (81) and the first connection line (71); there is a second distance between the fan-out connection electrode (83) and the first connection line (71); and the first distance and the second distance are greater than 0.

FIG. 13

**Description**

The present application claims priority to PCT application No. PCT/CN2022/093952 filed to the CNIPA on May 19, 2022 and entitled "Display Substrate, Preparation Method Therefor, and Display Apparatus" and claims priority to Chinese patent application No. 202210874018.9 filed to the CNIPA on July 25, 2022 and entitled "Display Substrate, Driving Method Thereof, and Display Device", contents of the above-identified applications shall be understood to be incorporated into the present application by reference.

Technical Field

The present disclosure relates to, but is not limited to, the field of display technologies, and particularly to a display substrate, a drive method and a preparation method therefor, and a display apparatus.

Background

An Organic Light Emitting Diode (OLED for short) and a Quantum dot Light Emitting Diode (QLED for short) are active light emitting display devices and have advantages such as self-luminescence, a wide viewing angle, a high contrast ratio, low power consumption, an extremely high response speed, lightness and thinness, flexibility, and a low cost. With constant development of display technologies, a flexible display apparatus (Flexible Display) in which an OLED or a QLED is used as a light emitting device and signal control is performed through a Thin Film Transistor (TFT for short) has become a mainstream product in the field of display at present.

Summary

The following is a summary of subject matters described herein in detail. The summary is not intended to limit the protection scope of claims.

In one aspect, the present disclosure provides a display substrate, including a plurality of circuit units, a plurality of data signal lines, and a plurality of data connection lines, wherein the data connection lines include a first connection line extending along a first direction and a second connection line extending along a second direction, the data signal lines extend along the second direction, and the first direction and the second direction intersect; at least one circuit unit includes a data connection electrode, at least one circuit unit includes a fan-out connection electrode, wherein the second connection line is connected with the first connection line through the fan-out connection electrode, and the first connection line is connected with a data signal line through the data connection electrode; an orthographic projection of the data connection electrode on a plane of the display substrate is at least partially overlapped with an orthographic projection of the data signal line on the plane of the display substrate, an orthographic projection of the fan-out connection electrode on the plane of the display substrate is at least partially overlapped with an orthographic projection of the second connection line on the plane of the display substrate, and at least one data signal line is disposed between the data connection electrode and the fan-out connection electrode connected with a same first connection line.

In an exemplary implementation mode, the data connection electrode and the fan-out connection electrode connected with the same first connection line are respectively disposed on two sides of the first connection line.

In an exemplary implementation mode, at least one circuit unit includes a data connection block, wherein the data connection electrode is connected with the first connection line through the data connection block, and an orthographic projection of the data connection block on the plane of the display substrate is at least partially overlapped with the orthographic projection of the data signal line on the plane of the display substrate.

In an exemplary implementation mode, the first connection line, the data connection block, and the data connection electrode are connected with each other to be of an integral structure.

In an exemplary implementation mode, at least one circuit unit includes a fan-out connection block, wherein the fan-out connection electrode is connected with the first connection line through the fan-out connection block, and an orthographic projection of the fan-out connection block on the plane of the display substrate is at least partially overlapped with the orthographic projection of the second connection line on the plane of the display substrate.

In an exemplary implementation mode, the first connection line, the fan-out connection block, and the fan-out connection electrode are connected with each other to be of an integral structure.

In an exemplary implementation mode, at least one circuit unit includes a dummy electrode, wherein a position and a shape of the dummy electrode in one circuit unit are the same as a position and a shape of the fan-out connection electrode in another circuit unit.

In an exemplary implementation mode, an orthographic projection of the dummy electrode on the plane of the display substrate is at least partially overlapped with the orthographic projection of the second connection line on the plane of the display substrate.

In an exemplary implementation mode, the display substrate further includes a plurality of first power supply traces extending along the first direction and a plurality of second power supply traces extending along the second direction; at least one circuit unit includes a power supply connection electrode, wherein a second power supply trace is connected with a first power supply trace through the power supply connection electrode, and an orthographic projection of the power supply connection electrode on the plane of the display substrate is at least partially overlapped with an orthographic projection of the second power supply trace on the plane of the display substrate.

In an exemplary implementation mode, at least one circuit unit includes a power supply connection block, wherein the power supply connection electrode is connected with the first power supply trace through the power supply connection block, and an orthographic projection of the power supply connection block on the plane of the display substrate is at least partially overlapped with the orthographic projection of the second power supply trace on the plane of the display substrate.

In an exemplary implementation mode, the first power supply trace, the power supply connection block, and the power supply connection electrode are connected with each other to be of an integral structure.

In an exemplary implementation mode, at least one circuit unit includes a dummy electrode, wherein a position and a shape of the dummy electrode in one circuit unit are the same as a position and a shape of the power supply connection electrode in another circuit unit.

In an exemplary implementation mode, an orthographic projection of the dummy electrode on the plane of the display substrate is at least partially overlapped with the orthographic projection of the second power supply trace on the plane of the display substrate.

In an exemplary implementation mode, the first power supply trace and the first connection line are disposed in a same layer, at least one first power supply trace and at least one first connection line are disposed in at least one circuit row, a first fracture is disposed between the first connection line and the first power supply trace, and an orthographic projection of the first fracture on the plane of the display substrate is at least partially overlapped with the orthographic projection of the second power supply trace on the plane of the display substrate, or the orthographic projection of the first fracture on the plane of the display substrate is at least partially overlapped with the orthographic projection of the second connection line on the plane of the display substrate.

In an exemplary implementation mode, a first width of the first fracture is less than or equal to a second width of the second power supply trace or the second connection line, wherein the first width and the second width are dimensions in the first direction, and the orthographic projection of the first fracture on the plane of the display substrate is within a range of the orthographic projection of the second power supply trace or the second connection line on the plane of the display substrate.

In an exemplary implementation mode, the second power supply trace and the second connection line are disposed in a same layer, at least one second power supply trace and at least one second connection line are disposed in at least one circuit column, a second fracture is disposed between the second connection line and the second power supply trace, and an orthographic projection of the second fracture on the plane of the display substrate is at least partially overlapped with an orthographic projection of the first connection line or the first power supply trace on the plane of the display substrate.

In an exemplary implementation mode, a third width of the second fracture is equal to a fourth width of the first connection line or the first power supply trace, wherein the third width and the fourth width are dimensions in the second direction, and a boundary of an orthographic projection of the second fracture on the plane of the display substrate is flush with a boundary of the orthographic projection of the first connection line or the first power supply trace on the plane of the display substrate.

In an exemplary implementation mode, the display substrate includes a display region and a bonding region located on one side of the display region in the second direction, wherein the bonding region is provided with a bonding power supply lead, the bonding power supply lead is configured to continuously provide a high-level signal or a low-level signal, and at least one second power supply trace of the display region is connected with the bonding power supply lead of the bonding region.

In an exemplary implementation mode, the display substrate further includes a bezel region located on another side of the display region, wherein the bezel region is provided with a bezel power supply lead, the bezel power supply lead is configured to continuously provide a high-level signal or a low-level signal, and a plurality of first power supply traces of the display region are connected with the bezel power supply lead of the bezel region.

In an exemplary implementation mode, at least one circuit unit at least includes a pixel drive circuit, wherein the pixel drive circuit at least includes a storage capacitor and a plurality of transistors; in a plane perpendicular to the display substrate, the circuit unit includes a semiconductor layer, a first conductive layer, a second conductive layer, a third conductive layer, and a fourth conductive layer sequentially disposed on a base substrate, the semiconductor layer at least includes active layers of the plurality of transistors, the first conductive layer at least includes gate electrodes of the plurality of transistors and a first electrode plate of the storage capacitor, the second conductive layer at least includes a second electrode plate of the storage capacitor, the third conductive layer at least includes the first connection line, and the fourth conductive layer at least includes the data signal line and the second connection line.

In an exemplary implementation mode, the third conductive layer further includes a data connection electrode and a fan-out connection electrode respectively connected with the first connection line, wherein the data signal line is connected with the data connection electrode through a first connection hole, and the second connection line is connected with the fan-out connection electrode through a second connection hole.

In an exemplary implementation mode, the third conductive layer further includes a first power supply trace extending along the first direction and a power supply connection electrode connected with the first power supply trace, the fourth conductive layer further includes a second power supply trace extending along the second direction, and the second power supply trace is connected with the power supply connection electrode through a third connection hole.

In an exemplary implementation mode, a first fracture is disposed between the first connection line and the first power supply trace, the first fracture is covered by the second power supply trace or the second connection line, and a second fracture is disposed between the second connection line and the second power supply trace, and a boundary of an orthographic projection of the second fracture on the plane of the display substrate is flush with a boundary of an orthographic projection of the first connection line or the first power supply trace on the plane of the display substrate.

In an exemplary implementation mode, the third conductive layer further includes a dummy electrode, wherein the second connection line is connected with the dummy electrode through a connection hole.

In an exemplary implementation mode, the plurality of transistors include at least a first transistor as a first initialization transistor, a second transistor as a compensation transistor, a third transistor as a drive transistor, a fourth transistor as a data writing transistor, a fifth transistor and a sixth transistor as light emitting control transistors, and a seventh transistor as a second initialization transistor, wherein the second transistor and the fourth transistor are respectively located on two sides of the third transistor in the second direction.

In an exemplary implementation mode, the first transistor includes a first active layer, the second transistor includes a second active layer, the third transistor includes a third active layer, the fourth transistor includes a fourth active layer, the fifth transistor includes a fifth active layer, the sixth transistor includes a sixth active layer, the seventh transistor includes a seventh active layer, wherein the first active layer to the third active layer and the fifth active layer to the seventh active layer are connected with each other to be of an integral structure, and the fourth active layer is disposed separately.

In an exemplary implementation mode, the fourth active layer is disposed on a side of the fifth active layer in the first direction, wherein a first region of the fourth active layer is disposed on a side of a channel region of the fourth active layer away from the third active layer, and a second region of the fourth active layer is disposed on a side of the channel region of the fourth active layer close to the third active layer.

In an exemplary implementation mode, a first region of the fifth active layer is located between the second region of the fourth active layer and a second region of the sixth active layer.

In an exemplary implementation mode, the storage capacitor includes a first electrode plate and a second electrode plate, wherein an orthographic projection of the second electrode plate on the base substrate is at least partially overlapped with an orthographic projection of the first electrode plate on the base substrate, and the orthographic projection of the second electrode plate on the base substrate is at least partially overlapped with an orthographic projection of a connection point of a first region of the third active layer, the second region of the fourth active layer, and a second region of the fifth active layer on the base substrate.

In an exemplary implementation mode, the second electrode plate is connected with a protrusion, the protrusion is disposed at a corner of the second electrode plate close to the fourth active layer, wherein an orthographic projection of the protrusion on the base substrate is at least partially overlapped with the orthographic projection of the connection point of the first region of the third active layer, the second region of the fourth active layer, and the second region of the fifth active layer on the base substrate.

In an exemplary implementation mode, the pixel drive circuit is connected with a light emitting control line and a first power supply line, wherein the light emitting control line is configured to control turn-on or turn-off of the fifth transistor and the sixth transistor, the first power supply line is connected with the second electrode plate through a first electrode of the fifth transistor, and an orthographic projection of the first electrode of the fifth transistor on the base substrate is at least partially overlapped with an orthographic projection of the light emitting control line on the base substrate.

In another aspect, the present disclosure also provides a display apparatus, including the aforementioned display substrate.

In yet another aspect, the present disclosure also provides a drive method for driving a display substrate, the display substrate includes a plurality of circuit units, wherein at least one circuit unit includes a pixel drive circuit, the pixel drive circuit at least includes a compensation transistor, a drive transistor, and a data writing transistor, wherein a gate electrode of the compensation transistor is connected with a first scan signal line, a first electrode of the compensation transistor is connected with a gate electrode of the drive transistor, a second electrode of the compensation transistor is connected with a second electrode of the drive transistor, a gate electrode of the data writing transistor is connected with a third scan signal line, a first electrode of the data writing transistor is connected with a data signal line, and a second electrode of the data writing transistor is connected with a first electrode of the drive transistor; the drive method includes: in a frame refresh phase, controlling, by the first scan signal line, the compensation transistor to be turned on, controlling, by the third scan signal line, the data writing transistor to be turned on, and providing a data voltage output by the data signal line to the gate electrode of the drive transistor; in a frame hold phase, controlling, by the third scan signal line, the data writing transistor to be turned on, and providing the data voltage output by the data signal line to the first electrode of the drive transistor.

In yet another aspect, the present disclosure also provides a preparation method of a display substrate, the display substrate includes a plurality of circuit units, a plurality of data signal lines, and a plurality of data connection lines, wherein the data connection lines include a first connection line extending along a first direction and a second connection line extending along a second direction, the data signal lines extend along the second direction, and the first direction intersects with the second direction; the preparation method includes: forming a data connection electrode in at least one circuit unit, forming a fan-out connection electrode in at least one circuit unit, and forming a data signal line, a first connection line, and a second connection line, the second connection line is connected with the first connection line through the fan-out connection electrode, and the first connection line is connected with the data signal line through the data connection electrode; an orthographic projection of the data connection electrode on a plane of the display substrate is at least partially overlapped with an orthographic projection of the data signal line on the plane of the display substrate, an orthographic projection of the fan-out connection electrode on the plane of the display substrate is at least partially overlapped with an orthographic projection of the second connection line on the plane of the display substrate, there is a first distance between the data connection electrode and the first connection line, and there is a second distance between the fan-out connection electrode and the first connection line, the first distance and the second distance are greater than 0, and the first distance and the second distance are dimensions in the second direction.

Other aspects may be understood upon reading and understanding drawings and detailed description.

Brief Description of Drawings

The accompanying drawings are used for providing understanding of technical solutions of the present disclosure, and constitute a part of the specification. They are used for explaining the technical solutions of the present disclosure together with the embodiments of the present disclosure, but do not constitute a limitation on the technical solutions of the present disclosure.

FIG. 1 is a schematic diagram of a structure of a display apparatus.

FIG. 2 is a schematic diagram of a structure of a display substrate.

FIG. 3 is a schematic diagram of a planar structure of a display region in a display substrate.

FIG. 4 is a schematic diagram of a sectional structure of a display region in a display substrate.

FIG. 5 is a schematic diagram of an equivalent circuit of a pixel drive circuit.

FIG. 6A is a schematic diagram of a planar structure of a display substrate according to an exemplary embodiment of the present disclosure.

FIG. 6B is a schematic diagram of an arrangement of data connection lines according to an exemplary embodiment of the present disclosure.

FIG. 7A is a schematic diagram of a planar structure of another display substrate according to an exemplary embodiment of the present disclosure.

FIG. 7B is a schematic diagram of an arrangement of another data connection lines according to an exemplary embodiment of the present disclosure.

FIG. 8A is a schematic diagram of a planar structure of yet another display substrate according to an exemplary embodiment of the present disclosure.

FIG. 8B is an enlarged view of a region C2 in FIG. 8A.

FIG. 9A is a schematic diagram of a planar structure of yet another display substrate according to an exemplary embodiment of the present disclosure.

FIG. 9B is an enlarged view of a region C2 in FIG. 9A.

FIG. 10 is a schematic diagram of a planar structure of a power supply trace according to an exemplary embodiment of the present disclosure.

FIG. 11 is a schematic diagram of a structure of a data connection line according to an exemplary embodiment of the present disclosure.

FIG. 12 is a schematic diagram of a structure of a circuit unit according to an exemplary embodiment of the present disclosure.

FIG. 13 is a schematic diagram of a structure of a third conductive layer in FIG. 12.

FIG. 14 is a schematic diagram of a structure of a fourth conductive layer in FIG. 12.

FIG. 15 is a schematic diagram of an E0 region in a display substrate after a pattern of a semiconductor layer is formed according to the present disclosure.

FIG. 16 is a schematic diagram of an F region in a display substrate after a pattern of a semiconductor layer is formed according to the present disclosure.

FIG. 17 is a schematic diagram of an E0 region in a display substrate after a pattern of a first conductive layer is formed according to the present disclosure.

FIG. 18 is a schematic diagram of an F region in a display substrate after a pattern of a first conductive layer is formed according to the present disclosure.

FIG. 19 is a schematic diagram of an E0 region in a display substrate after a pattern of a second conductive layer is formed according to the present disclosure.

FIG. 20 is a schematic diagram of an F region in a display substrate after a pattern of a second conductive layer is formed according to the present disclosure.

FIG. 21 is a schematic diagram of an E0 region in a display substrate after a pattern of a fourth insulation layer is formed according to the present disclosure.

FIG. 22 is a schematic diagram of an F region in a display substrate after a pattern of a fourth insulation layer is formed according to the present disclosure.

FIG. 23 is a schematic diagram of an E0 region in a display substrate after a pattern of a third conductive layer is formed according to the present disclosure.

FIG. 24 is a schematic diagram of an E1 region in a display substrate after a pattern of a third conductive layer is formed according to the present disclosure.

FIG. 25 is a schematic diagram of an E2 region in a display substrate after a pattern of a third conductive layer is formed according to the present disclosure.

FIG. 26 is a schematic diagram of an E3 region in a display substrate after a pattern of a third conductive layer is formed according to the present disclosure.

FIG. 27 is a schematic diagram of an E4 region in a display substrate after a pattern of a third conductive layer is formed according to the present disclosure.

FIG. 28 is a schematic diagram of an F region in a display substrate after a pattern of a third conductive layer is formed according to the present disclosure.

FIG. 29 is a schematic diagram of an E0 region in a display substrate after a pattern of a first planarization layer is formed according to the present disclosure.

FIG. 30 is a schematic diagram of an E1 region in a display substrate after a pattern of a first planarization layer is formed according to the present disclosure.

FIG. 31 is a schematic diagram of an E2 region in a display substrate after a pattern of a first planarization layer is formed according to the present disclosure.

FIG. 32 is a schematic diagram of an E3 region in a display substrate after a pattern of a first planarization layer is formed according to the present disclosure.

FIG. 33 is a schematic diagram of an E4 region in a display substrate after a pattern of a first planarization layer is formed according to the present disclosure.

FIG. 34 is a schematic diagram of an F region in a display substrate after a pattern of a first planarization layer is formed according to the present disclosure.

FIG. 35 is a schematic diagram of an E0 region in a display substrate after a pattern of a fourth conductive layer is formed according to the present disclosure.

FIG. 36 is a schematic diagram of an E1 region in a display substrate after a pattern of a fourth conductive layer is formed according to the present disclosure.

FIG. 37 is a schematic diagram of an E2 region in a display substrate after a pattern of a fourth conductive layer is formed according to the present disclosure.

FIG. 38 is a schematic diagram of an E3 region in a display substrate after a pattern of a fourth conductive layer is formed according to the present disclosure.

FIG. 39 is a schematic diagram of an E4 region in a display substrate after a pattern of a fourth conductive layer is formed according to the present disclosure.

FIG. 40 is a schematic diagram of an F region in a display substrate after a pattern of a fourth conductive layer is formed according to the present disclosure.

FIG. 41 is a schematic diagram of a structure of a region where a first fracture is located according to an exemplary embodiment of the present disclosure.

FIG. 42 is a schematic diagram of a structure of a region where a second fracture is located according to an exemplary embodiment of the present disclosure.

FIG. 43 is an equivalent circuit diagram of a pixel drive circuit according to an exemplary embodiment of the present disclosure.

FIG. 44 is a working timing diagram of a pixel drive circuit according to an exemplary embodiment of the present disclosure.

| 11-first active layer; | 12-second active layer; | 13-third active layer; |
|---|---|---|
| 14-fourth active layer; | 15-fifth active layer; | 16-sixth active layer; |
| 17-seventh active layer; | 21-first scan signal line; | 21-1 - gate block; |
| 22-second scan signal line; | 23-third scan signal line; | 24-light emitting control line; |
| 25-first electrode plate; | 31-first initial signal line; | 32-second initial signal line; |
| 33-second electrode plate; | 34-electrode plate connection line; | 35-shielding electrode; |

(continued)

| | | |
|---|---|---|
| 36-opening; | 37-protrusion; | 41-first connection electrode; |
| 42-second connection electrode; | 43-third connection electrode; | 44-fourth connection electrode; |
| 45-fifth connection electrode; | 46-sixth connection electrode; | 47-seventh connection electrode; |
| 51-first power supply line; | 52-anode connection electrode; | 60-data signal line; |
| 70-data connection line; | 71-first connection line; | 72-second connection line; |
| 80-leading out line; | 81-data connection electrode; | 82-data connection block; |
| 83-fan-out connection electrode; | 84-fan-out connection block; | 85-power supply connection electrode; |
| 86-power supply connection block; | 87-dummy electrode; | 91-first power supply trace; |
| 92-second power supply trace; | 100-display region; | 101-base substrate; |
| 102-drive structure layer; | 103-light emitting structure layer; | 104-encapsulation structure layer; |
| 110-first region; | 120-second region; | 130-third region; |
| 200-bonding region; | 201-lead region; | 210-first lead electrode; |
| 220-second lead electrode; | 230-third lead electrode; | 240-fourth lead electrode; |
| 250-bonding high voltage line; | 260-bonding high voltage electrode; | 300-bezel region; |
| 301-anode; | 302-pixel definition layer; | 303-organic emitting layer; |
| 304-cathode; | 401-first encapsulation layer; | 402-second encapsulation layer; |
| 403-third encapsulation layer; | 410-bonding power supply lead; | 420-lead opening; |
| 510-bezel power supply lead. | | |

## Detailed Description

To make objectives, technical solutions, and advantages of the present disclosure more clear, the embodiments of the present disclosure will be described in detail with reference to the accompanying drawings. It is to be noted that implementation modes may be implemented in multiple different forms. Those of ordinary skills in the art may easily understand such a fact that modes and contents may be transformed into various forms without departing from the purpose and scope of the present disclosure. Therefore, the present disclosure should not be explained as being limited to contents described in following implementation modes only. The embodiments in the present disclosure and features in the embodiments may be combined randomly with each other without conflict.

Scales of the drawings in the present disclosure may be used as a reference in an actual process, but are not limited thereto. For example, a width-length ratio of a channel, a thickness and a pitch of each film layer, and a width and a pitch of each signal line may be adjusted according to actual needs. A quantity of pixels in a display substrate and a quantity of sub-pixels in each pixel are not limited to numbers shown in the drawings. The drawings described in the present disclosure are structural schematic diagrams only, and one mode of the present disclosure is not limited to shapes, numerical values, or the like shown in the drawings.

Ordinal numerals such as "first", "second", and "third" in the specification are set to avoid confusion of constituent elements, but not to set a limit in quantity.

In the specification, for convenience, wordings indicating orientation or positional relationships, such as "middle", "upper", "lower", "front", "back", "vertical", "horizontal", "top", "bottom", "inside", and "outside", are used for illustrating positional relationships between constituent elements with reference to the drawings, and are merely for facilitating the description of the specification and simplifying the description, rather than indicating or implying that a referred apparatus or element must have a particular orientation and be constructed and operated in the particular orientation. Therefore, they cannot be understood as limitations on the present disclosure. The positional relationships between the constituent elements are changed as appropriate according to directions for describing various constituent elements. Therefore, appropriate replacements may be made according to situations without being limited to the wordings described in the specification.

In the specification, unless otherwise specified and defined explicitly, terms "mount", "mutually connect", and "connect" should be understood in a broad sense. For example, it may be a fixed connection, a detachable connection, or an integrated connection; it may be a mechanical connection or an electrical connection; it may be a direct mutual connection, or an indirect connection through middleware, or internal communication between two elements. Those of ordinary skill in the art may understand specific meanings of these terms in the present disclosure according to specific situations.

In the specification, a transistor refers to an element which at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that, in the specification, the channel region refers to a region through which the current mainly flows.

In the specification, a first electrode may be a drain electrode, and a second electrode may be a source electrode. Or, a first electrode may be a source electrode, and a second electrode may be a drain electrode. In a case that transistors with opposite polarities are used, in a case that a direction of a current is changed during operation of a circuit, or the like, functions of the "source electrode" and the "drain electrode" are sometimes interchangeable. Therefore, the "source electrode" and the "drain electrode", as well as the "source terminal" and the "drain terminal", are interchangeable in the specification.

In the specification, an "electrical connection" includes a case that constituent elements are connected together through an element with a certain electrical effect. The "element with the certain electrical effect" is not particularly limited as long as electrical signals may be sent and received between the connected constituent elements. Examples of the "element with the certain electrical effect" not only include electrodes and wirings, but also include switching elements such as transistors, resistors, inductors, capacitors, other elements with various functions, etc.

In the specification, "parallel" refers to a state in which an angle formed by two straight lines is above -10° and below 10°, and thus also includes a state in which the angle is above -5° and below 5°. In addition, "perpendicular" refers to a state in which an angle formed by two straight lines is above 80° and below 100°, and thus also includes a state in which the angle is above 85° and below 95°.

In the specification, a "film" and a "layer" are interchangeable. For example, a "conductive layer" may be replaced with a "conductive film" sometimes. Similarly, an "insulation film" may be replaced with an "insulation layer" sometimes.

A triangle, rectangle, trapezoid, pentagon, or hexagon, etc. in this specification are not strictly defined, and it may be an approximate triangle, rectangle, trapezoid, pentagon, or hexagon, etc. There may be some small deformation caused by tolerance, and there may be a chamfer, an arc edge, and deformation, etc.

In the present disclosure, "about" refers to that a boundary is not defined so strictly and numerical values within process and measurement error ranges are allowed.

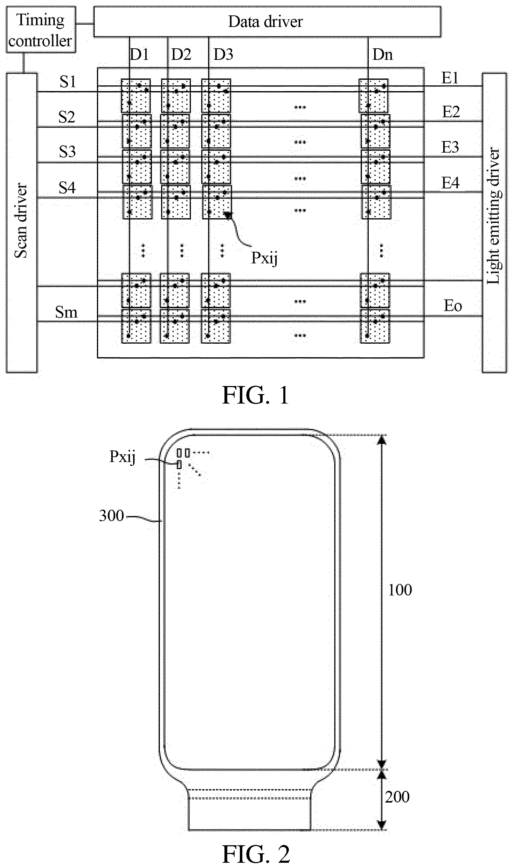

FIG. 1 is a schematic diagram of a structure of a display apparatus. As shown in FIG. 1, the display apparatus may include a timing controller, a data driver, a scan driver, a light emitting driver, and a pixel array. The timing controller is connected with the data driver, the scan driver, and the light emitting driver, respectively, the data driver is connected with multiple data signal lines (D1 to Dn) respectively, the scan driver is connected with multiple scan signal lines (S1 to Sm) respectively, and the light emitting driver is connected with multiple light emitting signal lines (E1 to Eo) respectively. The pixel array may include multiple sub-pixels Pxij, wherein i and j may be natural numbers. At least one sub-pixel Pxij may include a circuit unit and a light emitting device connected with the circuit unit, wherein the circuit unit may at least include a pixel drive circuit, and the pixel drive circuit is connected with a scan signal line, a light emitting signal line, and a data signal line, respectively. In an exemplary implementation mode, the timing controller may provide a gray-scale value and a control signal, which are suitable for a specification of the data driver, to the data driver, may provide a clock signal, a scan start signal, etc., which are suitable for a specification of the scan driver, to the scan driver, and may provide a clock signal, an emission stop signal, etc., which are suitable for a specification of the light emitting driver, to the light emitting driver. The data driver may generate a data voltage to be provided to the data signal lines D1, D2, D3, ..., and Dn by using the gray-scale value and the control signal that are received from the timing controller. For example, the data driver may sample the gray-scale value by using the clock signal and apply a data voltage corresponding to the gray-scale value to the data signal lines D1 to Dn by taking a pixel row as a unit, wherein n may be a natural number. The scan driver may generate a scan signal to be provided to the scan signal lines S1, S2, S3, ..., and Sm by receiving the clock signal, the scan start signal, etc., from the timing controller. For example, the scan driver may provide a scan signal with an on-level pulse to the scan signal lines S1 to Sm sequentially. For example, the scan driver may be constructed in a form of a shift register and may generate a scan signal in a manner in which a scan start signal provided in a form of an on-level pulse is transmitted to a next-stage circuit sequentially under control of the clock signal, wherein m may be a natural number. The light emitting driver may generate an emission signal to be provided to the light emitting signal lines E1, E2, E3, ..., and Eo by receiving the clock signal, the emission stop signal, etc., from the timing controller. For example, the light emitting driver may provide an emission signal with an off-level pulse to the light emitting signal lines E1 to Eo sequentially. For example, the light emitting driver may be constructed in a form of a shift register and may generate an emission signal in a manner in which an emission stop signal provided in a form of an off-level pulse is transmitted to a next-stage circuit sequentially under control of the clock signal, wherein o may be a natural number. In an exemplary implementation, the pixel array may be provided on the display substrate.

FIG. 2 is a schematic diagram of a structure of a display substrate. As shown in FIG. 2, the display substrate may include a display region 100, a bonding region 200 located on one side of the display region 100, and a bezel region 300 located on another side of the display region 100. In an exemplary implementation mode, the display region 100 may be a flat region, including multiple sub-pixels Pxij that constitute a pixel array, wherein the multiple sub-pixels Pxij are configured to display a dynamic picture or a static image, and the display region 100 may be referred to as an Active Area (AA). In an exemplary implementation mode, the display substrate may be a flexible substrate, and accordingly the display substrate may be deformable, for example, may be curled, bent, folded, or rolled.

In an exemplary implementation mode, the bonding region 200 may include a fan-out region, a bending region, a drive chip region, and a bonding pin region sequentially disposed along a direction away from the display region, wherein the fan-out region is connected to the display region 100 and at least includes data fan-out lines, and multiple data fan-out lines are configured to connect a data signal line of the display region in a fan-out trace manner. The bending region is connected to the fan-out region and may include a composite insulation layer provided with a groove, and is configured to enable the bonding region to be bent to a back surface of the display region. The drive chip region may include an Integrated Circuit (IC for short), and the Integrated Circuit is configured to be connected with multiple data fan-out lines. The bonding pin region may include a Bonding Pad, and the Bonding Pad is configured to be bonded and connected with an external Flexible Printed Circuit (FPC for short).

In an exemplary implementation mode, the bezel region 300 may include a circuit region, a power supply line region, a crack dam region, and a cutting region which are sequentially disposed along the direction away from the display region 100. The circuit region is connected to the display region 100 and may at least include a gate drive circuit, wherein the gate drive circuit is connected with a first scan line, a second scan line, and a light emitting control line of a pixel drive circuit in the display region 100. The power supply line region is connected to the circuit region and may at least include a bezel power supply lead, wherein the bezel power supply lead extends along a direction parallel to an edge of the display region and is connected with a cathode in the display region 100. The crack dam region is connected to the power supply line region and may at least include multiple cracks disposed on the composite insulation layer. The cutting region is connected to the crack dam region and may at least include a cutting groove disposed on the composite insulation layer, wherein the cutting groove is configured for respectively cutting along the cutting groove by a cutting device after all film layers of the display substrate are prepared.

In an exemplary implementation mode, the fan-out region in the bonding region 200 and the power supply line region in the bezel region 300 may be provided with a first isolation dam and a second isolation dam, wherein the first isolation dam and the second isolation dam may extend along the direction parallel to the edge of the display region, forming an annular structure surrounding the display region 100, and the edge of the display region is an edge on one side of the display region, the bonding region, or the bezel region.

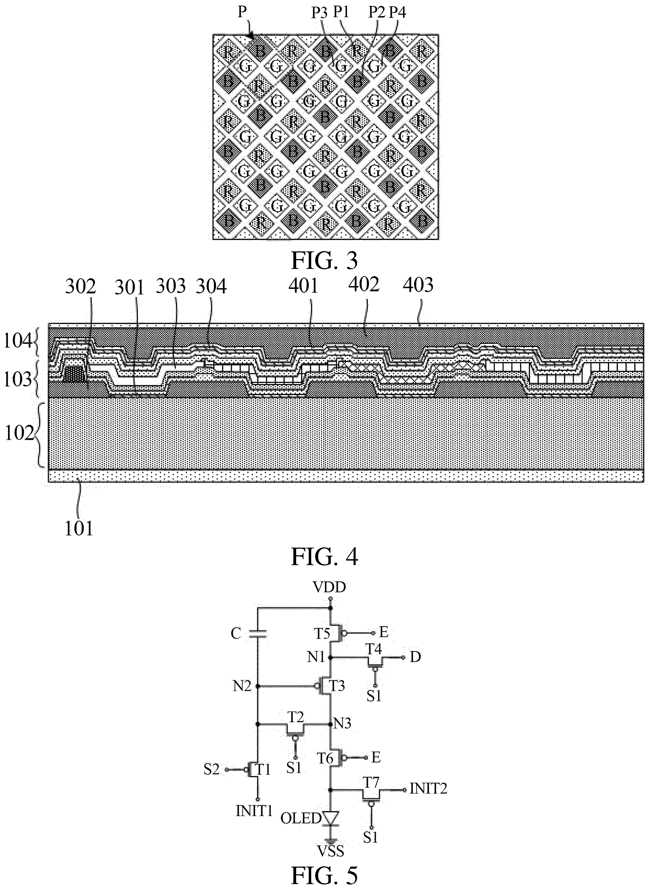

FIG. 3 is a schematic diagram of a planar structure of a display region in a display substrate. As shown in FIG. 3, the display substrate may include multiple pixel units P arranged in a matrix. At least one pixel unit P may include a first sub-pixel P1 emitting light of a first color, a second sub-pixel P2 emitting light of a second color, and a third sub-pixel P3 and a fourth sub-pixel P4 emitting light of a third color. Each sub-pixel may include a light emitting device, and the light emitting device is connected with the pixel drive circuit of the corresponding circuit unit. The pixel drive circuit is respectively connected with a scan signal line, a data signal line, and a light emitting signal line, the pixel drive circuit is configured to, under the control of the scan signal line and the light emitting signal line, receive a data voltage transmitted by the data signal line and output a corresponding current to the light emitting device, and the light emitting device is configured to emit light with corresponding brightness in response to the current output by the pixel drive circuit of the sub-pixel where the light emitting device is located.

In an exemplary implementation mode, the first sub-pixel P1 may be a red sub-pixel (R) emitting red light, the second sub-pixel P2 may be a blue sub-pixel (B) emitting blue light, and the third sub-pixel P3 and the fourth sub-pixel P4 may be green sub-pixels (G) emitting green light. In an exemplary implementation mode, a shape of a sub-pixel may be a rectangular shape, a diamond, a pentagon, or a hexagon. The four sub-pixels may be arranged in a manner of a Diamond to form an RGBG pixel arrangement. In another exemplary embodiment, the four sub-pixels may be arranged side by side horizontally, side by side vertically, or in a manner to form a square, etc., which is not limited here in the present disclosure.

In an exemplary implementation mode, the pixel unit may include three sub-pixels, wherein the three sub-pixels may be arranged side by side horizontally, side by side vertically, or in a manner like a Chinese character "品", etc., which is not limited here in the present disclosure.

FIG. 4 is a schematic diagram of a sectional structure of a display region in a display substrate, illustrating a structure of four sub-pixels in the display region. As shown in FIG. 4, on a plane perpendicular to the display substrate, the display substrate may include a drive structure layer 102 disposed on a base substrate 101, a light emitting structure layer 103 disposed on one side of the drive structure layer 102 away from the base substrate 101, and an encapsulation structure layer 104 disposed on one side of the light emitting structure layer 103 away from the base substrate 101. In some possible implementation modes, the display substrate may include another film layer, such as a touch structure layer, which is not limited here in the present disclosure.

In an exemplary implementation mode, the base substrate 101 may be a flexible base substrate, or a rigid base substrate. The drive structure layer 102 may include a plurality of circuit units, and a circuit unit may include at least a pixel drive circuit composed of a plurality of transistors and a storage capacitor. The light emitting structure layer 103 may include multiple sub-pixels, and a sub-pixel may at least include an anode 301, a pixel definition layer 302, an organic emitting layer 303 and a cathode 304. The anode 301 is connected with the pixel drive circuit, the organic emitting layer 303 is connected with the anode 301, the cathode 304 is connected with the organic emitting layer 303, and the organic emitting layer 303 emits light of a corresponding color under drive of the anode 301 and the cathode 304. The encapsulation structure layer 104 may include a first encapsulation layer 401, a second encapsulation layer 402, and a third encapsulation layer 403 which are stacked, wherein the first encapsulation layer 401 and the third encapsulation layer 403 may be made of an inorganic material, the second encapsulation layer 402 may be made of an organic material, and the second encapsulation layer 402 is disposed between the first encapsulation layer 401 and the third encapsulation layer 403 to form a laminated structure of an inorganic material/an organic material/an inorganic material, which may ensure that external water vapor cannot enter the light emitting structure layer 103.

In an exemplary implementation mode, the organic emitting layer may include an Emitting Layer (EML), and any one or more of following layers: a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation mode, one or more layers of hole injection layers, hole transport layers, electron block layers, hole block layers, electron transport layers, and electron injection layers of all sub-pixels may be respectively connected together to be a common layer. Emitting layers of adjacent sub-pixels may be overlapped slightly, or may be mutually isolated.

FIG. 5 is a schematic diagram of an equivalent circuit of a pixel drive circuit. In an exemplary implementation mode, the pixel drive circuit may have a structure of 3T1C, 4T1C, 5T1C, 5T2C, 6T1C, 7T1C, or 8T1C. As shown in FIG. 5, the pixel drive circuit may include seven transistors (a first transistor T1 to a seventh transistor T7), one storage capacitor C, and the pixel drive circuit is respectively connected with seven signal lines (a data signal line D, a first scan signal line S1, a second scan signal line S2, a light emitting signal line E, a first initial signal line INIT1, a second initial signal line INIT2, and a first power supply line VDD).

In an exemplary implementation mode, the pixel drive circuit may include a first node N1, a second node N2, and a third node N3. Herein, the first node N1 is respectively connected with a first electrode of the third transistor T3, a second electrode of the fourth transistor T4, and a second electrode of the fifth transistor T5, the second node N2 is respectively connected with a second electrode of the first transistor, a first electrode of the second transistor T2, a gate electrode of the third transistor T3, and a second end of the storage capacitor C, and the third node N3 is respectively connected with a second electrode of the second transistor T2, a second electrode of the third transistor T3, and a first electrode of the sixth transistor T6.

In an exemplary implementation mode, a first end of the storage capacitor C is connected with the first power supply line VDD, and the second end of the storage capacitor C is connected with the second node N2, namely the second end of the storage capacitor C is connected with a gate electrode of the third transistor T3.

A gate electrode of the first transistor T1 is connected with the second scan signal line S2, a first electrode of the first transistor T1 is connected with the first initial signal line INIT1, and a second electrode of the first transistor is connected with the second node N2. When a scan signal with an on level is applied to the second scan signal line S2, the first transistor T1 transmits a first initialization voltage to the gate electrode of the third transistor T3 so as to initialize a charge amount of the gate electrode of the third transistor T3.

A gate electrode of the second transistor T2 is connected with the first scan signal line S1, a first electrode of the second transistor T2 is connected with the second node N2, and a second electrode of the second transistor T2 is connected with the third node N3. When a scan signal with an on level is applied to the first scan signal line S1, the second transistor T2 enables the gate electrode of the third transistor T3 to be connected with the second electrode of the third transistor T3.

The gate electrode of the third transistor T3 is connected with the second node N2, namely, the gate electrode of the third transistor T3 is connected with the second end of the storage capacitor C, a first electrode of the third transistor T3 is connected with the first node N1, and the second electrode of the third transistor T3 is connected with the third node N3. The third transistor T3 may be referred to as a drive transistor, and the third transistor T3 determines an amount of a drive current flowing between the first power supply line VDD and the second power supply line VSS according to a potential difference between the gate electrode and the first electrode of the third transistor T3.

A gate electrode of the fourth transistor T4 is connected with the first scan signal line S1, a first electrode of the fourth transistor T4 is connected with the data signal line D, and a second electrode of the fourth transistor T4 is connected with the first node N1. The fourth transistor T4 may be referred to as a switching transistor, and a scan transistor, etc., and when a scan signal with an on-level is applied to the first scan signal line S1, the fourth transistor T4 enables a data voltage of the data signal line D to be input to the pixel drive circuit.

A gate electrode of the fifth transistor T5 is connected with the light emitting signal line E, a first electrode of the fifth transistor T5 is connected with the first power supply line VDD, and a second electrode of the fifth transistor T5 is connected with the first node N1. A gate electrode of the sixth transistor T6 is connected with the light emitting signal line E, a first electrode of the sixth transistor T6 is connected with the third node N3, and a second electrode of the sixth transistor T6 is connected with a first electrode of a light emitting device. The fifth transistor T5 and the sixth transistor T6 may be referred to as light emitting transistors. When a light emitting signal with an on-level is applied to the light emitting signal line E, the fifth transistor T5 and the sixth transistor T6 enable the light emitting device to emit light by forming a drive current path between the first power supply line VDD and the second power supply line VSS.

A control electrode of the seventh transistor T7 is connected with the first scan signal line S1, a first electrode of the seventh transistor T7 is connected with the second initial signal line INIT2, and a second electrode of the seventh transistor T7 is connected with the first electrode of the light emitting device. When a scan signal with an on-level is applied to the first scan signal line S1, the seventh transistor T7 transmits a second initial voltage to the first electrode of the light emitting device so as to initialize a charge amount accumulated in the first electrode of the light emitting device or release a charge amount accumulated in the first electrode of the light emitting device.

In an exemplary implementation mode, the light emitting device may be an OLED, including a first electrode (anode), an organic emitting layer, and a second electrode (cathode) that are stacked, or may be a QLED, including a first electrode (anode), a quantum dot emitting layer, and a second electrode (cathode) that are stacked.

In an exemplary implementation mode, a second electrode of the light emitting device is connected with the second power supply line VSS, a signal of the second power supply line VSS is a low-level signal continuously provided, and a signal of the first power supply line VDD is a high-level signal continuously provided.

In an exemplary implementation mode, the first transistor T1 to the seventh transistor T7 may be P-type transistors, or may be N-type transistors. Use of a same type of transistors in a pixel drive circuit may simplify a process flow, reduce process difficulties of a display panel, and improve a yield of products. In some possible implementation modes, the first transistor T1 to the seventh transistor T7 may include a P-type transistor and an N-type transistor.

In an exemplary implementation mode, for the first transistor T1 to the seventh transistor T7, low temperature poly silicon thin film transistors may be adopted, or oxide thin film transistors may be adopted, or a low temperature poly silicon thin film transistor and an oxide thin film transistor may be adopted. An active layer of a low temperature poly silicon thin film transistor may be made of Low Temperature Poly Silicon (LTPS for short), and an active layer of an oxide thin film transistor may be made of an oxide semiconductor (Oxide). The low temperature poly silicon thin film transistor has advantages such as, high mobility, fast charging, and the oxide thin film transistor has advantages such a low drain current. The low temperature poly silicon thin film transistor and the oxide thin film transistor are integrated on one display substrate to form a LTPS + Oxide (LTPO for short) display substrate, so that advantages of the low temperature poly silicon thin film transistor and the oxide thin film transistor may be utilized, low-frequency drive may be achieved, power consumption may be reduced, and display quality may be improved.

In an exemplary implementation mode, taking a case that the first transistor T1 to the seventh transistor T7 are all P-type transistors as an example, a working process of the pixel drive circuit may include following stages.

In a first stage A1, referred to as a reset stage, a signal of the second scan signal line S2 is a low-level signal, and signals of the first scan signal line S1 and the light emitting signal line E are high-level signals. The signal of the second scan signal line S2 is the low-level signal, so that the first transistor T1 is turned on, a first initial voltage of the first initial signal line INIT1 is provided to the second node N2 to initialize the storage capacitor C, thereby clearing an original data voltage in the storage capacitor. The signals of the first scan signal line S1 and the light emitting signal line E are the high-level signals, so that the second transistor T2, the fourth transistor T4, the fifth transistor T5, the sixth transistor T6, and the seventh transistor T7 are turned off. An OLED does not emit light in this stage.

In a second stage A2, referred to as a data writing stage or a threshold compensation stage, a signal of the first scan signal line S1 is a low-level signal, signals of the second scan signal line S2 and the light emitting signal line E are high-level signals, and the data signal line D outputs a data voltage. In this stage, the second end of the storage capacitor C is at a low level, so the third transistor T3 is turned on. The signal of the first scan signal line S1 is the low-level signal, so that the second transistor T2, the fourth transistor T4, and the seventh transistor T7 are turned on. The second transistor T2 and the fourth transistor T4 are turned on, so that the data voltage output by the data signal line D is provided to the second node N2 through the first node N1, the turned-on third transistor T3, the third node N3, and the turned-on second transistor T2, and the storage capacitor C is charged with a difference between the data voltage output by the data signal line D and a threshold voltage of the third transistor T3. A voltage at the second end (the second node N2) of the storage capacitor C is Vd-|Vth|, wherein Vd is the data voltage output by the data signal line D, and Vth is the threshold voltage of the third transistor T3. The seventh transistor T7 is turned on, so that a second initial voltage of the second initial signal line INIT2 is provided to a first electrode of the OLED to initialize (reset) the first electrode of the OLED and clear its internal pre-stored voltage, thereby completing initialization and ensuring that the OLED does not emit light. A signal of the second scan signal line S2 is a high-level signal, so that the first transistor T1 is turned off. A signal of the light emitting signal line E is a high-level signal, so that the fifth transistor T5 and the sixth transistor T6 are turned off.

In a third stage A3, referred to as a light emitting stage, a signal of the light emitting signal line E is a low-level signal, and signals of the first scan signal line S1 and the second scan signal line S2 are high-level signals. The signal of the light emitting signal line E is the low-level signal, so that the fifth transistor T5 and the sixth transistor T6 are turned on, and a power voltage output by the first power supply line VDD provides a drive voltage to the first electrode of the OLED through the turned-on fifth transistor T5, the third transistor T3, and the sixth transistor T6 to drive the OLED to emit light.

In a drive process of the pixel drive circuit, a drive current flowing through the third transistor T3 (drive transistor) is determined by a voltage difference between a gate electrode and the first electrode of the third transistor T3. Since the voltage of the second node N2 is Vd-|Vthl, the drive current of the third transistor T3 is as follows.

$$I = K*(Vgs-Vth)^2 = K*[(Vdd-Vd+|Vthl|)-Vth]^2 = K*[Vdd-Vd]^2$$

Herein, I is the drive current flowing through the third transistor T3, i.e., a drive current for driving the OLED, K is a constant, Vgs is the voltage difference between the gate electrode and the first electrode of the third transistor T3, Vth is the threshold voltage of the third transistor T3, Vd is the data voltage output by the data signal line D, and Vdd is the power voltage output by the first power supply line VDD.

With development of OLED display technologies, consumers have higher requirements for a display effect of a display product. An extremely narrow bezel has become a new trend in development of display products. Therefore, bezel narrowing or even a bezel-less design has received more and more attention in a design of OLED display products. In a display substrate, a bonding region generally includes a fan-out region, a bending region, a drive chip region, and a bonding pin region sequentially disposed along a direction away from a display region. Since a width of the bonding region is smaller than a width of the display region, signal lines of an integrated circuit and a bonding pad in the bonding region need to be led to a relatively wide display region through the fan-out region in a fan-out trace manner, the greater a width difference between the display region and the bonding region is, the more oblique fan-out lines in a fan-shaped region is, the longer a distance between the drive chip region and the display region is, so the fan-shaped region occupies relatively large space, which causes a relatively large difficulty in a narrowing design of a lower bezel, the lower bezel being always maintained at about 2.0 mm. In another display substrate, a bezel region is usually provided with a bezel power supply lead, wherein the bezel power supply lead is configured to continuously provide and transmit a low voltage power signal. In order to reduce voltage drop of the low voltage power signal, a width of the bezel power supply lead is relatively large, resulting in a relatively large width of left and right bezels of a display apparatus.

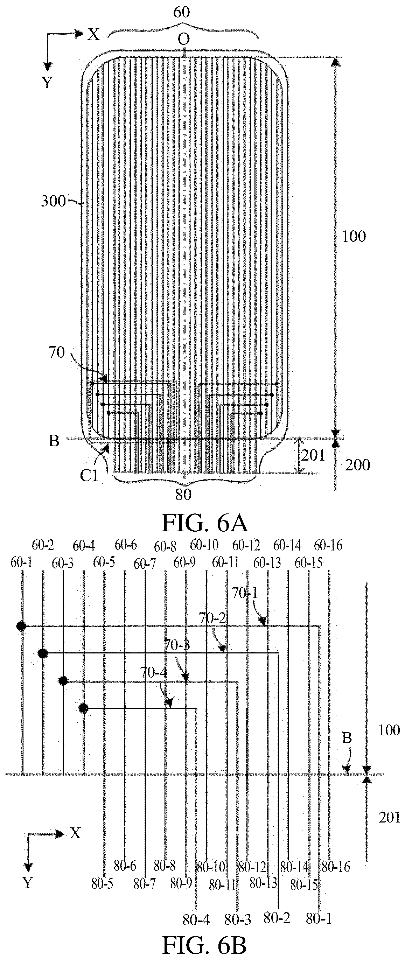

FIG. 6A is a schematic diagram of a planar structure of a display substrate according to an exemplary embodiment of the present disclosure. In a plane perpendicular to the display substrate, the display panel may include a drive structure layer disposed on the base substrate, a light emitting structure layer disposed on one side of the drive structure layer away from the base substrate, and an encapsulation structure layer disposed on one side of the light emitting structure layer away from the base substrate. As shown in FIG. 6A, in a plane parallel to the display substrate, the display substrate may at least include a display region 100, a bonding region 200 located on one side of the display region 100 in a second direction Y, and a bezel region 300 located on another side of the display region 100. In an exemplary implementation mode, the drive circuit layer of the display region 100 may include a plurality of circuit units constituting a plurality of unit rows and a plurality of unit columns, a plurality of data signal lines 60, and a plurality of data connection lines 70, wherein at least one circuit unit may include a pixel drive circuit, and the pixel drive circuit is configured to output a corresponding current to a connected light emitting device. The light emitting structure layer of the display region 100 may include multiple sub-pixels constituting a pixel array, wherein at least one sub-pixel may include a light emitting device, the light emitting device is connected with a pixel drive circuit of a corresponding circuit unit, and the light emitting device is configured to emit light with corresponding brightness in response to a current outputted by the connected pixel drive circuit.

In an exemplary implementation mode, at least one data signal line 60 is connected with multiple pixel drive circuits in one unit column, the data signal line 60 is configured to provide a data signal to a connected pixel drive circuit, at least one data connection line 70 is connected correspondingly with the data signal line 60, and the data connection line 70 is configured such that the data signal line 60 is correspondingly connected with a leading out line 80 in the bonding region 200 through the data connection line 70.

In an exemplary implementation mode, a sub-pixel in the present disclosure refers to a region divided according to a light emitting device, and a circuit unit in the present disclosure refers to a region divided according to a pixel drive circuit. In an exemplary implementation mode, a position of an orthographic projection of the sub-pixel on the base substrate may correspond to a position of an orthographic projection of the circuit unit on the base substrate, or a position of an orthographic projection of the sub-pixel on the base substrate may not correspond to a position of an orthographic projection of the circuit unit on the base substrate.

In an exemplary implementation mode, multiple circuit units sequentially disposed along a first direction X may be referred to as a unit row, and multiple circuit units sequentially disposed along the second direction Y may be referred to as a unit column. Multiple unit rows and multiple unit columns constitute a circuit unit array arranged in an array, and the first direction X and the second direction Y intersect.

In an exemplary implementation mode, the second direction Y (vertical direction) may be an extension direction of the data signal line, and the first direction X (horizontal direction) may be perpendicular to the second direction Y.

In an exemplary implementation mode, the bonding region 200 may include a lead region 20, a bending region, a drive chip region, and a bonding pin region which are sequentially disposed along a direction away from the display region, wherein the lead region 201 is connected to the display region 100, and the bending region is connected to the lead region 201. A plurality of leading out lines 80 may be disposed in the lead region 201, the plurality of leading out lines 80 extend along the direction away from the display region, first ends of a part of the leading out lines 80 are connected correspondingly with data connection lines 70 in the display region 100, first ends of the other part of the leading out lines are connected correspondingly with data signal lines 60 in the display region 100, and second ends of all leading out lines 80 extend along the second direction Y and then cross the bending region to be connected with an integrated circuit of a drive chip region, so that the integrated circuit applies data signals to the data signal lines through the leading out lines and the data connection lines. Since the data connection lines are disposed in the display region, a length of the lead region in the second direction Y may be effectively reduced, greatly shortening a width of a lower bezel, and increasing a screen-to-body ratio, which is beneficial to achieve full-screen display.

In an exemplary implementation mode, multiple data signal lines of the display region 100 may extend along the second direction Y, and are sequentially disposed at a set interval along the first direction X in an increasing number manner. The multiple data signal lines may be divided into a first data signal line group and a second data signal line group according to whether or not they are connected with data connection lines, wherein multiple data signal lines in the first data signal line group are connected with data connection lines correspondingly, and multiple data signal lines in the second data signal line group are not connected with data connection lines. The multiple leading out lines in the lead region 201 may be divided into a first leading out line group and a second leading out line group according to whether they are connected with data connection lines or data signal lines, wherein multiple leading out lines in the first leading out line group are connected correspondingly with data connection lines, and multiple leading out lines in the second leading out line group are connected correspondingly with data signal lines.

In an exemplary implementation mode, first ends of the multiple data connection lines 70 disposed in the display region 100 are connected correspondingly with multiple data signal lines 60 of the first data signal line group through a first connection hole, second ends of the multiple data connection lines 70 extend toward a direction of the bonding region 200 and cross a boundary B of the display region, and are connected correspondingly with multiple leading out lines 80 of the first leading out line group in the lead region 201, so that the multiple data signal lines 60 of the first data signal line group in the display region 100 are indirectly connected with the leading out lines 80 through the data connection lines 70. Multiple data signal lines 60 of the second data signal line group extend toward the direction of the bonding region 200 and cross the boundary B of the display region, and are connected correspondingly with multiple leading out lines 80 of the second leading out line group in the lead region 201, so that the multiple data signal lines 60 of the second data signal line group in the display region 100 are directly connected with the leading out lines 80. In an exemplary implementation mode, the boundary B of the display region is a junction of the display region 100 and the bonding region 200.

In the present disclosure, "A extends along a B direction" refers to that A may include a main portion and a secondary portion connected with the main portion, wherein the main portion is a line, a line segment, or a strip-shaped body, the main portion extends along the B direction, and a length of the main portion extending along the B direction is greater than a length of the secondary portion extending along another direction. In following description, "A extends along a B direction" means "a main body portion of A extends along a B direction". In an exemplary implementation mode, the second direction Y may be a direction pointing to the bonding region from the display region, and an opposite direction of the second direction Y may be a direction pointing to the display region from the bonding region.

In an exemplary implementation mode, a leading out line 80 and a data signal line 60, and a leading out line 80 and a data connection line 70 may be directly connected or may be connected through a via, which is not limited here in the present disclosure.

In an exemplary implementation mode, the display region 100 may have a center line O, wherein multiple data signal lines 60 and multiple data connection lines 70 in the display region 100, and multiple leading out lines 80 in the lead region 201 may be symmetrically disposed with respect to the center line O, and the center line O may be a straight line bisecting multiple unit columns of the display region 100 and extending along the second direction Y.

In an exemplary implementation mode, data connection lines 70 may include a first connection line and a second connection line, wherein the first connection line and the second connection line are connected with each other. A first end of the first connection line is connected with a data signal line through a first connection hole, a second end of the first connection line is connected with a first end of the second connection line after extending along the first direction X or an opposite direction of the first direction X, and a second end of the second connection line is connected with a leading out line after extending along the second direction Y toward a direction of the lead region.

In an exemplary implementation mode, multiple second connection lines may be disposed parallel to a data signal line, and multiple first connection lines may be disposed perpendicular to the data signal line.

In an exemplary implementation mode, pitches between adjacent second connection lines may be substantially the same, and pitches between adjacent first connection lines may be substantially the same, which is not limited here in the present disclosure.

In an exemplary implementation mode, m-1 data signal lines may be disposed between two adjacent first connection holes in the first direction X, wherein m may be a positive integer greater than or equal to 1. In an exemplary implementation mode, m may be 1, 2, 3, 4, 5, or 6. For example, in FIG. 6A, no data signal line is disposed between two adjacent first connection holes.

In an exemplary implementation mode, n data signal lines may be disposed between adjacent second connection lines in the first direction X, wherein n may be a positive integer greater than or equal to 1. In an exemplary implementation mode, n may be 1, 2, 3, 4, 5, or 6. For example, in FIG. 6A, two data signal lines are disposed between adjacent second connection lines.

FIG. 6B is a schematic diagram of an arrangement of data connection lines according to an exemplary embodiment of the present disclosure, and is an enlarged view of a C1 region in FIG. 6A, illustrating a structure of 16 data signal lines, 4 data connection lines, and 16 leading out lines. As shown in FIG. 6B , in an exemplary implementation mode, the plurality of data signal lines of the display region may include a first data signal line 60-1 to a sixteenth data signal line 60-16, the plurality of data connection lines of the display region may include a first data connection line 70-1 to a fourth data connection line 70-4, and the plurality of leading out lines of the lead region 201 may include a first leading out line 80-1 to a sixteenth leading out line 80-16.

In an exemplary implementation mode, the first data signal line group includes the first data signal line 60-1 to the fourth data signal line 60-4, and the second data signal line group includes remaining 12 data signal lines, wherein the first data signal line 60-1 to the sixteenth data signal line 60-16 may be sequentially disposed in the first direction X.

In an exemplary implementation mode, the first leading out line group includes the first leading out line 80-1 to the fourth leading out line 80-4, the second leading out line group includes remaining 12 leading out lines, wherein multiple leading out lines of the first leading out line group may be disposed sequentially along an opposite direction of the first direction X, multiple leading out lines of the second leading out line group may be disposed sequentially along the first direction X, and two leading out lines of the second leading out line group are disposed between adjacent leading out lines in the first leading out line group. For example, the fourteenth leading out line 80-14 and the fifteenth leading out line 80-15 may be disposed between the first leading out line 80-1 and the second leading out line 80-2, the twelfth leading out line 80-12 and the thirteenth leading out line 80-13 may be disposed between the second leading out line 80-2 and the third leading out line 80-3, and the tenth leading out line 80-10 and the eleventh leading out line 80-11 may be disposed between the third leading out line 80-3 and the fourth leading out line 80-4.

In an exemplary implementation mode, the first connection hole may be in circuit units of a first unit column to a fourth unit column. A first end of the first data connection line 70-1 is connected with the first data signal line 60-1 through the first connection hole in the display region 100, and a second end is connected with the first leading out line 80-1 after extending to the lead region 201. A first end of the second data connection line 70-2 is connected with the second data signal line 60-2 through the first connection hole in the display region 100, and a second end is connected with the second leading out line 80-2 after extending to the lead region 201. A first end of the third data connection line 70-3 is connected with the second data signal line 60-2 through the first connection hole in the display region 100, and a second end is connected with the third leading out line 80-3 after extending to the lead region 201. A first end of the fourth data connection line 70-4 is connected with the fourth data signal line 60-4 through the first connection hole in the display region 100, and a second end is connected with the fourth leading out line 80-4 after extending to the lead region 201.

In an exemplary implementation mode, multiple data signal lines of the second data signal line group are connected correspondingly with multiple leading out lines of the second leading out line group after extending to the lead region 201.

In an exemplary implementation mode, distances between multiple first connection holes through which data connection lines and data signal lines are connected correspondingly and an edge B of the display region may be different. For example, a distance between a first connection hole through which the first data connection line 70-1 is connected with the first data signal line 60-1 and the edge B of the display region may be greater than a distance between a first connection hole through which the second data connection line 70-2 is connected with the second data signal line 60-2 and the edge B of the display region. For another example, a distance between a first connection hole through which the second data connection line 70-2 is connected with the second data signal line 60-2 and the edge B of the display region may be greater than a distance between a first connection hole through which the third data connection line 70-3 is connected with the third data signal line 60-3 and the edge B of the display region. For yet another example, a distance between a first connection hole through which the third data connection line 70-3 is connected with the third data signal line 60-3 and the edge B of the display region may be greater than a distance between a first connection hole through which the fourth data connection line 70-4 is connected with the fourth data signal line 60-4 and the edge B of the display region.

In an exemplary implementation mode, data connection lines may include a first connection line and a second connection line which are sequentially connected. A shape of the first connection line may be a straight line extending along the first direction X, and a shape of the second connection line may be a straight line extending along the second direction Y. A first end of the first connection line is connected with a data signal line through a first connection hole, a second end of the first connection line is connected with a first end of the second connection line after extending along the first direction X or an opposite direction of the first direction X, and a second end of the second connection line is connected with a leading out line after extending toward a direction of the lead region along the second direction Y.

In an exemplary implementation mode, multiple data signal lines may be disposed between adjacent second connection lines in the first direction X. For example, one data signal line may be disposed between adjacent second connection lines in the first direction X. For another example, two data signal lines may be disposed between adjacent second connection lines in the first direction X.

In an exemplary implementation mode, for a data output pin of the integrated circuit, data signal output without abrupt change of load may be achieved by using a reverse sequence design, thereby improving display quality.

In an exemplary implementation mode, for a display substrate with a display resolution of M * N, when a data connection line is inserted into data signal lines with a quantity a (i.e., data signal lines with a quantity a are disposed between adjacent second connection lines in the first direction X), data output pins (PIN) of the integrated circuit are arranged in an order from left to right as follows. $[M/(a+1)]+1$, $[M/(a+1)]+2$, 1, $[M/(a+1)]+3$, $[M/(a+1)]+4$, 3 , $[M/(a+1)]+5$, $[M/(a+1)]+6$, 3 ... $[M-1]$, M, $[M/(a+1)]$ ... $[M+1]$, $[M+2]$, $[2M-M/(a+1)+1]$ ... 2M, $[2M-M/(a+1)-1]$, $[2M-M/(a+1)]$.

For example, for a display substrate with a resolution of $1080 \times 2160$, a quantity of data output pins of the integrated circuit is 2160. When one data connection line is inserted into two data signal lines, the data output pins of the integrated circuit are arranged in an order from left to right as follows.

D361, D362, D1, D363, D364, D2, D365, D366, D3, D367, D368, D4, D369, D370...D1073, D1074, D357, D1075, D1076, D358, D1077, D1078, D359, D1079, D1080, D360...D1793, D1794, D2158, D1795, D1796, D2159, D1797, D1798, D2160, D1799, D1800.

In an exemplary implementation mode, the reverse sequence design is only one implementation mode, and an implementation mode of a positive sequence design may be adopted in an actual design. For example, an order of output signals of pins of the integrated circuit may be consistent with an arrangement order of data signal lines in the display region through an over-line design.

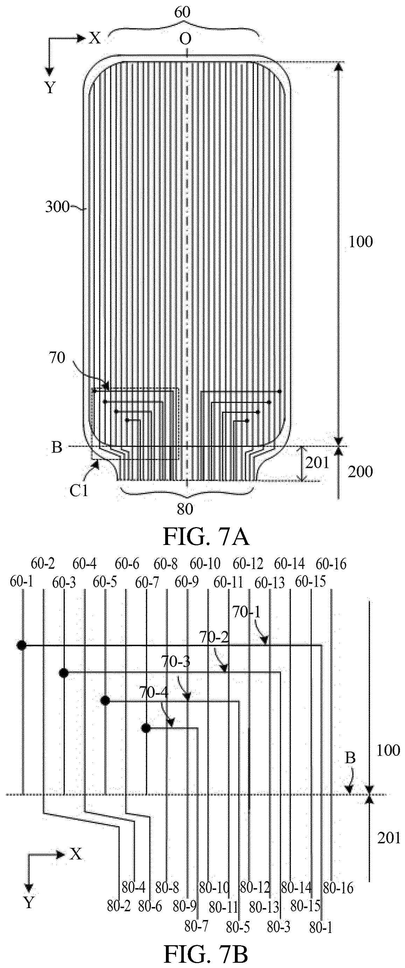

FIG. 7A is a schematic diagram of a planar structure of another display substrate according to an exemplary embodiment of the present disclosure. As shown in FIG. 7A, a main body structure of the display substrate of the present embodiment is substantially the same as that of the display substrate of FIG. 6A, except that one data signal line is disposed between two adjacent first connection holes of the present embodiment.

FIG. 7B is a schematic diagram of an arrangement of another data connection lines according to an exemplary embodiment of the present disclosure, and is an enlarged view of a C1 region in FIG. 7A, illustrating a structure of 16 data signal lines, 4 data connection lines, and 16 leading out lines. As shown in FIG. 7B, the first data signal line group includes four odd-numbered data signal lines (the first data signal line 60-1, the third data signal line 60-3, the fifth data signal line 60-5, and the seventh data signal line 60-7), the second data signal line group includes remaining 12 data signal lines, and the first data signal line 60-1 to the sixteenth data signal line 60-16 may be arranged sequentially along the first direction X.

In an exemplary implementation mode, the first leading out line group includes four odd-numbered leading out lines (the first leading out line 80-1, the third leading out line 80-3, the fifth leading out line 80-5, and the seventh leading out line 80-7), the second leading out line group includes remaining 12 leading out lines, wherein multiple leading out lines of the first leading out line group may be disposed sequentially along an opposite direction of the first direction X, multiple leading out lines of the second leading out line group may be disposed sequentially along the first direction X, and two leading out lines of the second leading out line group are disposed between adjacent leading out lines in the first leading out line group. For example, multiple leading out lines may include the second leading out line 80-2, the fourth leading out line 80-4, the sixth leading out line 80-6, the eighth leading out line 80-8, the ninth leading out line 80-9, the seventh leading out line 80-7, the tenth leading out line 80-10, the eleventh leading out line 80-11, the fifth leading out line 805, the twelfth leading out line 80-12, the thirteenth leading out line 80-13, the third leading out line 803, the fourteenth leading out line 80-14, the fifteenth leading out line 80-15, the first leading out line 80-1, and the sixteenth leading out line 80-16 disposed sequentially along the first direction X.

In an exemplary implementation mode, the fourteenth leading out line 80-14 and the fifteenth leading out line 80-15 may be disposed between the first leading out line 80-1 and the third leading out line and 80-3, the twelfth leading out line 80-12 and the thirteenth leading out line 80-13 may be disposed between the third leading out line 80-3 and the fifth leading out line 80-5, and the tenth leading out line 80-10 and the eleventh leading out line 80-11 may be disposed between the fifth leading out line 80-5 and the seventh leading out line 80-7.

In an exemplary implementation mode, the first connection hole is disposed in a circuit unit of an odd-numbered unit column. A first end of the first data connection line 70-1 is connected with the first data signal line 60-1 through the first connection hole in the display region 100, and a second end is connected with the first leading out line 80-1 after extending to the lead region 201. A first end of the second data connection line 70-2 is connected with the third data signal line 60-3 through the first connection hole in the display region 100, and a second end is connected with the third leading out line 80-3 after extending to the lead region 201. A first end of the third data connection line 70-3 is connected with the fifth data signal line 60-5 through the first connection hole in the display region 100, and a second end is connected with the fifth leading out line 80-5 after extending to the lead region 201. A first end of the fourth data connection line 70-4 is connected with the seventh data signal line 60-7 through the first connection hole in the display region 100, and a second end is connected with the seventh leading out line 80-7 after extending to the lead region 201.

In an exemplary implementation mode, multiple data signal lines of the second data signal line group are connected correspondingly with multiple leading out lines of the second leading out line group after extending to the lead region 201. For example, the second data signal line 60-2, the fourth data signal line 60-4, the sixth data signal line 60-6, and the eighth data signal line 60-8 to the sixteenth data signal line 60-16 are correspondingly connected with corresponding leading out lines.

In an exemplary implementation mode, distances between multiple first connection holes through which data connection lines and data signal lines are connected correspondingly and an edge B of the display region may be different.

In an exemplary implementation mode, two data signal lines may be disposed between adjacent second connection lines in the first direction X, forming a structure in which a data connection line is connected with a data signal line of an odd-numbered unit column, and two data signal lines are disposed between adjacent second connection lines.

In an exemplary implementation mode, a part of leading out lines in the second leading out line group are straight lines parallel to a data signal line, and the other part of the leading out lines are broken lines. For example, shapes of the tenth leading out line 80-10 to the sixteenth leading out line 80-16 may be straight lines, and shapes of the second leading out line 80-2, the fourth leading out line 80-4, and the sixth leading out line 80-6 may be broken lines.

In an exemplary implementation mode, positions of multiple sub-pixels in the light emitting structure layer and positions of multiple circuit units in the drive structure layer may correspond. An odd-numbered unit column may be referred to as a first unit column. Multiple circuit units of the odd-numbered unit column correspond to multiple red sub-pixels and blue sub-pixels, that is, pixel drive circuits of multiple circuit units in the odd-numbered unit column are respectively connected with red light emitting devices emitting red light and blue light emitting devices emitting blue light. An even-numbered unit column may be referred to as a second unit column, and multiple circuit units of the even-numbered unit column correspond to multiple green sub-pixels, that is, pixel drive circuits of multiple circuit units in the even-numbered unit column are connected with green light emitting devices emitting green light.

In an exemplary implementation mode, a first connection line is connected with a data signal line of the first unit column through a first connection hole, and the first connection line is not connected with a data signal line of the second unit column. In the present disclosure, by disposing the first connection hole in the odd-numbered unit column, that is, data signals of a red sub-pixel and a blue sub-pixel are transmitted by using a data connection line, not only a layout of data connection lines may be facilitated, but also a load without abrupt change may be achieved by using a reverse sequence design, thus improving display quality.

In some possible exemplary embodiments, a data connection line may be connected with a data signal line of the odd-numbered unit column, and one data signal line may be disposed between adjacent second connection lines in the first direction X, which is not limited here in the present disclosure.

By disposing a data connection line in the display region in the present disclosure, a leading out line of the bonding region is enabled to be connected with a data signal line through the data connection line, so that a fan-shaped oblique line does not need to be disposed in the lead region, which effectively reduces a length of the lead region, greatly reduces a width of a lower bezel, and increasing a screen-to-body ratio, which is beneficial to achieve full-screen display.

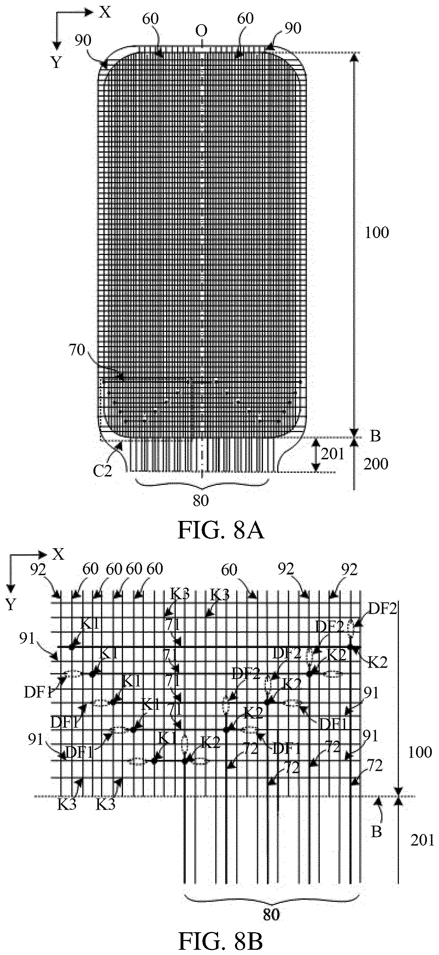

FIG. 8A is a schematic diagram of a planar structure of yet another display substrate according to an exemplary embodiment of the present disclosure, and FIG. 8B is an enlarged view of a C2 region in FIG. 8A. A drive structure layer of a display region 100 may include a plurality of circuit units constituting a circuit unit array, a plurality of data signal lines 60, a plurality of data connection lines 70, and power supply traces 90 with a mesh communication structure. A layout and a structure of the plurality of circuit units, the plurality of data signal lines 60, and the plurality of data connection lines 70 are substantially the same as a layout and a structure shown in FIG. 6A aforementioned.

As shown in FIGs. 8A and 8B, in an exemplary implementation mode, the data connection lines 70 may include a first connection line 71 extending along a first direction X and a second connection line 72 extending along a second direction Y. The first connection line 71 and the second connection line 72 may be disposed in different conductive layers. The first connection line 71 and a data signal line 60 may be disposed in different conductive layers. A first end of the first connection line 71 is connected with the data signal line 60 through a first connection hole K1, and a second end of the first connection line 71 is connected with a first end of the second connection line 72 through a second connection hole K2 after extending along the first direction X or an opposite direction of the first direction X. The second end of the second connection line 72 is connected with a leading out line 80 after extending toward a direction of a lead region along the second direction Y, and the second connection line 72 may be disposed between adjacent data signal lines 60 in the first direction X.

In an exemplary implementation mode, the power supply traces 90 may include multiple first power supply traces 91 extending along the first direction X and multiple second power supply traces 92 extending along the second direction Y, wherein the multiple first power supply traces 91 may be sequentially disposed along the second direction Y, and the multiple second power supply traces 92 may be sequentially disposed along the first direction X.

In an exemplary implementation mode, a first power supply trace 91 and a second power supply trace 92 may be disposed in different conductive layers, wherein the second power supply trace 92 may be disposed between adjacent data signal lines 60, and at least one second power supply trace 92 may be connected with at least one first power supply trace 91 through a third connection hole K3, so that the multiple first power supply traces 91 and the multiple second power supply traces 92 constitute the power supply traces 90 with the mesh communication structure.

In an exemplary implementation mode, two data signal lines 60 and one second power supply trace 92 may be disposed between two adjacent second connection lines 72 in the first direction X.

In an exemplary implementation mode, the first power supply trace 91 and the first connection line 71 may be disposed in a same layer and formed synchronously through a same patterning process, and the second power supply trace 92 and the second connection line 72 may be disposed in a same layer and formed synchronously through a same patterning process.

In an exemplary implementation mode, only one first power supply trace 91 may be disposed in at least one circuit row and no first connection line 71 is disposed in the circuit row.

In an exemplary implementation mode, at least one first power supply trace 91 and at least one first connection line 71 may be disposed in at least one circuit row, wherein a first fracture DF1 is disposed between the first power supply trace 91 and the first connection line 71, and the first fracture DF1 is configured to achieve insulation between the first power supply trace 91 and the first connection line 71.

In an exemplary implementation mode, only one second power supply trace 92 may be disposed in at least one circuit column and no second connection line 72 is disposed in the circuit column.

In an exemplary implementation mode, the at least one circuit column may be provided with at least one second power supply trace 92 and at least one second connection line 72, wherein a second fracture DF2 is disposed between the second power supply trace 92 and the second connection line 72, and the second fracture DF2 is configured to achieve insulation between the second power supply trace 92 and the second connection line 72.

In an exemplary implementation mode, first connection holes K1 may be disposed in circuit units of adjacent unit columns, and one second power supply traces 92 may be disposed between two adjacent first connection holes K1 in the first direction X.

In an exemplary implementation mode, a power supply trace 90 may be a low-level signal continuously provided. For example, the power supply trace 90 may be a second power supply line VSS.

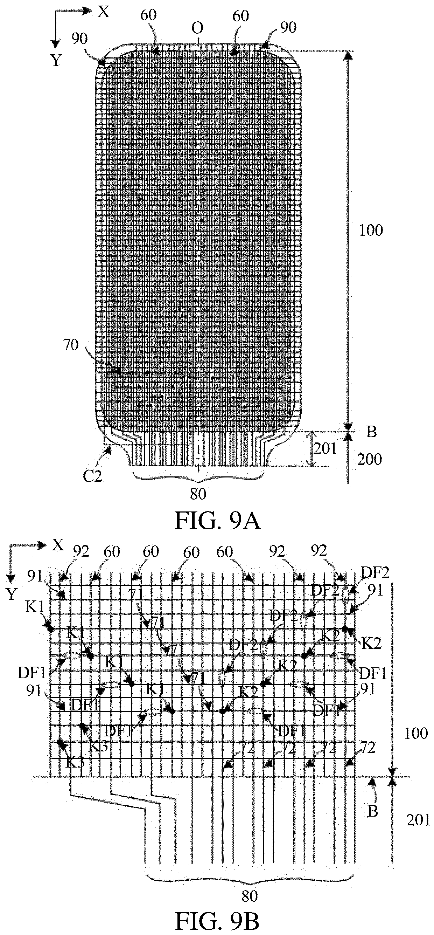

FIG. 9A is a schematic diagram of a planar structure of yet another display substrate according to an exemplary embodiment of the present disclosure, and FIG. 9B is an enlarged view of a C2 region in FIG. 9A. A drive structure layer of a display region 100 may include a plurality of circuit units constituting a circuit unit array, a plurality of data signal lines 60, a plurality of data connection lines 70, and power supply traces 90 with a mesh communication structure. A layout and a structure of the plurality of circuit units, the plurality of data signal lines 60, and the plurality of data connection lines 70 are substantially the same as a layout and a structure shown in FIG. 7A aforementioned.

As shown in FIGs. 9A and 9B, a main body structure of the display substrate of the present embodiment is substantially the same as that of the display substrate shown in FIGs. 8A and 8B, except that one data signal line 60 and two second power supply traces 92 may be disposed between two adjacent first connection holes K1 in the first direction X of the present embodiment.

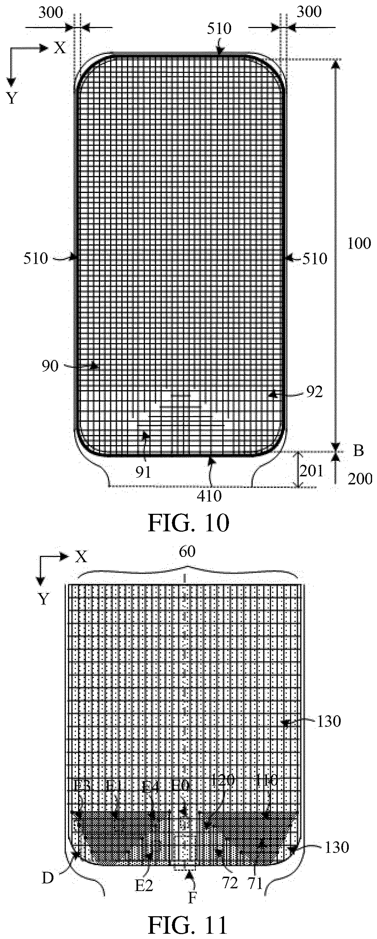

FIG. 10 is a schematic diagram of a planar structure of a power supply trace according to an exemplary embodiment of the present disclosure. As shown in FIG. 10, a display substrate may include a display region 100, a bonding region 200 located on a side of the display region 100 in a second direction Y, and a bezel region 300 located on another side of the display region 100, wherein the display region 100 is provided with grid-like power supply traces 90, the bonding region 200 is provided with a bonding power supply lead 410, the bezel region 300 is provided with a bezel power supply lead 510, and a power supply trace 90 may be connected with the bonding power supply lead 410 and the bezel power supply lead 510, respectively.

In an exemplary implementation mode, the bonding power supply lead 410 of the bonding region 200 and the bezel power supply lead 510 of the bezel region 300 may be connected with each other to be of an integral structure.

In an exemplary implementation mode, the power supply traces 90 of the display region 100 may include a plurality of first power supply traces 91 extending along a first direction X and a plurality of second power supply traces 92 extending along a second direction Y, wherein the plurality of first power supply traces 91 may be sequentially disposed along the second direction Y, and one end or two ends in the first direction X are connected with the bezel power supply lead 510, and the plurality of second power supply traces 92 may be sequentially disposed along the first direction X, and one end of a second power supply trace 92 away from the bonding region is connected with the bezel power supply lead 510.

In an exemplary implementation mode, one end of at least one second power supply trace 92 in the second direction Y may be connected with the bonding power supply lead 410.

In an exemplary implementation mode, a first power supply trace 91 and a second power supply trace 92 may be disposed in different conductive layers, and at least one second power supply trace 92 may be connected with at least one first power supply trace 91 through a third connection hole, so that the multiple first power supply traces 91 and the multiple second power supply traces 92 have a same potential. In the present disclosure, a structure in which a low voltage line is disposed in a sub-pixel (VSS in pixel) is achieved by disposing power supply traces in the display region, which may greatly reduce a width of a bezel power supply lead and is beneficial to achieve a narrow bezel. In the present disclosure, by disposing power supply traces in a mesh communication structure, not only a resistance of the power supply traces may be effectively reduced, voltage drop of a low voltage power supply signal may be effectively reduced, and low power consumption may be achieved, but also uniformity of power supply signals in the display substrate may be effectively improved, effectively improving display uniformity, and improving display character and display quality.

FIG. 11 is a schematic diagram of a structure of a data connection line according to an exemplary embodiment of the present disclosure. As shown in FIG. 11, since the data connection line is disposed in a part of a display region, and the data connection line includes a first connection line extending along a first direction X and a second connection line extending along a second direction Y, the display region may be divided into a first region 110, a second region 120, and a third region 130 according to whether there is a data connection line or not and by taking an extension direction of the data connection line as a division basis, wherein the first region 110 may be a region provided with a first connection line 71 (which may be referred to as a connection line lateral trace region), the second region 120 may be a region provided with a second connection line 72 (which may be referred to as a connection line longitudinal trace region), the third region 130 may be a region where no first connection line 71 or second connection line 72 is provided (which may be referred to as a normal region).

In an exemplary implementation mode, the first region 110 may include multiple circuit units, wherein an orthographic projection of the first connection line 71 on a plane of a display substrate is at least partially overlapped with orthographic projections of pixel drive circuits in multiple circuit units of the first region 110 on the plane of the display substrate, and the orthographic projections of the pixel drive circuits in the multiple circuit units of the first region 110 on the plane of the display substrate are not overlapped with an orthographic projection of the second connection line 72 on the plane of the display substrate.

In an exemplary implementation mode, the second region 120 may include multiple circuit units, wherein the orthographic projection of the second connection line 72 on the plane of the display substrate is at least partially overlapped with orthographic projections of pixel drive circuits in the multiple circuit units of the second region 120 on the plane of the display substrate, and the orthographic projections of the pixel drive circuits in the multiple circuit units of the second region 120 on the plane of the display substrate are not overlapped with the orthographic projection of the first connection line 71 on the plane of the display substrate.

In an exemplary implementation mode, the third region 130 may include multiple circuit units, wherein orthographic projections of pixel drive circuits in the multiple circuit units of the third region 130 on the plane of the display substrate are not overlapped with orthographic projections of the first connection line 71 and the second connection line 72 on the plane of the display substrate.

In an exemplary implementation mode, division of various regions shown in FIG. 11 is only exemplary illustration. Since the first region 110, the second region 120, and the third region 130 are divided according to whether there is a data connection line or not and by taking an extension direction of the data connection line as a division basis, shapes of the three regions may be regular polygons or irregular polygons, and the display region may be divided into one or more first regions 110, one or more second regions 120, and one or more third regions 130, which are not limited here in the present disclosure.

An exemplary embodiment of the present disclosure provides a display substrate including a plurality of circuit units, a plurality of data signal lines, and a plurality of data connection lines, wherein the data connection lines include a first connection line extending along a first direction and a second connection line extending along a second direction, the data signal lines extend along the second direction, and the first direction and the second direction intersect; and at least one circuit unit includes a data connection electrode, at least one circuit unit includes a fan-out connection electrode, wherein the second connection line is connected with the first connection line through the fan-out connection electrode, and the first connection line is connected with a data signal line through the data connection electrode; an orthographic projection of the data connection electrode on a plane of the display substrate is at least partially overlapped with an orthographic projection of the data signal line on the plane of the display substrate, an orthographic projection of the fan-out connection electrode on the plane of the display substrate is at least partially overlapped with an orthographic projection of the second connection line on the plane of the display substrate, and at least one of the data signal lines is disposed between the data connection electrode and the fan-out connection electrode connected with a same first connection line.

In an exemplary implementation mode, the data connection electrode and the fan-out connection electrode connected with a same first connection line are respectively disposed on two sides of the first connection line.

In an exemplary implementation mode, at least one circuit unit includes a dummy electrode, wherein a position and a shape of the dummy electrode in one circuit unit is the same as those of the fan-out connection electrode in another circuit unit.

In an exemplary implementation mode, an orthographic projection of the dummy electrode on the plane of the display substrate is at least partially overlapped with the orthographic projection of the second connection line on the plane of the display substrate.

In an exemplary implementation mode, the display substrate further includes multiple first power supply traces extending along the first direction and multiple second power supply traces extending along the second direction; at least one circuit unit includes a power supply connection electrode, wherein the second power supply trace is connected with the first power supply trace through the power supply connection electrode, and an orthographic projection of the power supply connection electrode on the plane of the display substrate is at least partially overlapped with an orthographic projection of the second power supply trace on the plane of the display substrate.

In an exemplary implementation mode, at least one circuit unit includes a dummy electrode, wherein a position and a shape of the dummy electrode in one circuit unit is the same as those of the power supply connection electrode in another circuit unit.

In an exemplary implementation mode, an orthographic projection of the dummy electrode on the plane of the display substrate is at least partially overlapped with the orthographic projection of the second power supply trace on the plane of the display substrate.

In an exemplary implementation mode, the first power supply trace and the first connection line are disposed in a same layer, at least one first power supply trace and at least one first connection line are disposed in at least one circuit row, at least one first fracture is disposed between the first connection line and the first power supply trace, and an orthographic projection of the first fracture on the plane of the display substrate is at least partially overlapped with the orthographic projection of the second power supply trace on the plane of the display substrate, or the orthographic projection of the first fracture on the plane of the display substrate is at least partially overlapped with the orthographic projection of the second connection line on the plane of the display substrate.

In an exemplary implementation mode, a first width of the first fracture is less than or equal to a second width of the second power supply trace or the second connection line, wherein the first width and the second width are dimensions in the first direction, and the orthographic projection of the first fracture on the plane of the display substrate is within a range of the orthographic projection of the second power supply trace or the second connection line on the plane of the display substrate.

In an exemplary implementation mode, the second power supply trace and the second connection line are disposed in a same layer, at least one second power supply trace and at least one second connection line are disposed in at least one circuit column, a second fracture is disposed between the second connection line and the second power supply trace, and an orthographic projection of the second fracture on the plane of the display substrate is at least partially overlapped with an orthographic projection of the first connection line or the first power supply trace on the plane of the display substrate.

In an exemplary implementation mode, a third width of the second fracture is equal to a fourth width of the first connection line or the first power supply trace, wherein the third width and the fourth width are dimensions in the second direction, and a boundary of an orthographic projection of the second fracture on the plane of the display substrate is flush with a boundary of the orthographic projection of the first connection line or the first power supply trace on the plane of the display substrate.

In an exemplary implementation mode, at least one circuit unit at least includes a pixel drive circuit, wherein the pixel drive circuit at least includes a storage capacitor and multiple transistors; in a plane perpendicular to the display substrate, the circuit unit includes a semiconductor layer, a first conductive layer, a second conductive layer, a third conductive layer, and a fourth conductive layer sequentially disposed on a base substrate, the semiconductor layer at least includes active layers of multiple transistors, the first conductive layer at least includes gate electrodes of multiple transistors and a first electrode plate of the storage capacitor, the second conductive layer at least includes a second electrode plate of the storage capacitor, the third conductive layer at least includes the first connection line, and the fourth conductive layer at least includes the data signal line and the second connection line.

In an exemplary implementation mode, the third conductive layer further includes a data connection electrode and a fan-out connection electrode respectively connected with the first connection line, wherein the data signal line is connected with the data connection electrode through a first connection hole, and the second connection line is connected with the fan-out connection electrode through a second connection hole.

In an exemplary implementation mode, the third conductive layer further includes a first power supply trace extending along the first direction and a power supply connection electrode connected with the first power supply trace, the fourth conductive layer further includes a second power supply trace extending along the second direction, and the second power supply trace is connected with the power supply connection electrode through a third connection hole.

In an exemplary implementation mode, the third conductive layer further includes a dummy electrode, wherein in at least one circuit unit, the second connection line is connected with the dummy electrode through a connection hole, and in at least one circuit unit, the second power supply trace is connected with the dummy electrode through a connection hole.

In an exemplary implementation mode, the drive structure layer may further at least include a first insulation layer, a second insulation layer, a third insulation layer, a fourth insulation layer, and a first planarization layer, wherein the first insulation layer is disposed between the base substrate and the semiconductor layer, the second insulation layer is disposed between the semiconductor layer and the first conductive layer, the third insulation layer is disposed between the first conductive layer and the second conductive layer, the fourth insulation layer is disposed between the second conductive layer and the third conductive layer, and the first planarization layer is disposed between the third conductive layer and the fourth conductive layer.

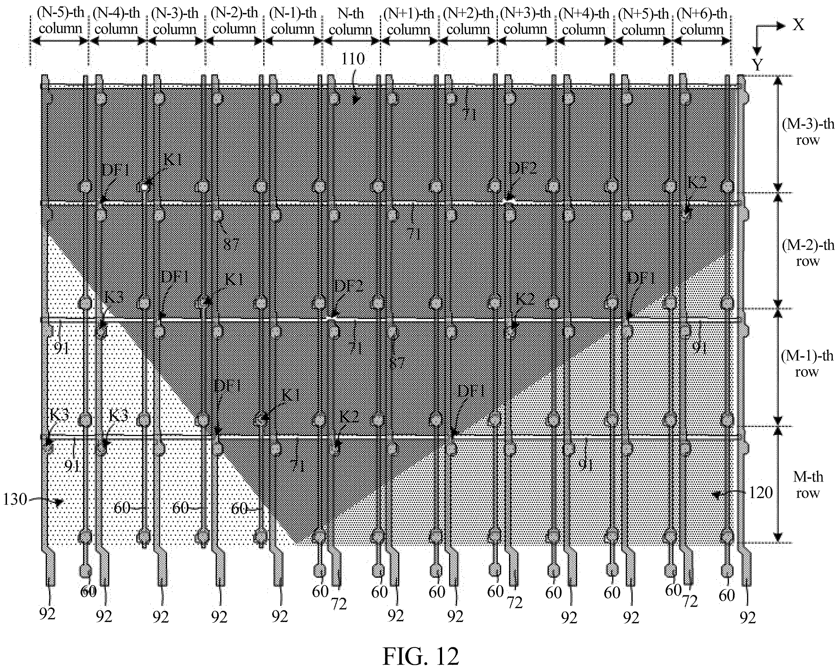

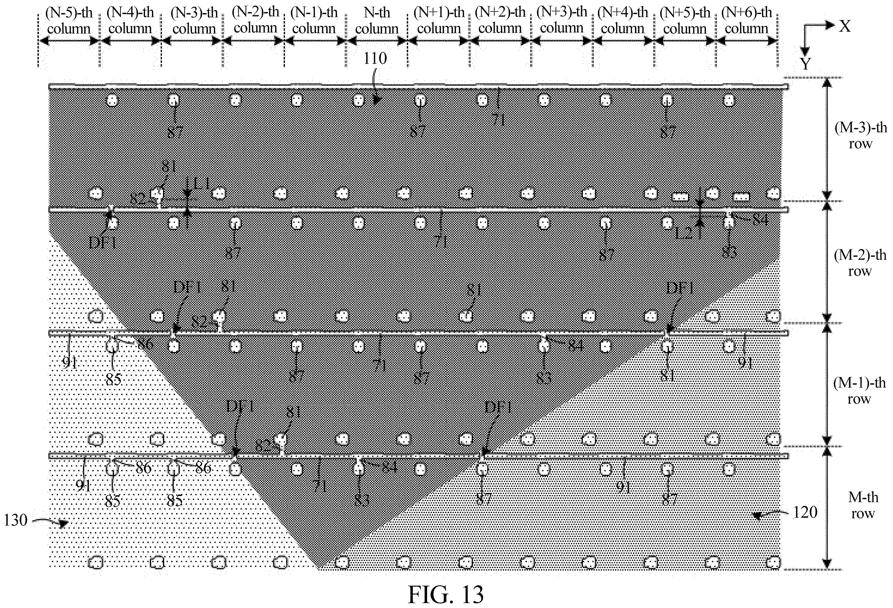

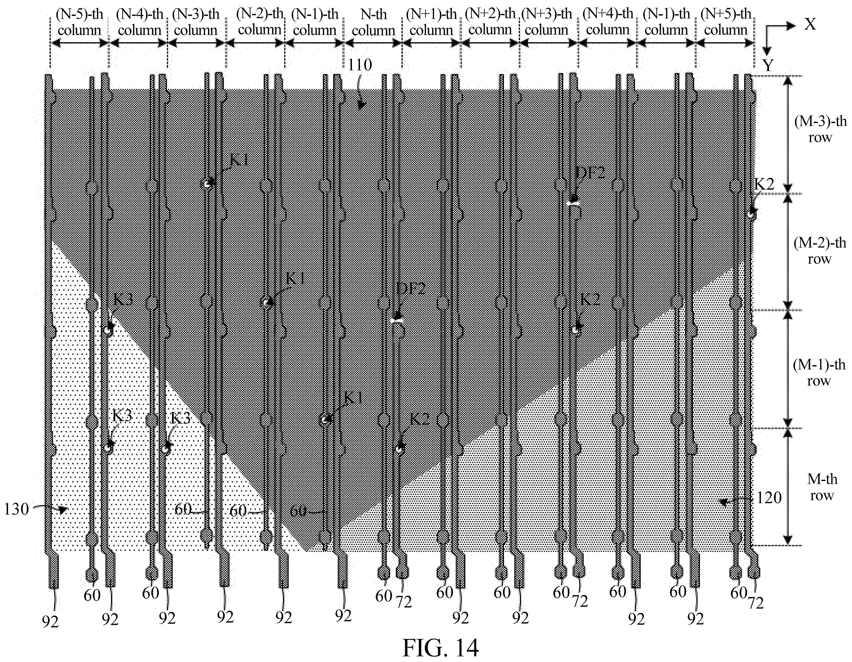

FIG. 12 is a schematic diagram of a structure of a circuit unit according to an exemplary embodiment of the present disclosure, and is an enlarged view of a region D in FIG. 11, illustrating a structure of a circuit unit of 4 circuit rows and 12 circuit columns. FIG. 13 is a schematic diagram of a structure of a third conductive layer in FIG. 12. FIG. 14 is a schematic diagram of a structure of a fourth conductive layer in FIG. 12. As shown in FIGs. 12, 13, and 14, in a plane parallel to a display substrate, a drive structure layer may include: a plurality of circuit units constituting multiple unit rows and multiple unit columns, and a plurality of data signal lines 60, a plurality of first connection lines 71, a plurality of second connection lines 72, a plurality of first power supply traces 91, and a plurality of second power supply traces 92, wherein a circuit unit may at least include a pixel drive circuit, a shape of a data signal line 60 may be a shape of a straight line extending along a second direction Y, the data signal line 60 may be connected with pixel drive circuits of a plurality of circuit units in a unit column where the data signal line 60 is located, shapes of a first connection line 71 and a first power supply trace 91 may be shapes of straight lines extending along a first direction X, and shapes of a second connection line 72 and a second power supply trace 92 may be shapes of straight lines extending along the second direction Y.

In an exemplary implementation mode, in a plane parallel to the display substrate, the drive structure layer may include a first region 110, a second region 120, and a third region 130, wherein the first region 110 may be a region provided with the first connection line 71, the second region 120 may be a region provided with the second connection line 72, the third region 130 may be a region where no first connection line 71 or second connection line 72 is provided, and the first region 110, the second region 120, and the third region 130 are each provided with a data signal line 60, a first power supply trace 91, and a second power supply trace 92.

In an exemplary implementation mode, at least one circuit unit in the first region 110 may include a data connection electrode 81 and a data connection block 82, wherein there is a first distance L1 between the first connection line 71 and the data connection electrode 81, and the first distance L1 may be greater than 0. In an exemplary implementation mode, the first distance L1 may be a distance between an edge of the first connection line 71 close to the data connection electrode 81 and an edge of the data connection electrode 81 close to the first connection line 71, and the first distance L1 is a dimension in the second direction Y. The data connection block 82 may be disposed between the first connection line 71 and the data connection electrode 81, and be respectively connected with the first connection line 71 and the data connection electrode 81. The data signal line 60 may be connected with the data connection electrode 81 through a first connection hole K1, thereby achieving a connection between the data signal line 60 and the first connection line 71. For example, a data connection electrode 81 and a data connection block 82 are disposed in a circuit unit of an (M-2)-th row and an (N-3)-th column, and the data connection electrode 81 is connected with a first connection line 71 of an (M-1)-th row through the data connection block 82.

In an exemplary implementation mode, an orthographic projection of the data connection electrode 81 on a plane of the display substrate is at least partially overlapped with an orthographic projection of the data signal line 60 on the plane of the display substrate.

In an exemplary implementation mode, the orthographic projection of the data connection electrode 81 on the plane of the display substrate may be located within a range of the orthographic projection of the data signal line 60 on the plane of the display substrate.

In an exemplary implementation mode, an orthographic projection of the data connection block 82 on the plane of the display substrate is at least partially overlapped with the orthographic projection of the data signal line 60 on the plane of the display substrate.

In an exemplary implementation mode, the orthographic projection of the data connection block 82 on the plane of the display substrate may be located within the range of the orthographic projection of the data signal line 60 on the plane of the display substrate.

In an exemplary implementation mode, at least one circuit unit in the first region 110 may include a fan-out connection electrode 83 and a fan-out connection block 84, wherein there is a second distance L2 between the first connection line 71 and the fan-out connection electrode 83, and the second distance L2 may be greater than 0. In an exemplary implementation mode, the second distance L2 may be a distance between an edge of the first connection line 71 close to the fan-out connection electrode 83 and an edge of the fan-out connection electrode 83 close to the first connection line 71, and the second distance L2 is a dimension in the second direction Y. The fan-out connection block 84 may be disposed between the first connection line 71 and the fan-out connection electrode 83, and respectively connected with the first connection line 71 and the fan-out connection electrode 83. The second connection line 72 may be connected with the fan-out connection electrode 83 through a second connection hole K2, thereby achieving a connection between the second connection line 72 and the first connection line 71. For example, a fan-out connection block 84 and a fan-out connection electrode 83 are disposed in a circuit unit of the (M-1)-th row and an (N+3)-th column, wherein the fan-out connection electrode 83 is connected with the first connection line 71 of the (M-1)-th row through the fan-out connection block 84. Since the fan-out connection electrode 83 is connected with the second connection line 72 through the second connection hole K2 and the data connection electrode 81 is connected with the data signal line 60 through the first connection hole K1, it is achieved that the data signal line 60 is connected with the second connection line 72 through the first connection line 71.

In an exemplary implementation mode, an orthographic projection of the fan-out connection electrode 83 on the plane of the display substrate is at least partially overlapped with an orthographic projection of the second connection line 72 on the plane of the display substrate.

In an exemplary implementation mode, the orthographic projection of the fan-out connection electrode 83 on the plane of the display substrate may be located within a range of the orthographic projection of the second connection line 72 on the plane of the display substrate.

In an exemplary implementation mode, an orthographic projection of the fan-out connection block 84 on the plane of the display substrate is at least partially overlapped with the orthographic projection of the second connection line 72 on the plane of the display substrate.

In an exemplary implementation mode, the orthographic projection of the fan-out connection block 84 on the plane of the display substrate may be located within the range of the orthographic projection of the second connection line 72 on the plane of the display substrate.

In an exemplary implementation mode, for a data connection electrode 81 and a fan-out connection electrode 83 connected with a same first connection line 71, at least one data signal line 60 may be disposed between the data connection electrode 81 and the fan-out connection electrode 83, the data connection electrode 81 may be disposed on one side of the first connection line 71 in an opposite direction of the second direction Y, the fan-out connection electrode 83 may be disposed on one side of the first connection line 71 in the second direction Y, that is, the data connection electrode 81 and the fan-out connection electrode 83 are respectively disposed on two sides of the first connection line 71 in the second direction Y, and correspondingly, a first connection hole K1 and a second connection hole K2 connected with a same first connection line 71 are respectively disposed on two sides of the first connection line 71 in the second direction Y.

In an exemplary implementation mode, at least one circuit unit in the third region 130 may include a power supply connection electrode 85 and a power supply connection block 86, wherein the power supply connection block 86 may be disposed between the first power supply trace 91 and the power supply connection electrode 85, and connected with the first power supply trace 91 and the power supply connection electrode 85, respectively. The second power supply trace 92 may be connected with the power supply connection electrode 85 through a third connection hole K3, thereby achieving a connection between the first power supply trace 91 and the second power supply trace 92, and multiple first power supply trace 91 and multiple second power supply trace 92 constitute power supply traces with a mesh structure.

In an exemplary implementation mode, an orthographic projection of the power supply connection electrode 85 on the plane of the display substrate is at least partially overlapped with an orthographic projection of the second power supply trace 92 on the plane of the display substrate.

In an exemplary implementation mode, the orthographic projection of the power supply connection electrode 85 on the plane of the display substrate may be located within a range of the orthographic projection of the second power supply trace 92 on the plane of the display substrate.

In an exemplary implementation mode, an orthographic projection of the power supply connection block 86 on the plane of the display substrate is at least partially overlapped with the orthographic projection of the second power supply trace 92 on the plane of the display substrate.

In an exemplary implementation mode, the orthographic projection of the power supply connection block 86 on the plane of the display substrate may be located within the range of the orthographic projection of the second power supply trace 92 on the plane of the display substrate.

In an exemplary implementation mode, the power supply connection electrode 85 and the power supply connection block 86 may be disposed on one side of the first power supply trace 91 in the second direction Y.

In an exemplary implementation mode, at least one circuit unit in the first region 110 or the third region 130 may include a first fracture DF1, wherein the first fracture DF1 may be disposed between a first connection line 71 and a first power supply trace 91 in one unit row, achieving insulation of the first connection line 71 and the first power supply trace 91.

In an exemplary implementation mode, an orthographic projection of the first fracture DF1 on the plane of the display substrate is at least partially overlapped with the orthographic projection of the second power supply trace 92 or the second connection line 72 on the plane of the display substrate.

In an exemplary implementation mode, the orthographic projection of the first fracture DF1 on the plane of the display substrate may be located within a range of the orthographic projection of the second power supply trace 92 or the second connection line 72 on the plane of the display substrate.

In an exemplary implementation mode, at least one circuit unit in the first region 110 or the third region 130 may include a second fracture DF2, wherein the second fracture DF2 may be disposed between a second connection line 72 and a second power supply trace 92 in one unit column, achieving insulation of the second connection line 72 and the second power supply trace 92.

In an exemplary implementation mode, an orthographic projection of the second fracture DF2 on the plane of the display substrate is at least partially overlapped with an orthographic projection of the first connection line 71 or the first power supply trace 91 on the plane of the display substrate.

In an exemplary implementation mode, the orthographic projection of the second fracture DF2 on the plane of the display substrate may be flush with a boundary of the orthographic projection of the first connection line 71 or the first power supply trace 91 on the plane of the display substrate.

In an exemplary implementation mode, at least one circuit unit in the first region 110 may include a dummy electrode 87, wherein the second power supply trace 92 may be connected with the dummy electrode 87 through a connection hole.

In an exemplary implementation mode, an orthographic projection of the dummy electrode 87 on the plane of the display substrate is at least partially overlapped with the orthographic projection of the second power supply trace 92 on the plane of the display substrate.

In an exemplary implementation mode, the orthographic projection of the dummy electrode 87 on the plane of the display substrate may be located within the range of the orthographic projection of the second power supply trace 92 on the plane of the display substrate.

In an exemplary implementation mode, at least one circuit unit in the second region 120 may include a dummy electrode 87, wherein the second connection line 72 may be connected with the dummy electrode 87 through a connection hole.

In an exemplary implementation mode, the orthographic projection of the dummy electrode 87 on the plane of the display substrate is at least partially overlapped with the orthographic projection of the second connection line 72 on the plane of the display substrate.

In an exemplary implementation mode, the orthographic projection of the dummy electrode 87 on the plane of the display substrate may be located within the range of the orthographic projection of the second connection line 72 on the plane of the display substrate.

In an exemplary implementation mode, the data connection electrode 81, the data connection block 82, the power supply connection electrode 85, the power supply connection block 86, the fan-out connection electrode 83, the fan-out connection block 84, the dummy electrode 87, the first connection line 71, and the first power supply trace 91 may be disposed in a third conductive layer, and the data signal line 60, the second connection line 72, and the second power supply trace 92 may be disposed in a fourth conductive layer.

In an exemplary implementation mode, a position and a shape of the dummy electrode 87 in the circuit unit may be substantially the same as a position and a shape of the fan-out connection electrode 83 in the circuit unit, the position and the shape of the dummy electrode 87 in the circuit unit may be substantially the same as a position and a shape of the power supply connection electrode 85 in the circuit unit, so that the fan-out connection electrode 83, the power supply connection electrode 85, and the dummy electrode 87 appears same morphology and via connection structure, through a same design of a transfer region, not only uniformity of a subsequent etching process may be improved, but also a same display effect may all be achieved in different regions under transmitted and reflected light, which effectively avoids shadow elimination, effectively avoids poor appearance of the display substrate, and improves display character and display quality.

Exemplary description is made below through a preparation process of a display substrate. A "patterning process" mentioned in the present disclosure includes all or part of processing processes such as coating photoresist, mask exposure, development, etching, and stripping of photoresist. A "thin film" refers to a layer of thin film made of a material on a base substrate using a process such as deposition and coating. If the "thin film" does not need a patterning process in an entire manufacturing process, the "thin film" may also be called a "layer". If the "thin film" needs a patterning process in an entire manufacturing process, it is called a "thin film" before the patterning process, and called a "layer" after the patterning process. The "layer" after the patterning process includes at least one "pattern". "A and B being disposed in a same layer" mentioned in the present disclosure means that A and B are formed simultaneously through a same patterning process, and a "thickness" of a film layer is a dimension of the film layer in a direction perpendicular to the display substrate. In an exemplary embodiment of the present disclosure, "an orthographic projection of B is within a range of an orthographic projection of A" or "an orthographic projection of A contains an orthographic projection of B" refers to that a boundary of the orthographic projection of B falls within a range of a boundary of the orthographic projection of A, or a boundary of the orthographic projection of A is overlapped with a boundary of the orthographic projection of B.

In an exemplary implementation mode, a preparation process of the display substrate may include following operations.

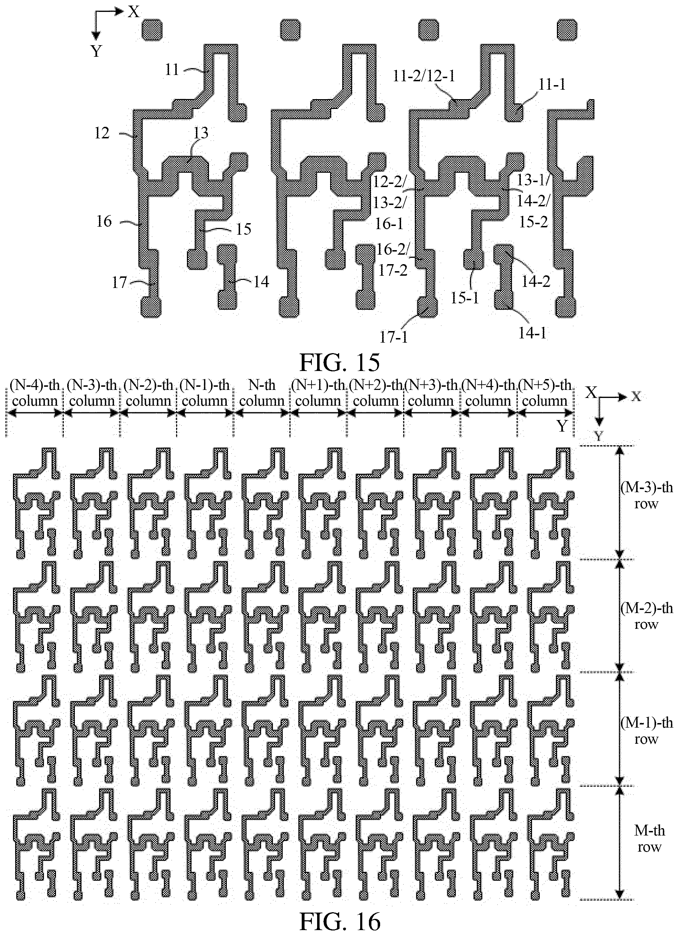

(1) A pattern of a semiconductor layer is formed. In an exemplary implementation mode, the pattern of the semiconductor layer is formed, which may include: a first insulation thin film and a semiconductor thin film are sequentially deposited on a base substrate, and the semiconductor thin film is patterned through a patterning process to form a first insulation layer covering the base substrate and a semiconductor layer disposed on the first insulation layer, as shown in FIGs. 15 and 16, wherein FIG. 15 is an enlarged view of an E0 region in FIG. 11, and FIG. 16 is an enlarged view of an F region in FIG. 11.

In an exemplary implementation mode, the semiconductor layer of each circuit unit in a display region may at least include a first active layer 11 of a first transistor T1 to a seventh active layer 17 of a seventh transistor T7, and the first active layer 11 to the third active layer 13, and the fifth active layer 15 to the seventh active layer 17 may be connected with each other to be of an integral structure, and the fourth active layer 14 may be disposed separately.

In an exemplary implementation mode, the first active layer 11 and the second active layer 12 may be located on one side of the third active layer 13 of a present circuit unit in an opposite direction of a second direction Y, and the fourth active layer 14, the fifth active layer 15, the sixth active layer 16, and the seventh active layer 17 may be located on one side of the third active layer 13 of the present circuit unit in the second direction Y.

In an exemplary implementation mode, a shape of the first active layer 11 may be an "n" shape, shapes of the second active layer 12 and the fifth active layer 15 may be an "L" shape, a shape of the third active layer 13 may be an "Ω" shape, shapes of the fourth active layer 14, the sixth active layer 16, and the seventh active layer 17 may be an "I" shape.

In an exemplary implementation mode, an active layer of each transistor may include a first region, a second region, and a channel region located between the first region and the second region. In an exemplary implementation mode, a first region 11-1 of the first active layer 11, a first region 14-1 of the fourth active layer 14, a second region 14-2 of the fourth active layer 14, a first region 15-1 of the fifth active layer 15, and a first region 17-1 of the seventh active layer 17 may be separately disposed, a second region 11-2 of the first active layer 11 may serve as a first region 12-1 of the second active layer 12, a first region 13-1 of the third active layer 13 may simultaneously serve as a second region 14-2 of the fourth active layer 14 and a second region 15-2 of the fifth active layer 15, a second region 13-2 of the third active layer 13 may simultaneously serve as a second region 12-2 of the second active layer 12 and a first region 16-1 of the sixth active layer 16, and a second region 16-2 of the sixth active layer 16 may serve as a second region 17-2 of the seventh active layer 17.

In an exemplary implementation mode, the fourth active layer 14 may be separately disposed on one side of the fifth active layer 15 in the first direction X, the first region 14-1 of the fourth active layer 14 may be disposed on one side of a channel region of the fourth active layer 14 away from the third active layer 13, and the second region 14-2 of the fourth active layer 14 may be disposed on one side of the channel region of the fourth active layer 14 close to the third active layer 13. In an exemplary implementation mode, the first region 14-1 of the fourth active layer 14 is configured to be connected with the data signal line through a fourth connection electrode to be formed subsequently, and the second region 14-2 of the fourth active layer 14 is configured to be connected with the first region 13-1 of the third active layer 13 through a third connection electrode to be formed subsequently.

In an exemplary implementation mode, the second region 14-2 of the fourth active layer 14 may be located on one side of the first region 15-1 of the fifth active layer 15 in the first direction X, i.e., the first region 15-1 of the fifth active layer 15 may be located between the second region 14-2 of the fourth active layer 14 and the second region 16-2 of the sixth active layer 16 (also the second region 17-2 of the seventh active layer 17).

In an exemplary implementation mode, the first region of the third active layer may serve as a first electrode of the third transistor (a drive transistor), the second region of the fourth active layer may serve as a second electrode of the fourth transistor (a data writing transistor), and the second region of the fifth active layer may serve as a second electrode of the fifth transistor, and a connection point for the first region of the third active layer, the second region of the fourth active layer, and the second region of the fifth active layer connecting with each other is a first node N1 of a pixel drive circuit.

In an exemplary implementation mode, a pattern of a semiconductor of an E1 region, an E2 region, an E3 region, and an E4 region in FIG. 11 is substantially the same as a pattern of a semiconductor of an E0 region, and no pattern of a semiconductor is disposed in a lead region in a bonding region.

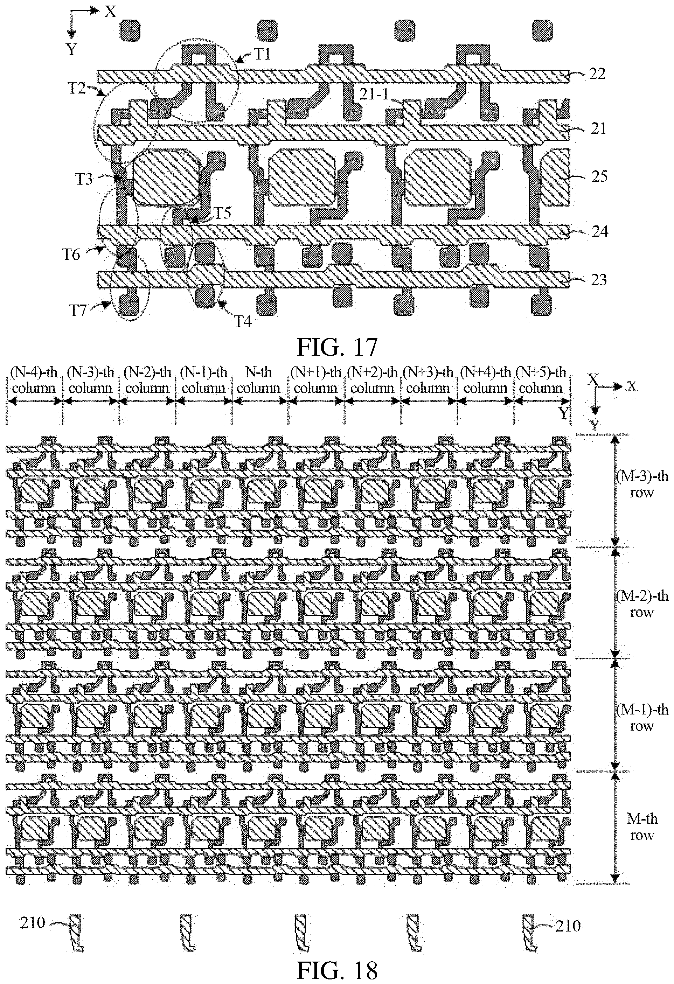

(2) A pattern of a first conductive layer is formed. In an exemplary implementation mode, the pattern of the first conductive layer is formed, which may include: a second insulation thin film and a first conductive thin film are sequentially deposited on the base substrate on which the aforementioned pattern is formed, and the first conductive thin film is patterned through a patterning process to form a second insulation layer that covers the pattern of the semiconductor layer and the pattern of the first conductive layer disposed on the second insulation layer, as shown in FIG. 17 and FIG. 18, wherein FIG. 17 is an enlarged view of the E0 region in FIG. 11, and FIG. 18 is an enlarged view of the F region in FIG. 11. In an exemplary implementation mode, the first conductive layer may be referred to as a first gate metal (GATE1) layer.

In an exemplary implementation mode, the pattern of the first conductive layer of each circuit unit in the display region at least includes: a first scan signal line 21, a second scan signal line 22, a third scan signal line 23, a light emitting control line 24, and a first electrode plate 25 of a storage capacitor.

In an exemplary implementation mode, a shape of the first electrode plate 25 of the storage capacitor may be a rectangular shape, wherein corners of the rectangular shape may be provided with chamfers. There is an overlapping region between an orthographic projection of the first electrode plate 25 on the base substrate and an orthographic projection of the third active layer of the third transistor T3 on the base substrate. In an exemplary implementation mode, the first electrode plate 25 may serve as one plate of the storage capacitor and a gate electrode of the third transistor T3 simultaneously.

In an exemplary implementation mode, shapes of the first scan signal line 21, the second scan signal line 22, the third scan signal line 23, and the light emitting control line 24 may be line shapes of which a main body portion extends along a first direction X. The first scan signal line 21 and the second scan signal line 22 may be located on one side of the first electrode plate 25 of the present circuit unit in the opposite direction of the second direction Y, the second scan signal line 22 may be located on one side of the first scan signal line 21 of the present circuit unit away from the first electrode plate 25, the third scan signal line 23 and the light emitting control line 24 may be located on one side of the first electrode plate 25 of the present circuit unit in the second direction Y, and the third scan signal line 23 may be located on one side of the light emitting control line 24 of the present circuit unit away from the first electrode plate 25.

In an exemplary implementation mode, the first scan signal line 21 may be provided with a gate block 21-1 protruding toward one side of the second scan signal line 22, and a region in which the first scan signal line 21 and the gate block 21-1 are overlapped with the second active layer may serve as a gate electrode of the second transistor T2, forming the second transistor T2 with a double-gate structure.

In an exemplary implementation mode, a region in which the second scan signal line 22 is overlapped with the first active layer may serve as a gate electrode of the first transistor T1 with a double-gate structure. A region in which the third scan signal line 23 is overlapped with the fourth active layer may serve as a gate electrode of the fourth transistor T4, and a region in which the third scan signal line 23 is overlapped with the seventh active layer may serve as a gate electrode of the seventh transistor T7. A region in which the light emitting control line 24 is overlapped with the fifth active layer may serve as a gate electrode of the fifth transistor T5, and a region in which the light emitting control line 24 is overlapped with the sixth active layer may serve as a gate electrode of the sixth transistor T6.

In an exemplary implementation mode, since the first scan signal line 21 is located on one side of a third transistor T3 of a present circuit unit in the opposite direction of the second direction Y, and the third scan signal line 23 is located on one side of the third transistor T3 of the present circuit unit in the second direction Y, the second transistor T2 and the fourth transistor T4 are respectively located on two sides of the third transistor T3 in the second direction Y.

In an exemplary implementation mode, the first scan signal line 21 and the third scan signal line 23 may be connected with a same signal source, that is, output signals of the first scan signal line 21 and the third scan signal line 23 are the same.

In an exemplary implementation mode, the pattern of the first conductive layer of the E1 region, the E2 region, the E3 region, and the E4 region in FIG. 11 is substantially the same as the pattern of the first conductive layer of the E0 region.

In an exemplary implementation mode, the pattern of the first conductive layer of the lead region in the bonding region may at least include multiple first lead electrodes 210.

In an exemplary implementation mode, a shape of a first lead electrode 210 may be a strip shape extending along the second direction Y, and the first lead electrode 210 is configured to be connected with a data signal line of an odd-numbered unit column subsequently formed.

The lead region shown in FIG. 18 is the pattern of the first conductive layer of a third region in the display region, so there is only a first lead electrode connected with the data signal line of the odd-numbered unit column. For a second region in the display region, since a second connection line is subsequently formed, the pattern of the first conductive layer of the second region may further include a fifth lead electrode configured to be connected with the second connection line to be formed subsequently through a sixth lead electrode. Thus, not only multiple first lead electrodes but also multiple fifth lead electrodes are included in the second region, and a quantity of lead electrodes in the second region is different from a quantity of lead electrodes in the third region.

In an exemplary implementation mode, structures of the fifth lead electrode and the first lead electrode may be substantially the same.

In an exemplary implementation mode, the pattern of the first conductive layer of the bonding region may further include multiple first leading out lines (not shown), wherein a shape of a first leading out line may be a straight line shape or a broken line shape, first ends of the multiple first leading out lines are connected with the first lead electrodes 210 and the fifth lead electrodes, and second ends of the multiple first leading out lines extend to a bending region of the bonding region along a direction away from the display region.

In an exemplary implementation mode, after the pattern of the first conductive layer is formed, a conductive processing may be performed on the semiconductor layer by using the first conductive layer as a shield, the semiconductor layer in a region shielded by the first conductive layer forms channel regions of the first transistor T1 to the seventh transistor T7, and the semiconductor layer in a region not shielded by the first conductive layer is made to be conductive, that is, first regions and second regions of the first active layer to the seventh active layer are all made to be conductive.

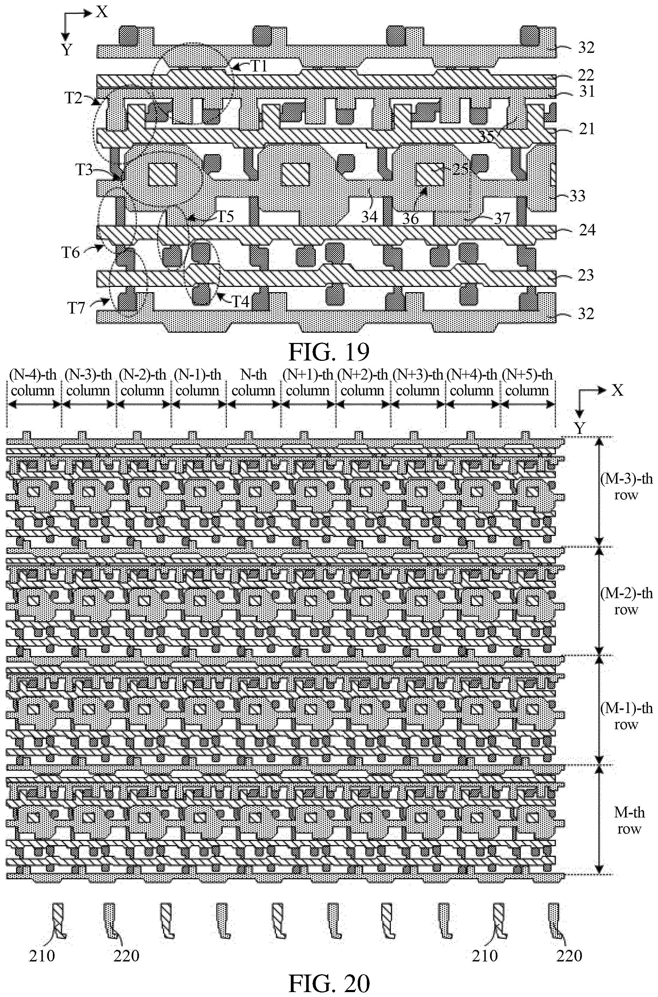

(3) A pattern of a second conductive layer is formed. In an exemplary implementation mode, the pattern of the second conductive layer is formed, which may include: a third insulation thin film and a second conductive thin film are sequentially deposited on the base substrate on which the aforementioned patterns are formed, and the second conductive thin film is patterned through a patterning process to form a third insulation layer covering the first conductive layer and the pattern of the second conductive layer disposed on the third insulation layer, wherein the pattern of the second conductive layer at least includes: as shown in FIGs. 19 and 20, wherein FIG. 19 is an enlarged view of the E0 region in FIG. 11, and FIG. 20 is an enlarged view of the F region in FIG. 11. In an exemplary implementation mode, the second conductive layer may be referred to as a second gate metal (GATE2) layer.

In an exemplary implementation mode, the pattern of the second conductive layer of each circuit unit in the display region at least includes: a first initial signal line 31, a second initial signal line 32, a second electrode plate 33 of the storage capacitor, an electrode plate connection line 34, and a shielding electrode 35.

In an exemplary implementation mode, shapes of the first initial signal line 31 and the second initial signal line 32 may be line shapes of which main body portions may extend along the first direction X. The first initial signal line 31 may be located between the first scan signal line 21 and the second scan signal line 22 of the present circuit unit, and the second initial signal line 32 may be located on one side of the third scan signal line 23 of the present circuit unit away from the light emitting control line 24.

In an exemplary implementation mode, a contour shape of the second electrode plate 33 may be a rectangular shape, corners of the rectangular shape may be provided with chamfers, there is an overlapping region between an orthographic projection of the second electrode plate 33 on the base substrate and an orthographic projection of the first electrode plate 25 on the base substrate, the second electrode plate 33 serves as another plate of the storage capacitor and is located between the first scan signal line 21 of the present circuit unit and the light emitting control line 24, and the first electrode plate 25 and the second electrode plate 33 constitute the storage capacitor of the pixel drive circuit.

In an exemplary implementation mode, the electrode plate connection line 34 may be disposed on one side of the second electrode plate 33 in the first direction X or an opposite direction of the first direction X, a first end of the electrode plate connection line 34 is connected with the second electrode plate 33 of the present circuit unit, and a second end of the electrode plate connection line 34 is connected with a second electrode plate 33 of an adjacent circuit unit after extending along the first direction X or the opposite direction of the first direction X, so that second electrode plates 33 of adjacent circuit units on a unit row are connected with each other. In an exemplary implementation mode, second electrode plates of multiple circuit units in a unit row may be connected with each other to form an integral structure through an electrode plate connection line. The second electrode plates in the integral structure may be multiplexed as power supply signal connection lines, thus ensuring that multiple second electrode plates in a unit row have a same potential and being beneficial to improve uniformity of a panel, avoiding poor display of the display substrate, and ensuring a display effect of the display substrate.

In an exemplary implementation mode, an opening 36 is disposed on the second electrode plate 33 and may be located in a middle part of the second electrode plate 33, and the opening 36 may be in a shape of a rectangle, so that the second electrode plate 33 forms an annular structure. The opening 36 exposes the third insulation layer covering the first electrode plate 25, and an orthographic projection of the first electrode plate 25 on the base substrate contains an orthographic projection of the opening 36 on the base substrate. In an exemplary implementation mode, the opening 36 is configured to accommodate a first via subsequently formed, wherein the first via is located within the opening 36 and exposes the first electrode plate 25, so that a second electrode of the first transistor T1 subsequently formed is connected with the first electrode plate 25.

In an exemplary implementation mode, the second electrode plate 33 is also provided with a protrusion 37, which may be disposed at a corner of the second electrode plate 33 close to the fourth active layer and connected with the second electrode plate 33, and an orthographic projection of the protrusion 37 on the base substrate is at least partially overlapped with orthographic projections of the first region of the third active layer, the second region of the fourth active layer, and the second region of the fifth active layer on the base substrate. Since the second electrode plate 33 is connected with the first power supply line to be formed subsequently, the protrusion 37 is configured to shield the connection point of the first region of the third active layer, the second region of the fourth active layer, and the second region of the fifth active layer (i.e., the first node N1 of the pixel drive circuit), avoiding an external influence on a potential of the first node N1, and improving a display effect.

In an exemplary implementation mode, the protrusion 37 may include a first protrusion connected with an edge on one side of the second electrode plate 33 in the first direction X and a second protrusion connected with an edge on one side of the second electrode plate 33 in the second direction Y, and ends of the first protrusion and the second protrusion close to each other are connected with each other.

In an exemplary implementation mode, the shielding electrode 35 may be located on one side of the first initial signal line 31 close to the first scan signal line 21, and is connected with the first initial signal line 31, an orthographic projection of the shielding electrode 35 on the base substrate is at least partially overlapped with an orthographic projection of the second active layer between two gate electrodes of the second transistors T2 on the base substrate. The shielding electrode 35 is configured to shield an influence of data voltage jump on a key node, avoiding the data voltage jump from influencing a potential of a key node of the pixel drive circuit, and improve a display effect.

In an exemplary implementation mode, the pattern of the second conductive layer of the E1 region, the E2 region, the E3 region, and the E4 region in FIG. 11 is substantially the same as the pattern of the second conductive layer of the E0 region.

In an exemplary implementation mode, the pattern of the second conductive layer of the lead region in the bonding region may at least include multiple second lead electrodes 220.

In an exemplary implementation mode, a shape of a second lead electrode 220 may be a strip shape extending along the second direction Y, and the second lead electrode 220 is configured to be connected with a data signal line of an even-numbered unit column subsequently formed.

The lead region shown in FIG. 20 is the pattern of the second conductive layer of the third region in the display region, so there is only the second lead electrode connected with the data signal line of the even-numbered unit column. For the second region in the display region, since the second connection line is subsequently formed, the pattern of the second conductive layer of the second region may also include a fifth lead electrode configured to be connected with the second connection line to be formed subsequently through the sixth lead electrode. Thus, not only multiple second lead electrodes but also multiple fifth lead electrodes are included in the second region, and a quantity of lead electrodes in the second region is different from a quantity of lead electrodes in the third region.

In an exemplary implementation mode, the fifth lead electrode connected with the second connection line to be formed subsequently may be disposed in the first conductive layer, or may be disposed in the second conductive layer, or may be respectively disposed in the first conductive layer and the second conductive layer according to the odd-numbered unit column and the even-numbered unit column, which is not limited here in the present disclosure.

In an exemplary implementation mode, structures of the fifth lead electrode and the second lead electrode may be substantially the same.

In an exemplary implementation mode, the pattern of the second conductive layer of the bonding region may further include multiple second leading out lines (not shown), wherein a shape of a second leading out line may be a straight line shape or a broken line shape, first ends of the multiple second leading out lines are connected with the second lead electrodes 220 and the fifth lead electrodes, and second ends of the multiple second leading out lines extend to the bending region of the bonding region along a direction away from the display region.

In an exemplary implementation mode, a second lead electrode 220 may be disposed between first lead electrodes 210 adjacent in the first direction X, a first lead electrode 210 may be disposed between second lead electrodes 220 adjacent in the first direction X, and ends of the multiple first lead electrodes 210 close to the display region and ends of the multiple second lead electrodes 220 close to the display region may be flush.

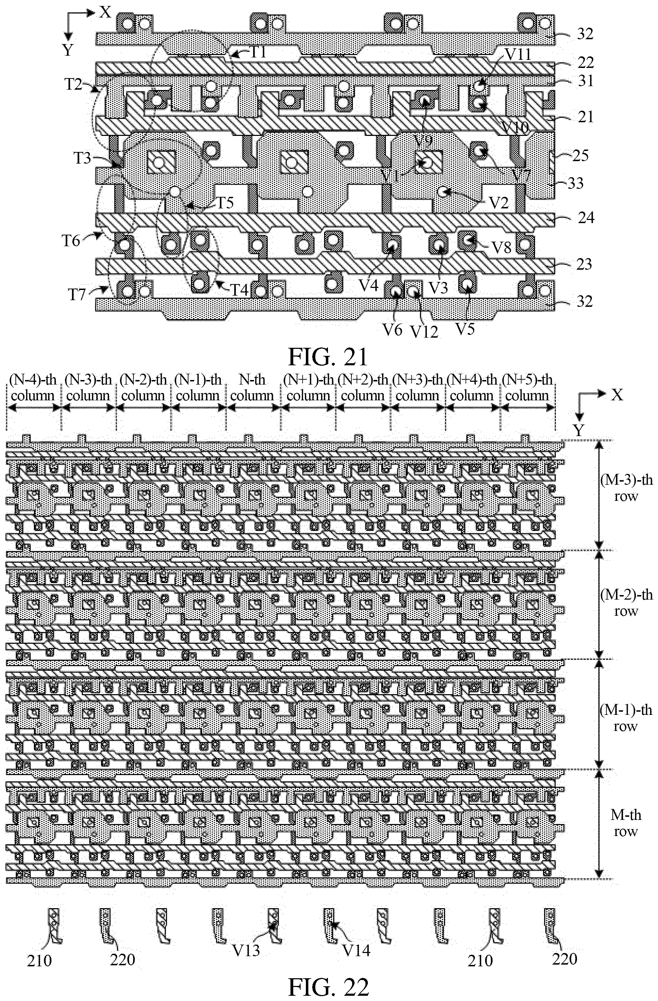

(4) A pattern of a fourth insulation layer is formed. In an exemplary implementation mode, the pattern of the fourth insulation layer is formed, which may include: a fourth insulation thin film is deposited on the base substrate on which the aforementioned patterns are formed, the fourth insulation thin film is patterned through a patterning process to form the fourth insulation layer covering the second conductive layer, and multiple vias are disposed in each circuit unit, as shown in FIGs. 21 and 22, wherein FIG. 21 is an enlarged view of the E0 region in FIG. 11, and FIG. 22 is an enlarged view of the F region in FIG. 11.

In an exemplary implementation mode, multiple vias of each circuit unit in the display region at least include: a first via V1, a second via V2, a third via V3, a fourth via V4, a fifth via V5, a sixth via V6, a seventh via V7, an eighth via V8, a ninth via V9, a tenth via V10, an eleventh via V11, and a twelfth via V12.

In an exemplary implementation mode, an orthographic projection of the first via V1 on the base substrate is located within a range of an orthographic projection of the opening 36 of the second electrode plate 33 on the base substrate, the fourth insulation layer and the third insulation layer within the first via V1 are etched away to expose a surface of the first electrode plate 25, and the first via V1 is configured such that the second electrode of the first transistor T1 subsequently formed is connected with the first electrode plate 25 through the via.

In an exemplary implementation mode, an orthographic projection of the second via V2 on the base substrate is located within a range of an orthographic projection of the second electrode plate 33 on the base substrate, the fourth insulation layer within the second via V2 is etched away to expose a surface of the second electrode plate 33, and the second via V2 is configured such that a first electrode of the fifth transistor T5 subsequently formed is connected with the second electrode plate 33 through the via.

In an exemplary implementation mode, an orthographic projection of the third via V3 on the base substrate is located within a range of an orthographic projection of a first region of the fifth active layer on the base substrate, the fourth insulation layer, the third insulation layer, and the second insulation layer within the third via V3 are etched away to expose a surface of the first region of the fifth active layer, and the third via V3 is configured such that the first electrode of the fifth transistor T5 subsequently formed is connected with the first region of the fifth active layer through the via.

In an exemplary implementation mode, an orthographic projection of the fourth via V4 on the base substrate is located within a range of an orthographic projection of a second region of the sixth active layer (which is also a second region of the seventh active layer) on the base substrate, the fourth insulation layer, the third insulation layer, and the second insulation layer within the fourth via V4 are etched away to expose a surface of the second region of the sixth active layer, and the fourth via V4 is configured such that a second electrode of the sixth transistor T6 (which is also a second electrode of the seventh transistor T7) formed subsequently is connected with the sixth active layer through the via.

In an exemplary implementation mode, an orthographic projection of the fifth via V5 on the base substrate is located within a range of an orthographic projection of a first region of the fourth active layer on the base substrate, the fourth insulation layer, the third insulation layer, and the second insulation layer within the fifth via V5 are etched away to expose a surface of a first region of the fourth active layer, and the fifth via V5 is configured such that a first electrode of the fourth transistor T4 subsequently formed is connected with the first region of the fourth active layer through the via.

In an exemplary implementation mode, an orthographic projection of the sixth via V6 on the base substrate is located within a range of an orthographic projection of a first region of the seventh active layer on the base substrate, the fourth insulation layer, the third insulation layer, and the second insulation layer within the sixth via V6 are etched away to expose a surface of the first region of the seventh active layer, and the sixth via V6 is configured such that a first electrode of the seventh transistor T7 subsequently formed is connected with the first region of the seventh active layer through the via.

In an exemplary implementation mode, an orthographic projection of the seventh via V7 on the base substrate is located within a range of an orthographic projection of a first region of the third active layer on the base substrate, the fourth insulation layer, the third insulation layer, and the second insulation layer within the seventh via V7 are etched away to expose a surface of the first region of the third active layer, and the seventh via V7 is configured such that a first electrode of the third transistor T3 subsequently formed is connected with the first region of the third active layer through the via.

In an exemplary implementation mode, an orthographic projection of the eighth via V8 on the base substrate is located within a range of an orthographic projection of a second region of the fourth active layer on the base substrate, the fourth insulation layer, the third insulation layer, and the second insulation layer within the eighth via V8 are etched away to expose a surface of the second region of the fourth active layer, and the eighth via V8 is configured such that the first electrode of the third transistor T7 subsequently formed is connected with the second region of the fourth active layer through the via.

In an exemplary implementation mode, an orthographic projection of the ninth via V9 on the base substrate is located within a range of an orthographic projection of a second region of the first active layer (which is also a first region of the second active layer) on the base substrate, the fourth insulation layer, the third insulation layer, and the second insulation layer within the ninth via V9 are etched away to expose a surface of the second region of the first active layer, and the ninth via V9 is configured such that a second electrode of the first transistor T1 (which is also a first electrode of the second transistor T2) subsequently formed is connected with the first active layer through the via.

In an exemplary implementation mode, an orthographic projection of the tenth via V10 on the base substrate is located within a range of an orthographic projection of a first region of the first active layer on the base substrate, the fourth insulation layer, the third insulation layer, and the second insulation layer within the tenth via V10 are etched away to expose a surface of the first region of the first active layer, and the tenth via V10 is configured such that a first electrode of the first transistor T1 subsequently formed is connected with the first region of the first active layer through the via.

In an exemplary implementation mode, an orthographic projection of the eleventh via V11 on the base substrate is located within a range of an orthographic projection of the first initial signal line 31 on the base substrate, the fourth insulation layer within the eleventh via V11 is etched away to expose a surface of the first initial signal line 31, and the eleventh via V11 is configured such that the first electrode of the first transistor T1 subsequently formed is connected with the first initial signal line 31 through the via. In the present disclosure, by providing the tenth via V10 and the eleventh via V11, the connection of the first initial signal line 31 with the first region of the first active layer may be achieved by using the first electrode of the first transistor T1 to be formed subsequently. Compared with a scheme in which the first initial signal line of the second conductive layer is directly connected with the first region of the first active layer through a via, the present disclosure may reduce the patterning process for one time, reduce preparation time, and reduce a production cost.

In an exemplary implementation mode, an orthographic projection of the twelfth via V12 on the base substrate is located within a range of an orthographic projection of the second initial signal line 32 on the base substrate, the fourth insulation layer within the twelfth via V12 is etched away to expose a surface of the second initial signal line 32, and the twelfth via V12 is configured such that the first electrode of the seventh transistor T7 subsequently formed is connected with the second initial signal line 32 through the via.

In the present disclosure, by providing the sixth via V6 and the twelfth via V12, the connection of the second initial signal line 32 with the first region of the seventh active layer may be achieved by using the first electrode of the seventh transistor T7 to be formed subsequently. Compared with a scheme in which the second initial signal line of the second conductive layer is directly connected with the first region of the seventh active layer through a via, the present disclosure may reduce the patterning process for one time, reduce preparation time, and reduce a production cost.

In an exemplary implementation mode, patterns of multiple via of the E1 region, the E2 region, the E3 region, and the E4 region in FIG. 11 are substantially the same as patterns of multiple via of the E0 region.

In an exemplary implementation mode, multiple vias of the lead region in the bonding region at least include: a thirteenth via V13 and a fourteenth via V14.

In an exemplary implementation mode, an orthographic projection of the thirteenth via V13 on the base substrate is located within a range of an orthographic projection of the first lead electrode 210 on the base substrate, the fourth insulation layer and the third insulation layer within the thirteenth via V13 are etched away to expose a surface of the first lead electrode 210, and the thirteenth via V13 is configured such that a third lead electrode formed subsequently is connected with the first lead electrode 210 through the via.

In an exemplary implementation mode, an orthographic projection of the fourteenth via V14 on the base substrate is located within a range of an orthographic projection of the second lead electrode 220 on the base substrate, the fourth insulation layer within the fourteenth via V13 is etched away to expose a surface of the second lead electrode 220, and the fourteenth via V14 is configured such that a fourth lead electrode formed subsequently is connected with the second lead electrode 220 through the via.

The lead region shown in FIG. 22 is the pattern of vias on the fourth insulation layer of the third region in the display region, since a fifth lead electrode is also disposed in the second region of the display region, the multiple vias of the lead region in the bonding region may further include a fifteenth via, wherein the fifteenth via exposes a surface of the fifth lead electrode, and the fifteenth via is configured such that a sixth lead electrode to be formed subsequently is connected with the fifth lead electrode through the via.

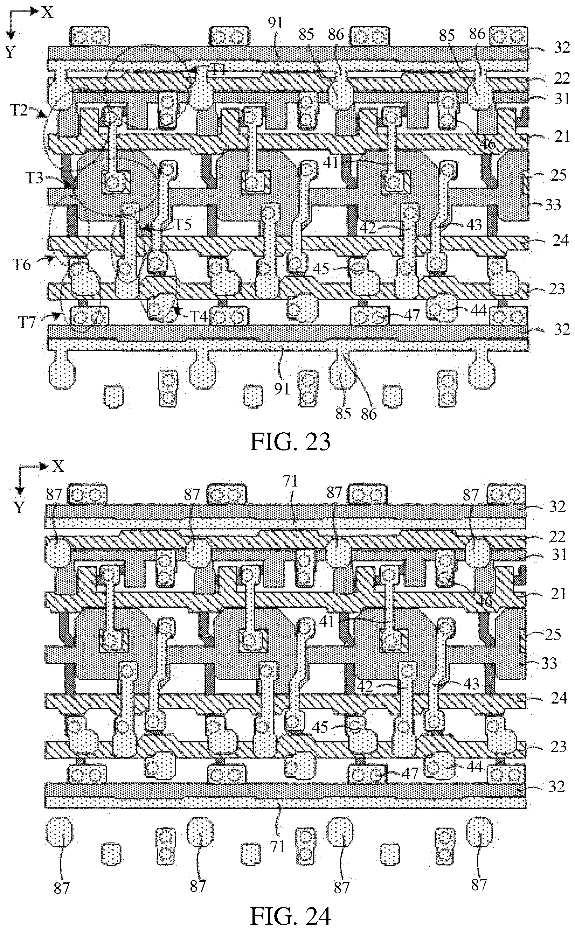

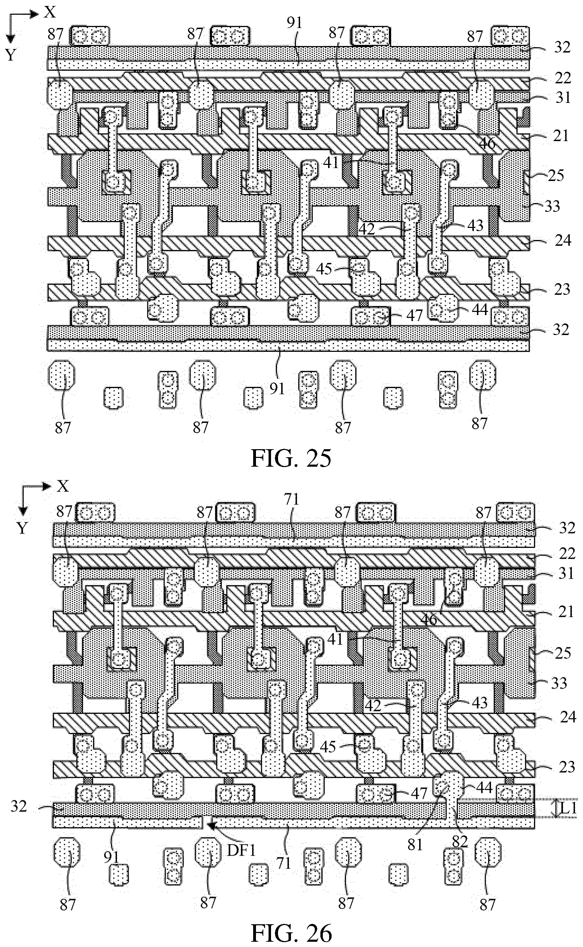

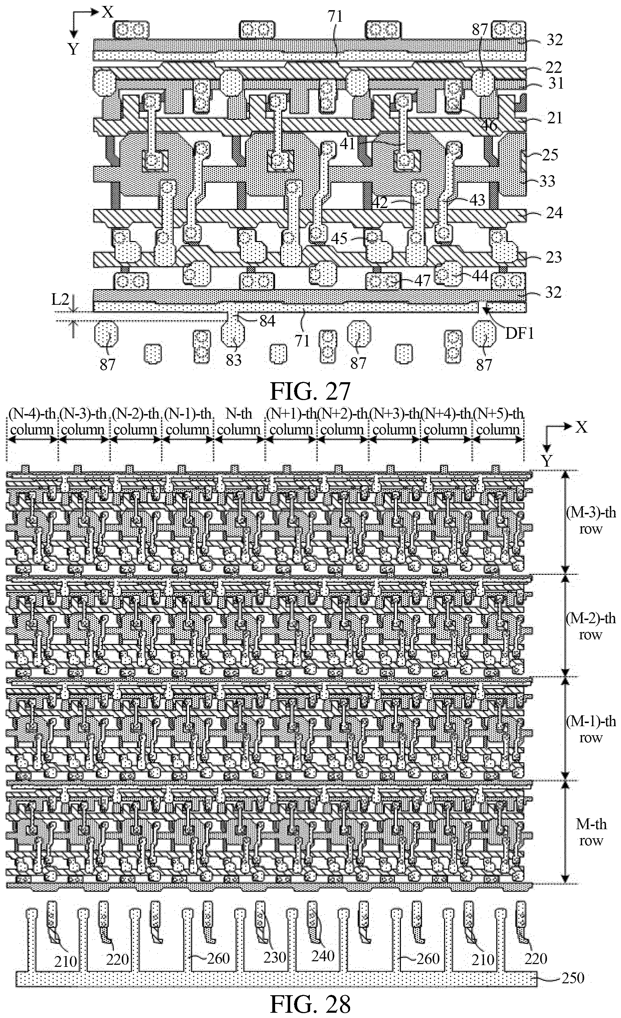

(5) A pattern of a third conductive layer is formed. In an exemplary implementation mode, the third conductive layer is formed, which may include: a third conductive thin film is deposited on the base substrate on which the aforementioned patterns are formed, and the third conductive thin film is patterned through a patterning process to form the third conductive layer disposed on the fourth insulation layer, as shown in FIGs. 23 to 28, wherein FIG. 23 is an enlarged view of the E0 region in FIG. 11, FIG. 24 is an enlarged view of the E1 region in FIG. 11, FIG. 25 is an enlarged view of the E2 region in FIG. 11, FIG. 26 is an enlarged view of the E3 region in FIG. 11, FIG. 27 is an enlarged view of the E4 region in FIG. 11, and FIG. 28 is an enlarged view of the F region in FIG. 11. In an exemplary implementation mode, the third conductive layer may be referred to as a first source drain metal (SD1) layer.

In an exemplary implementation mode, the pattern of the third conductive layer of multiple circuit units in the display region each include: a first connection electrode 41, a second connection electrode 42, a third connection electrode, a fourth connection electrode 44, a fifth connection electrode 45, a sixth connection electrode 46, and a seventh connection electrode 47.

In an exemplary implementation mode, a shape of the first connection electrode 41 may be a strip shape of which a main body portion extends along the second direction Y, a first end of the first connection electrode 41 is connected with the first electrode plate 25 through the first via V1, and a second end of the first connection electrode 41 is connected with the second region of the first active layer (which is also the first region of the second active layer) through the ninth via V9. In an exemplary implementation mode, the first connection electrode 41 may serve as the second electrode of the first transistor T1 and the first electrode of the second transistor T2 (i.e., a second node N2 of the pixel drive circuit), so that the first electrode plate 25, the second electrode of the first transistor T1, the first electrode of the second transistor T2 have a same potential.

In an exemplary implementation mode, a shape of the second connection electrode 42 may be a strip shape of which a main body portion extends along the second direction Y, a first end of the second connection electrode 41 is connected with the second electrode plate 33 through the second via V2, and a second end of the second connection electrode 41 is connected with the first region of the fifth active layer through the third via V3. In an exemplary implementation mode, the second connection electrode 42 may serve as a first electrode of the fifth transistor T5 so that the second electrode plate 33 and the first electrode of the fifth transistor T5 have a same potential, and the second connection electrode 42 is configured to be connected with a first power supply line to be formed subsequently. The second connection electrode 42 may server as a connection electrode achieving the connection between the second electrode plate 33 and the first power supply line to be formed subsequently, the first power supply line being connected with the second electrode plate 33 through the second connection electrode 42.

In an exemplary implementation mode, since the second via V2 and the third via V3 are respectively located on two sides of the light emitting control line 24 in the second direction Y, the second connection electrode 42 crosses the light emitting control line 24, and an orthographic projection of the second connection electrode 42 on the base substrate is at least partially overlapped with an orthographic projection of the light emitting control line 24 on the base substrate, forming a shield for the fifth transistor T5.

In an exemplary implementation mode, a shape of the third connection electrode 43 may be a strip shape of which a main body portion extends along the second direction Y, a first end of the third connection electrode 43 is connected with the first region of the third active layer through the seventh via V7, and a second end of the third connection electrode 43 is connected with the second region of the fourth active layer through the eighth via V8. In an exemplary implementation mode, the third connection electrode 43 may serve as the first electrode of the third transistor T3 (which is also the second electrode of the fourth transistor T4), so that the first electrode of the third transistor T3, the second electrode of the fourth transistor T4, and the second electrode of the fifth transistor T5 have a same potential (a first node N1).

In an exemplary implementation mode, a shape of the fourth connection electrode 44 may be a rectangular shape, and the fourth connection electrode 44 is connected with the first region of the fourth active layer through the fifth via V5. The fourth connection electrode 44 may serve as the first electrode of the fourth transistor T4, and the fourth connection electrode 44 is configured to be connected with a data signal line subsequently formed.

In an exemplary implementation mode, a shape of the fifth connection electrode 45 may be a rectangular shape, and the fifth connection electrode 45 is connected with the second region of the sixth active layer (which is also the second region of the seventh active layer) through the fourth via V4. The fifth connection electrode 45 may serve as the second electrode of the sixth transistor T6 (which is also the second electrode of the seventh transistor T7), and the fifth connection electrode 45 is configured to be connected with an anode connection electrode subsequently formed.

In an exemplary implementation mode, a shape of the sixth connection electrode 46 may be a rectangular shape, a first end of the sixth connection electrode 46 is connected with the first region of the first active layer through the tenth via V10, and a second end of the sixth connection electrode 46 is connected with the first initial signal line 31 through the eleventh via V11. The sixth connection electrode 46 may serve as the first electrode of the first transistor T1, thereby achieving that the first initial signal line 31 writes a first initial signal into the first electrode of the first transistor T1.

In an exemplary implementation mode, a shape of the seventh connection electrode 47 may be a rectangular shape, a first end of the seventh connection electrode 47 is connected with the first region of the seventh active layer through the sixth via V6, and a second end of the seventh connection electrode 47 is connected with the second initial signal line 32 through the twelfth via V12. The seventh connection electrode 47 may serve as the first electrode of the seventh transistor T7, thereby achieving that the second initial signal line 32 writes a second initial signal into the first electrode of the seventh transistor T7.

As shown in FIG. 23, in an exemplary implementation mode, the pattern of the third conductive layer of the plurality of circuit units in the third region (E0 region) may further include a first power supply trace 91, a power supply connection electrode 85, and a power supply connection block 86.

In an exemplary implementation mode, a shape of the first power supply trace 91 may be a line shape of which a main body portion extends along the first direction X, and the first power supply trace 9 may be disposed on one side of the second scan signal line 22 away from the first scan signal line 21. In an exemplary implementation mode, the first power supply trace 91 may be connected with a bezel power supply lead of a bezel region, wherein the bezel power supply lead is configured to continuously provide a high voltage signal (VDD) or a low voltage signal (VSS).

In an exemplary implementation mode, a shape of the power supply connection electrode 85 may be a rectangular shape, the power supply connection electrode 85 may be disposed on one side of the first power supply trace 91 close to the first scan signal line 21, an orthographic projection of the power supply connection electrode 85 on the base substrate is at least partially overlapped with an orthographic projection of the second scan signal line 22 on the base substrate, and the orthographic projection of the power supply connection electrode 85 on the base substrate is at least partially overlapped with the orthographic projection of the first initial signal line 31 on the base substrate. In an exemplary implementation mode, the power supply connection electrode 85 is configured to be connected with a second power supply trace subsequently formed.

In an exemplary implementation mode, the power supply connection block 86 is disposed between the first power supply trace 91 and the power supply connection electrode 85, a first end of the power supply connection block 86 is connected with the first power supply trace 91, and a second end of the power supply connection block 86 is connected with the power supply connection electrode 85, thereby achieving a connection between the first power supply trace 91 and the power supply connection electrode 85.

In an exemplary implementation mode, the first power supply trace 91, the power supply connection electrode 85, and the power supply connection block 86 of one circuit row in the third region may be connected with each other to be of an integral structure.

As shown in FIG. 24, in an exemplary implementation mode, the pattern of the third conductive layer of the plurality of circuit units in the first region (E1 region) may further include a first connection line 71 and a dummy electrode 87.

In an exemplary implementation mode, a shape of the first connection line 71 of data connection lines may be a line shape of which a main body portion extends along the first direction X, and the first connection line 71 may be disposed on one side of the second scan signal line 22 away from the first scan signal line 21. In an exemplary implementation mode, the first connection line 71 is configured to be connected with a second connection line of the data connection lines subsequently formed.

In an exemplary implementation mode, a position and a shape of the dummy electrode 87 of the multiple circuit units in the first region may be substantially the same as a position and a shape of the power supply connection electrode 85 in the third region, except that the dummy electrode 87 is disposed in isolation and is not connected with the first connection line 71 or connected with another electrode. In an exemplary implementation mode, morphology and a connection structure exhibited by the dummy electrode 87 are substantially identical to a data connection electrode, a fan-out connection electrode, and a power supply connection electrode. Since a signal line subsequently formed is connected with the dummy electrode through a via, a first planarization layer subsequently formed is provided with a via in each circuit unit, which may not only improve uniformity of a preparation process, but also make different regions have substantially a same transfer connection structure, and that different regions may each achieve substantially a same display effect under transmitted light and reflected light, thereby effectively eliminating a shadow elimination situation, effectively avoiding poor appearance of the display substrate, and improving display character and display quality.

As shown in FIG. 25, in an exemplary implementation mode, the pattern of the third conductive layer of plurality of circuit units in the second region (E2 region) further includes a first power supply trace 91 and a dummy electrode 87.

In an exemplary implementation mode, a position and a shape of the first power supply trace 91 of the multiple circuit units in the second region may be substantially the same as a position and a shape of the first power supply trace 91 in the third region, and a position, a shape, and a function of the dummy electrode 87 of the multiple circuit units in the second region may be substantially the same as a position, a shape, and a function of the power supply connection electrode 85 in the first region.

As shown in FIG. 15d, in an exemplary implementation mode, the pattern of the third conductive layer of at least one circuit unit of a junction region (E3 region) of the first region and the third region may further include a first connection line 71, a data connection electrode 81, and a data connection block 82.

In an exemplary implementation mode, the junction region of both the first region and the third region may include at least one circuit unit of the first region, at least one circuit unit of the third region, and a first connection unit, wherein the first connection unit may be a circuit unit in which a data signal line and a first connection line are connected through a first connection hole.

In an exemplary implementation mode, the first connection unit may include a first connection line 71, a data connection electrode 81, and a data connection block 82. The circuit unit of the first region may include a first connection line 71 and a dummy electrode 87, located on a right side of the first connection unit. The circuit unit of the third region may include a first power supply trace 91 and a dummy electrode 87, located on a left side of the first connection unit.

In an exemplary implementation mode, a shape of the data connection electrode 81 may be a rectangular shape, and the data connection electrode 81 may be disposed on one side of the first connection line 71 away from the dummy electrode 87. There is a first distance L1 between the first connection line 71 and the data connection electrode 81, and the first distance L1 may be greater than 0. In an exemplary implementation mode, the first distance L1 may be a distance between an edge of one side of the first connection line 71 close to the data connection electrode 81 and an edge of one side of the data connection electrode 81 close to the first connection line 71, and the first distance L1 is a dimension in the second direction Y. A shape of the data connection block 82 may be a rectangular shape, and the data connection block 82 may be disposed between the first connection line 71 and the data connection electrode 81, wherein a first end of the data connection block 82 is connected with the first connection line 71, and a second end of the data connection block 82 is connected with the data connection block 82, thereby achieving a connection between the first connection line 71 and the data connection electrode 81. In an exemplary implementation mode, the data connection electrode 81 is configured to be connected with a data signal line subsequently formed.

In an exemplary implementation mode, the data connection electrode 81 may be connected with the fourth connection electrode 44 in the pixel drive circuit.

In an exemplary implementation mode, the fourth connection electrode 44 in the pixel drive circuit may serve as the data connection electrode 81, that is, the data connection electrode 81 and the fourth connection electrode 44 (the first electrode of the fourth transistor) are of a common structure. In the present disclosure, the first electrode of the fourth transistor in the pixel drive circuit is used as a data connection electrode connected with a first connection line, not only a quantity of openings on the first planarization layer may be reduced, and a process is simplified, but also it is beneficial to a layout of a territory and improve a resolution.

In an exemplary implementation mode, at least one circuit unit of the third region adjacent to the first connection unit may be provided with at least one first fracture DF1, wherein the first fracture DF1 cuts off a first connection line 71 and a first power supply trace 91 in a same circuit row, the first connection line 71 is on one side of the first fracture DF1 in the first direction X, and the first power supply trace 91 is on one side of the first fracture DF1 in the opposite direction of the first direction X.

As shown in FIG. 27, in an exemplary implementation mode, the pattern of the third conductive layer of at least one circuit unit in a junction region (E4 region) of the first region and the second region may further include a first connection line 71, a fan-out connection electrode 83, and a fan-out connection block 84.

In an exemplary implementation mode, the junction region of both the first region and the second region may include at least one circuit unit of the first region, at least one circuit unit of the second region, and a second connection unit, wherein the second connection unit may be a circuit unit in which the first connection line and a second connection line are connected through a second connection hole.

In an exemplary implementation mode, the second connection unit may include a first connection line 71, a fan-out connection electrode 83, and a fan-out connection block 84. The circuit unit of the first region may include a first connection line 71 and a dummy electrode 87, located on a left side of the first connection unit. The circuit unit of the second region may include a first power supply trace 91 and a dummy electrode 87, located on a right side of the second connection unit.

In an exemplary implementation mode, a shape of the fan-out connection electrode 83 may be a rectangular shape, and the fan-out connection electrode 83 may be disposed on one side of the first connection line 71 close to away from the second initial signal line 32. There is a second distance L2 between the first connection line 71 and the fan-out connection electrode 83, and the second distance L2 may be greater than 0. In an exemplary implementation mode, the second distance L2 may be a distance between an edge of one side of the first connection line 71 close to the fan-out connection electrode 83 and an edge of one side of the fan-out connection electrode 83 close to the first connection line 71, and the second distance L2 is a dimension in the second direction Y. A shape of the fan-out connection block 84 may be a rectangular shape, and the fan-out connection block 84 may be disposed between the first connection line 71 and the fan-out connection electrode 83, a first end of the fan-out connection block 84 is connected with the first connection line 71, and a second end of the fan-out connection block 84 is connected with the fan-out connection electrode 83, thereby achieving a connection between the first connection line 71 and the fan-out connection electrode 83. In an exemplary implementation mode, the fan-out connection electrode 83 is configured to be connected with a second connection line subsequently formed.

In an exemplary implementation mode, at least one circuit unit of the first region adjacent to the second connection unit may be provided with at least one first fracture DF1, wherein the first fracture DF1 cuts off a first connection line 71 and a first power supply trace 91 in a same circuit row, the first connection line 71 is on one side of the first fracture DF1 in an opposite direction of the first direction X, and the first power supply trace 91 is on one side of the first fracture DF1 in the first direction X.

In an exemplary implementation mode, at least two first fractures DF1 may be disposed at both ends of a same first connection line 71, one first fracture DF1 may be located near a junction region of the first region and the third region, and the other first fracture DF1 may be located near a junction region of the first region and the second region.

As shown in FIG. 28, in an exemplary implementation mode, the pattern of the third conductive layer of the lead region in the bonding region at least includes: a plurality of third lead electrodes 230, a plurality of fourth lead electrodes 240, a bonding high voltage line 250, and a plurality of bonding high voltage electrodes 260.

In an exemplary implementation mode, a shape of a third lead electrode 230 may be a strip shape extending along the second direction Y, positions of multiple third lead electrodes 230 may correspond to positions of multiple first lead electrodes 210, an orthographic projection of the third lead electrode 230 on the base substrate is at least partially overlapped with an orthographic projection of a first lead electrode 210 on the base substrate, and the third lead electrode 230 is connected with the first lead electrode 210 through the thirteenth via V13. In an exemplary implementation mode, the multiple third lead electrodes 230 are configured to be correspondingly connected with data signal lines of an odd-numbered unit column subsequently formed.

In an exemplary implementation mode, a shape of a fourth lead electrode 240 may be a strip shape extending along the second direction Y, positions of multiple fourth lead electrodes 240 may correspond to positions of multiple second lead electrodes 220, an orthographic projection of the fourth lead electrode 240 on the base substrate is at least partially overlapped with an orthographic projection of a second lead electrode 220 on the base substrate, and the fourth lead electrode 240 is connected with the second lead electrode 220 through the fourteenth via V14. In an exemplary implementation mode, the multiple fourth lead electrodes 240 are configured to be correspondingly connected with data signal lines of an even-numbered unit column subsequently formed.

In an exemplary implementation mode, a shape of the bonding high voltage line 250 may be a strip shape extending along the first direction X, and the bonding high voltage line 250 is configured to continuously provide a high-level signal to multiple first power supply lines of the display region.

In an exemplary implementation mode, a shape of a bonding high voltage electrode 260 may be a strip shape extending along the second direction Y, multiple bonding high voltage electrodes 260 may be sequentially disposed along the first direction X, first ends of the multiple bonding high voltage electrodes 260 are connected with the bonding high voltage line 250, and second ends of the multiple bonding high voltage electrodes 260 extend toward a direction of the display region. In an exemplary implementation mode, the multiple bonding high voltage electrodes 260 are configured to be correspondingly connected with multiple first power supply lines subsequently formed.

The lead region shown in FIG. 28 is the pattern of the third conductive layer of the third region in the display region. For the second region in the display region, since the second region is provided with the fifth lead electrode, the pattern of the third conductive layer of the second region may further include a sixth lead electrode, wherein the sixth lead electrode is connected with the fifth lead electrode through the fifteenth via, and the sixth lead electrode is configured to be connected with a second connection line to be formed subsequently. Thus, not only multiple third lead electrodes and multiple fourth lead electrodes, but also multiple sixth lead electrodes are included in the second region, and a quantity of lead electrodes in the second region is different from a quantity of lead electrodes in the third region.

In an exemplary implementation mode, structures of the sixth lead electrode and a third lead electrode (a fourth lead electrode) may be substantially the same.

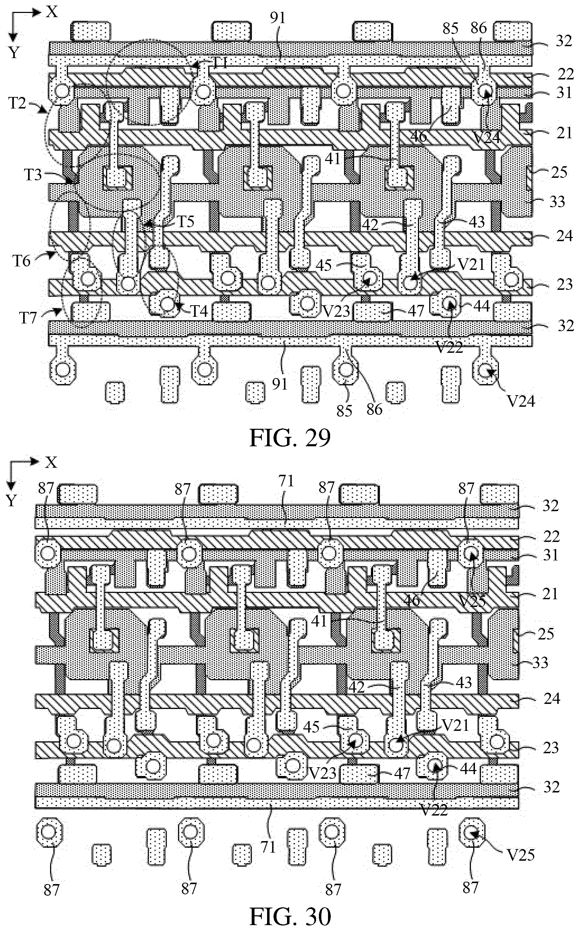

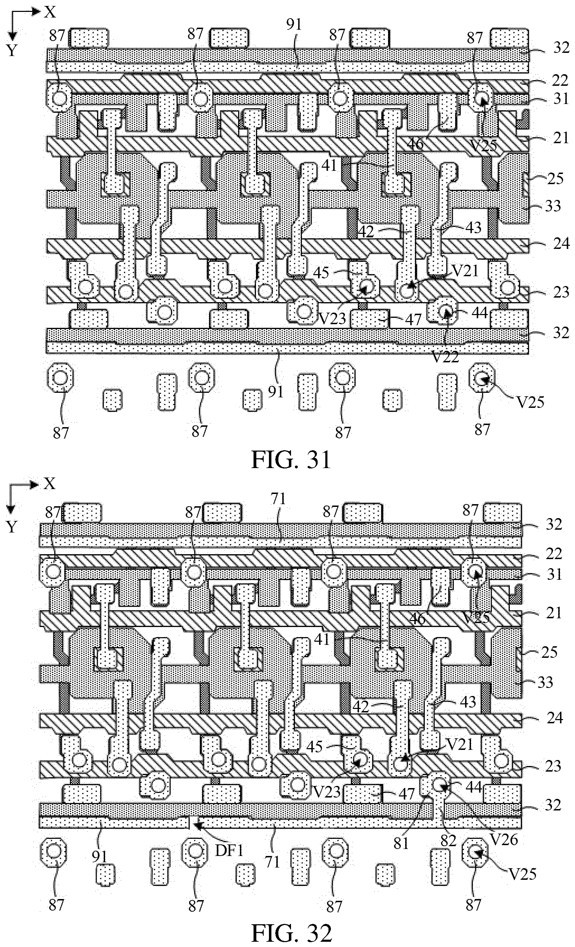

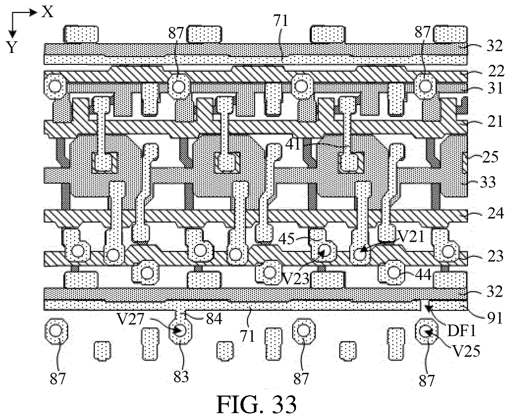

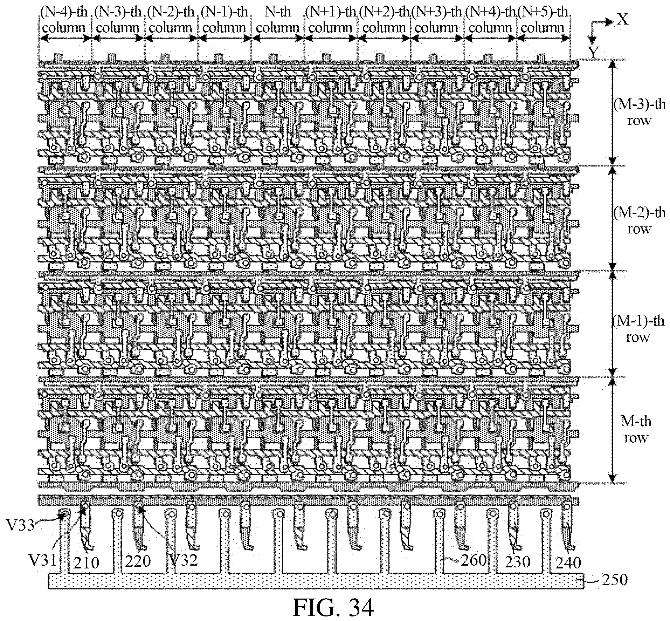

(6) A pattern of a first planarization layer is formed. In an exemplary implementation mode, the pattern of the first planarization layer is formed, which may include: a first planarization thin film is coated on the base substrate on which the aforementioned patterns are formed, the first planarization thin film is patterned through a patterning process to form the first planarization layer covering the third conductive layer, and multiple vias are disposed on the first planarization layer, as shown in FIGs. 29 to 34, wherein FIG. 29 is an enlarged view of the E0 region in FIG. 11, FIG. 30 is an enlarged view of the E1 region in FIG. 11, FIG. 31 is an enlarged view of the E2 region in FIG. 11, FIG. 32 is an enlarged view of the E3 region in FIG. 11, FIG. 33 is an enlarged view of the E4 region in FIG. 11, and FIG. 34 is an enlarged view of the F region in FIG. 11.

In an exemplary implementation mode, multiple vias of multiple circuit units in the display region each include: a twenty-first via V21, a twenty-second via V22, and a twenty-third via V23.

In an exemplary implementation mode, an orthographic projection of the twenty-first via V21 on the base substrate is located within a range of an orthographic projection of the second connection electrode 42 on the base substrate, the first planarization layer within the twenty-first via V21 is removed to expose a surface of the second connection electrode 42, and the twenty-first via V21 is configured such that a first power supply line subsequently formed is connected with the second connection electrode 42 through the via.

In an exemplary implementation mode, an orthographic projection of the twenty-second via 22 on the base substrate is located within a range of an orthographic projection of the fourth connection electrode 44 on the base substrate, the first planarization layer within the twenty-second via V22 is removed to expose a surface of the fourth connection electrode 44, and the twenty-second via V22 is configured such that a data signal line subsequently formed is connected with the fourth connection electrode 44 through the via.

In an exemplary implementation mode, an orthographic projection of the twenty-third via V23 on the base substrate is located within a range of an orthographic projection of the fifth connection electrode 45 on the base substrate, the first planarization layer within the twenty-third via V23 is removed to expose a surface of the fifth connection electrode 45, and the twenty-third via V23 is configured such that an anode connection electrode subsequently formed is connected with the fifth connection electrode 45 through the via.

As shown in FIG. 29, in an exemplary implementation mode, the plurality of circuit units in the third region (E0 region) further include a twenty-fourth via V24.

In an exemplary implementation mode, an orthographic projection of the twenty-fourth via 24 on the base substrate is located within a range of an orthographic projection of the power supply connection electrode 85 on the base substrate, the first planarization layer within the twenty-fourth via V24 is removed to expose a surface of the power supply connection electrode 85, and the twenty-fourth via V24 is configured such that a second power supply trace subsequently formed is connected with the power supply connection electrode 85 through the via. In an exemplary implementation mode, the twenty-fourth via V24 may be referred to as a third connection hole.

As shown in FIGs. 30 and 31, in an exemplary implementation mode, the plurality of circuit units in the first region (E1 region) and the multiple circuit units in the second region (E2 region) further include a twenty-fifth via V25.

In an exemplary implementation mode, an orthographic projection of the twenty-fifth via V25 on the base substrate is located within a range of an orthographic projection of the dummy electrode 87 on the base substrate, the first planarization layer within the twenty-fifth via V25 is removed to expose a surface of the dummy electrode 87, and the twenty-fifth via V25 is configured such that a second power supply trace subsequently formed is connected with the dummy electrode 85 through the via.

As shown in FIG. 32, in an exemplary implementation mode, at least one circuit unit of the junction region (E3 region) of the first region and the third region further includes a twenty-sixth via V26.

In an exemplary implementation mode, an orthographic projection of the twenty-sixth via V26 on the base substrate is located within a range of an orthographic projection of the data connection electrode 81 on the base substrate, the first planarization layer within the twenty-sixth via V26 is removed to expose a surface of the data connection electrode 81, and the twenty-sixth via V26 is configured such that a data signal line subsequently formed is connected with the data connection electrode 81 through the via.

In an exemplary implementation mode, the twenty-sixth via V26 and the twenty-second via V22 may be of a common structure of a same hole. In an exemplary implementation mode, the twenty-sixth via V26 may be referred to as a first connection hole.

As shown in FIG. 33, in an exemplary implementation mode, at least one circuit unit of the junction region (E4 region) of the first region and the second region further includes a twenty-seventh via V27.

In an exemplary implementation mode, an orthographic projection of the twenty-seventh via V27 on the base substrate is located within a range of an orthographic projection of the fan-out connection electrode 83 on the base substrate, the first planarization layer within the twenty-seventh via V27 is removed to expose a surface of the fan-out connection electrode 83, and the twenty-seventh via V27 is configured such that a second connection line subsequently formed is connected with the fan-out connection electrode 83 through the via. In an exemplary implementation mode, the twenty-seventh via V27 may be referred to as a second connection hole.

In an exemplary implementation mode, the twenty-sixth via V26 may be located on one side of the first connection line 71 in the opposite direction of the second direction Y, the twenty-seventh via V27 may be located on one side of the first connection line 71 in the second direction Y, that is, the first connection hole (the twenty-sixth via V26) and the second connection hole (the twenty-seventh via V27) connecting a same first connection line 71 are disposed on two sides of the first connection line 71 in the second direction Y respectively.

As shown in FIG. 34, in an exemplary implementation mode, a plurality of vias of the lead region in the bonding region at least include: a thirty-first via V31, a thirty-second via V32, and a thirty-third via V33.

In an exemplary implementation mode, an orthographic projection of the thirty-first via V31 on the base substrate is located within a range of an orthographic projection of the third lead electrode 230 on the base substrate, the first planarization layer within the thirty-first via V31 is removed to expose a surface of the third lead electrode 230, and the thirty-first via V31 is configured such that a data signal line of an odd-numbered column in the display region subsequently formed is connected with the third lead electrode 230 through the via.

In an exemplary implementation mode, an orthographic projection of the thirty-second via V32 on the base substrate is located within a range of an orthographic projection of the fourth lead electrode 240 on the base substrate, the first planarization layer within the thirty-second via V32 is removed to expose a surface of the fourth lead electrode 240, and the thirty-second via V32 is configured such that a data signal line of an even-numbered column in the display region subsequently formed is connected with the fourth lead electrode 240 through the via.

In an exemplary implementation mode, an orthographic projection of the thirty-third via V33 on the base substrate is located within a range of an orthographic projection of the bonding high voltage electrode 260 on the base substrate, the first planarization layer within the thirty-third via V33 is removed to expose a surface of the bonding high voltage electrode 260, and the thirty-third via V33 is configured such that a first power supply line in the display region subsequently formed is connected with the bonding high voltage electrode 260 through the via.

The lead region shown in FIG. 34 is patterns of vias on the first planarization layer of the third region in the display region, since the second region of the display region is further provided with a sixth lead electrode, the plurality of vias of the lead region in the bonding region may further include a thirty-fourth via, wherein the thirty-fourth via exposes a surface of the sixth lead electrode, and the thirty-fourth via is configured such that a second connection line to be formed subsequently is connected with the sixth lead electrode through the via.

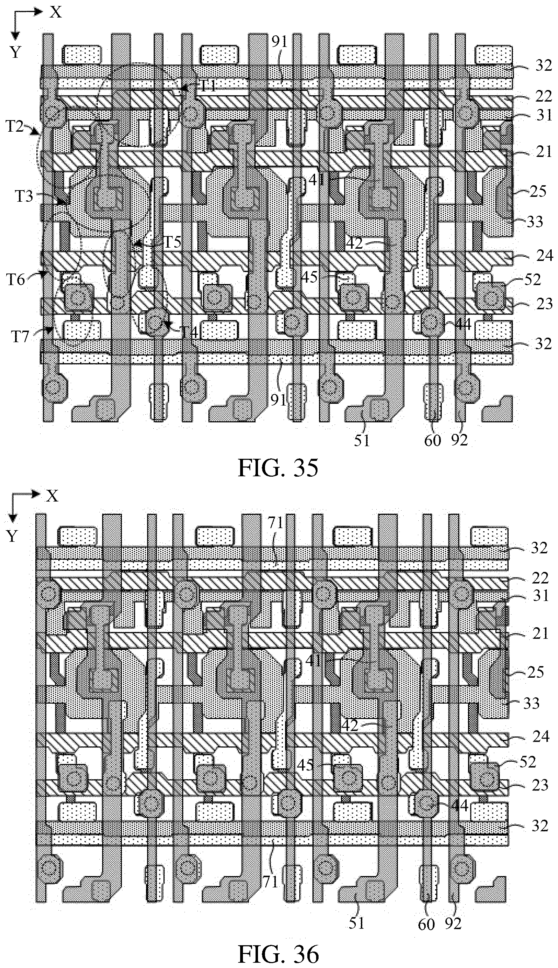

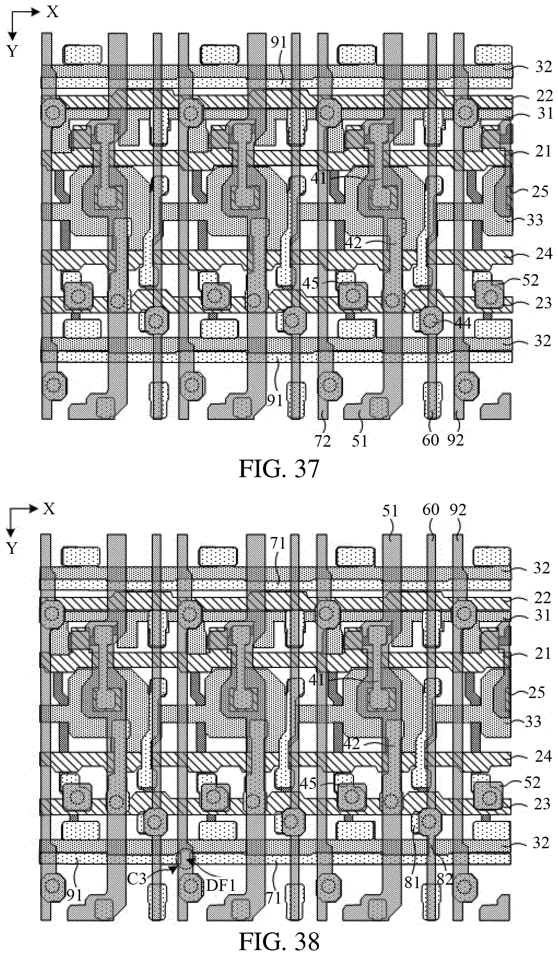

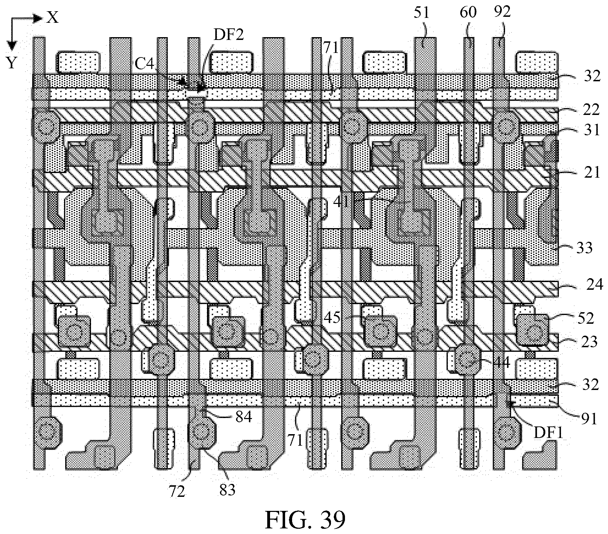

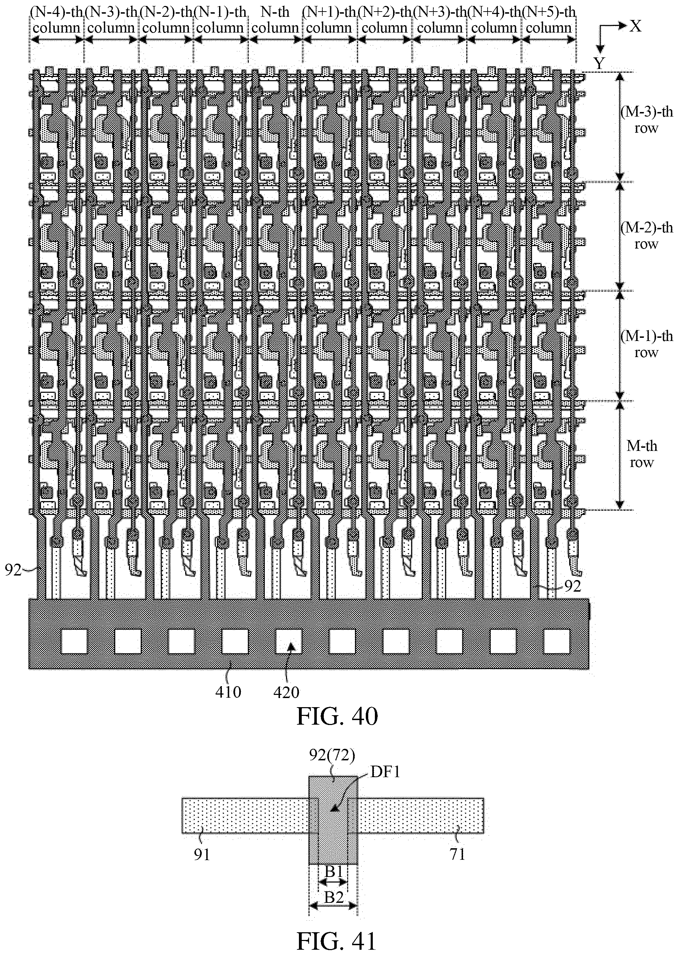

(7) A pattern of a fourth conductive layer is formed. In an exemplary implementation mode, the pattern of the fourth conductive layer is formed, which may include: a fourth conductive thin film is deposited on the base substrate on which the aforementioned patterns are formed, and the fourth conductive thin film is patterned through a patterning process to form the fourth conductive layer disposed on the first planarization layer, as shown in FIGs. 35 to 40, wherein FIG. 35 is an enlarged view of the E0 region in FIG. 11, FIG. 36 is an enlarged view of the E1 region in FIG. 11, FIG. 37 is an enlarged view of the E2 region in FIG. 11, FIG. 38 is an enlarged view of the E3 region in FIG. 11, FIG. 39 is an enlarged view of the E4 region in FIG. 11, and FIG. 40 is an enlarged view of the F region in FIG. 11. In an exemplary implementation mode, the fourth conductive layer may be referred to as a second source drain metal (SD2) layer.

In an exemplary implementation mode, the pattern of the fourth conductive layer of multiple circuit units in the display region each include: a first power supply line 51, an anode connection electrode 52, and a data signal line 60.

In an exemplary implementation mode, a shape of the first power supply line 51 may be a broken line shape of which a main body portion extends along the second direction Y. On one hand, the first power supply line 51 is connected with the second connection electrode 42 through the twenty-first via V21 of the display region, and on the other hand, after extending to the lead region, the first power supply line 51 is connected with the bonding high voltage electrode 260 through the thirty-third via V33 of the lead region. Since the second connection electrode 42 is respectively connected with the second electrode plate and the first region of the fifth active layer through a via, it is achieved that the first power supply line 51 writes a power supply signal into the first electrode of the fifth transistor T5, and the second electrode plate of the storage capacitor and the first power supply line 51 have a same potential. Since the bonding high voltage electrode 260 is connected with the bonding high voltage line 250, it is achieved that the bonding high voltage line 250 provides a high-level signal to the first power supply line 51 through the bonding high voltage electrode 260.

In an exemplary implementation mode, an orthographic projection of the first power supply line 51 on the base substrate is at least partially overlapped with an orthographic projection of the first connection electrode 41 on the base substrate, and the first power supply line 51 may effectively shield an influence of data voltage jump on a key node in the pixel drive circuit, avoid the influence of the data voltage jump on a potential of the key node in the pixel drive circuit, and improve a display effect.

In an exemplary implementation mode, an orthographic projection of the first power supply line 51 on the base substrate contains an orthographic projection of the first connection electrode 41 on the base substrate, and an orthographic projection of the first power supply line 51 on the base substrate contains an orthographic projection of the second connection electrode 42 on the base substrate.

In an exemplary implementation mode, the first power supply line 51 may be of an unequal width design, and the first power supply line 51 with the unequal width design may not only facilitate a layout of a pixel structure, but also reduce a parasitic capacitance between the first power supply line and a data signal line.

In an exemplary implementation mode, a shape of the data signal line 60 may be a straight line shape of which a main body portion extends along the second direction Y. On one hand, the data signal line 60 is connected with the fourth connection electrode 44 through the twenty-second via V22 of the display region, on the other hand, after the data signal line 60 extends to the lead region, a data signal line 60 of an odd-numbered unit column is connected with the third lead electrode 230 through the thirty-first via V31, and a data signal line 60 of an even-numbered unit column is connected with fourth lead electrode 240 through the thirty-second via V32. Since the fourth connection electrode 44 is connected with the first region of the fourth active layer through a via, it is achieved that the data signal line 60 writes a data signal into the first electrode of the fourth transistor T4.

In an exemplary implementation mode, FIG. 40 shows the pattern of the fourth conductive layer of the third region in the display region, and the data signal line 60 is connected with the third lead electrode 230 and the fourth lead electrode 240 respectively. For the second region in the display region, the pattern of the fourth conductive layer of the second region may further include a second connection line, wherein the second connection line is connected with the sixth lead electrode through the thirty-fourth via after extending to the lead region.

In an exemplary implementation mode, a connection structure between a second connection line and a lead electrode is substantially the same as a connection structure between a data signal line and the lead electrode, and the second connection line may lead out a data signal line of an odd-numbered unit column through a first connection line, or the second connection line may lead out a data signal line of an even-numbered unit column through a first connection line, which will not be repeated here.

In an exemplary implementation mode, since the third lead electrode 230 is connected with the first lead electrode 210 through a via, and the first lead electrode 210 is connected with a first leading out line, a connection between a data signal line 60 of an odd-numbered unit column and the first leading out line located in the first conductive layer (GATE1) is achieved. Since the fourth lead electrode 240 is connected with the second lead electrode 220 through a via, and the second lead electrode 220 is connected with a second leading out line, a connection between a data signal line 60 of an even-numbered unit column and the second leading out line located in the second conductive layer (GATE2) is achieved.

In an exemplary implementation mode, multiple leading out lines of the lead region may include multiple first leading out lines disposed in the first conductive layer (GATE1) and multiple second leading out lines disposed in the second conductive layer (GATE2), wherein the multiple first leading out lines may be correspondingly connected with data signal lines 60 of an odd-numbered unit column through the first lead electrode 210 and the third lead electrode 230, and the multiple second leading out lines may be correspondingly connected with data signal lines 60 of an even-numbered unit column through the second lead electrode 220 and the fourth lead electrode 240. By disposing multiple leading out lines in two conductive layers in the present disclosure, a width of leading out lines may be increased on a premise of avoiding short circuit, and reliability of data transmission may be improved.

In an exemplary implementation mode, multiple first leading out lines may be correspondingly connected with data signal lines of an even-numbered unit column, and multiple second leading out lines may be correspondingly connected with data signal lines of an odd-numbered unit column, which is not limited here in the present disclosure.

In an exemplary implementation mode, a shape of the anode connection electrode 52 may be a rectangular shape, and the anode connection electrode 52 is connected with the fifth connection electrode 45 through the twenty-third via V23. In an exemplary implementation mode, the anode connection electrode 52 is configured to be connected with an anode to be formed subsequently, and since the fifth connection electrode 45 is connected with the second region of the sixth active layer (also the second region of the seventh active layer) through a via, it is achieved that the anode is connected with the second electrode of the sixth transistor T6 (also the second electrode of the seventh transistor T7) through the anode connection electrode 52 and the fifth connection electrode 45.

As shown in FIG. 35, in an exemplary implementation mode, the pattern of the fourth conductive layer of the plurality of circuit units of the third region (E0 region) may further include a second power supply trace 92.

In an exemplary implementation mode, a shape of the second power supply trace 92 may be a straight line of which a main body portion extends along the second direction Y, and the second power supply trace 92 is connected with the power supply connection electrode 85 through the twenty-fourth via V24. Since the power supply connection electrode 85 is connected with the first power supply trace 91 through the power supply connection block 86, it is achieved that the second power supply trace 92 and the first power supply trace 91 are connected with each other, so that the first power supply trace 91 extending along the first direction X and the second power supply trace 92 extending along the second direction Y constitute a mesh communication structure. By disposing power supply traces with a mesh communication structure in the present disclosure, power supply traces in multiple unit rows and multiple unit columns have a same potential, which not only effectively reduces a resistance of the power supply traces and reduces voltage drop for transmitting low voltage signals, but also effectively improves uniformity of low voltage signals in the display substrate, effectively improves display uniformity, and improves display character and display quality.

In an exemplary implementation mode, an orthographic projection of the power supply connection electrode 85 on the base substrate is at least partially overlapped with an orthographic projection of the second power supply trace 92 on the base substrate.

In an exemplary implementation mode, an orthographic projection of the power supply connection electrode 85 on the base substrate may be located within a range of an orthographic projection of the second power supply trace 92 on the base substrate.

In an exemplary implementation mode, an orthographic projection of the power supply connection block 86 on the base substrate is at least partially overlapped with the orthographic projection of the second power supply trace 92 on the base substrate.

In an exemplary implementation mode, an orthographic projection of the power supply connection block 86 on the base substrate may be located within a range of the orthographic projection of the second power supply trace 92 on the base substrate.

As shown in FIG. 36, in an exemplary implementation mode, the pattern of the fourth conductive layer of the plurality of circuit units in the first region (E1 region) may further include a second power supply trace 92.

In an exemplary implementation mode, the second power supply trace 92 is connected with the dummy electrode 87 through the twenty-fifth via V25.

In an exemplary implementation mode, since a position and a shape of the dummy electrode 87 are substantially the same as those of a power supply connection electrode and a data connection electrode, a hole connection structure of second power supply traces 92 and dummy electrodes 87 of the multiple circuit units in the first region are substantially the same as a hole connection structure of a circuit unit in another region, which may not only improve uniformity of a preparation process, but also achieve a same display effect in different regions under both transmitted and reflected light, and effectively avoid shadow elimination.

As shown in FIG. 37, in an exemplary implementation mode, the pattern of the fourth conductive layer of at least one circuit unit in the second region (E2 region) may further include a second connection line 72, and another circuit unit may include a second power supply trace 92.

In an exemplary implementation mode, a shape of the second connection line 72 may be a straight line shape of which a main body portion extends along the second direction Y, and the second connection line 72 is connected with the dummy electrode 87 through the twenty-fifth via V25.

In an exemplary implementation mode, the second power supply trace 92 is connected with the dummy electrode 87 through the twenty-fifth via V25.

As shown in FIG. 38, in an exemplary implementation mode, a data signal line 60 of at least one circuit unit in the junction region (E3 region) of the first region and the third region is connected with the data connection electrode 81 through the twenty-sixth via V26. Since the data connection electrode 81 is connected with the first connection line 71 through the data connection block 82, a connection between the data signal line 60 and the first connection line 71 is achieved.

In an exemplary implementation mode, an orthographic projection of the data connection electrode 81 on the base substrate is at least partially overlapped with an orthographic projection of the data signal line 60 on the base substrate.

In an exemplary implementation mode, an orthographic projection of the data connection electrode 81 on the base substrate may be located within a range of the orthographic projection of the data signal line 60 on the base substrate.

In an exemplary implementation mode, an orthographic projection of the data connection block 82 on the base substrate is at least partially overlapped with the orthographic projection of the data signal line 60 on the base substrate.

In an exemplary implementation mode, the orthographic projection of the data connection block 82 on the base substrate may be located within the range of the orthographic projection of the data signal line 60 on the base substrate.

In an exemplary implementation mode, a second power supply trace 92 of another circuit unit in the junction region of the first region and the third region is connected with the dummy electrode 87 through the twenty-fifth via V25.

In an exemplary implementation mode, an orthographic projection of the first fracture DF1 located between the first connection line 71 and the first power supply trace 91 on the base substrate is at least partially overlapped with an orthographic projection of the second power supply trace 92 on the base substrate, or an orthographic projection of the first fracture DF1 on the base substrate is at least partially overlapped with an orthographic projection of the second connection line 72 on the base substrate.

In an exemplary implementation mode, the orthographic projection of the first fracture DF1 on the base substrate may be within a range of an orthographic projection of the second power supply trace 92 or the second connection line 72 on the base substrate, that is, the first fracture DF1 is covered by the second power supply trace 92 or the second connection line 72. By using the second power supply trace 92 or the second connection line 72 to shield the first fracture DF1, film layer differences of different regions are effectively eliminated, and undesirable appearance of the display substrate is further avoided.

As shown in FIG. 39, in an exemplary implementation mode, the pattern of the fourth conductive layer of the second connection unit of the junction region (E4 region) of the first region and the second region may further include a second connection line 72.

In an exemplary implementation mode, a shape of the second connection line 72 may be a straight line shape of which a main body portion extends along the second direction Y, and the second connection line 72 is connected with the fan-out connection electrode 83 through the twenty-seventh via V27. Since the fan-out connection electrode 83 is connected with the first connection line 71 through the fan-out connection block 84, a mutual connection between the second connection line 72 and the first connection line 71 is achieved. Since the first connection line 71 and a data signal line are connected, it is achieved that the data signal line 60 is connected with the second connection line 72 through the first connection line 71.

In an exemplary implementation mode, a second power supply trace 92 of another circuit unit of the junction region of the first region and the second region is connected with the dummy electrode 87 through the twenty-fifth via V25.

In an exemplary implementation mode, an orthographic projection of the fan-out connection electrode 83 on the base substrate is at least partially overlapped with an orthographic projection of the second connection line 72 on the base substrate.

In an exemplary implementation mode, the orthographic projection of the fan-out connection electrode 83 on the base substrate may be located within a range of the orthographic projection of the second connection line 72 on the base substrate.

In an exemplary implementation mode, an orthographic projection of the fan-out connection block 84 on the base substrate is at least partially overlapped with the orthographic projection of the second connection line 72 on the base substrate.

In an exemplary implementation mode, the orthographic projection of the fan-out connection block 84 on the base substrate may be located within the range of the orthographic projection of the second connection line 72 on the base substrate.

In an exemplary implementation mode, at least one circuit unit of the first region adjacent to the second connection unit may be provided with at least one second fracture DF2, wherein the second fracture DF2 cuts off a second connection line 72 and a second power supply trace 92 in a same circuit column, the second connection line 72 is on one side of the second fracture DF2 in the second direction Y, and the second power supply trace 92 is on one side of the second fracture DF2 in the opposite direction of the second direction Y.

In an exemplary implementation mode, an orthographic projection of the second fracture DF2 on the base substrate is at least partially overlapped with an orthographic projection of the first connection line 71 or the first power supply trace 91 on the base substrate.

In an exemplary implementation mode, the orthographic projection of the second fracture DF2 on the base substrate may be located within a range of an orthographic projection of the first connection line 71 or the first power supply trace 91 on the base substrate, and the second fracture DF2 may be padded by using the first connection line 71 or the first power supply trace 91, effectively eliminating film layer differences of different regions, which may further avoid poor appearance of the display substrate.

As shown in FIG. 40, in an exemplary implementation mode, the pattern of the fourth conductive layer of the lead region in the bonding region at least includes a bonding power supply lead 410.

In an exemplary implementation mode, a shape of the bonding power supply lead 410 may be a strip shape extending along the first direction X, and the bonding power supply lead 410 is connected with multiple second power supply traces 92 of the display region, respectively. In an exemplary implementation mode, the bonding power supply lead 410 is configured to continuously provide a high-level signal to the multiple second power supply traces 92 of the display region, or configured to continuously provide a low-level signal to the multiple second power supply traces 92 of the display region.

In an exemplary implementation mode, multiple lead openings 420 may be disposed on the bonding power supply lead 410, wherein the fourth conductive thin film within the lead openings 420 is removed to expose the first planarization layer. In an exemplary implementation mode, the multiple lead openings 420 are configured to release water vapor in the first planarization layer.

In an exemplary implementation mode, the bonding high voltage line 250 and the bonding power supply lead 410 of the lead region may be connected with a bonding pad of a bonding pin region after crossing the bending region and a drive chip region, and an external control apparatus provides a high voltage signal and a low voltage signal to the bonding high voltage line 250 and the bonding power supply lead 410 respectively through a flexible printed circuit board and the bonding pad.

In an exemplary implementation mode, multiple first power supply traces in the display region may be connected with a bezel power supply lead of the bezel region, wherein a connection structure between the first power supply traces and the bezel power supply lead is substantially the same as a connection structure between the aforementioned second power supply traces and the bonding power supply lead, which will not be repeated here.

FIG. 41 is a schematic diagram of a structure of a region where a first fracture is located according to an exemplary embodiment of the present disclosure, and is an enlarged view of a region C3 in FIG. 38. As shown in FIG. 41, the first fracture DF1 may be disposed between the first connection line 71 and the first power supply trace 91 in one unit row, thereby achieving insulation between the first connection line 71 and the first power supply trace 91.

In an exemplary implementation mode, a first width B1 of the first fracture DF1 may be less than or equal to a second width B2 of the second power trace 92 or the second connection line 72, and the first width B 1 and the second width B2 may be dimensions in the first direction X.

In an exemplary implementation mode, an orthographic projection of the first fracture DF1 on the base substrate may be within a range of an orthographic projection of the second power supply line 92 or the second connection line 72 on the base substrate, i.e., both edges of the first fracture DF1 are within a coverage of the second power trace 92 or the second connection line 72.

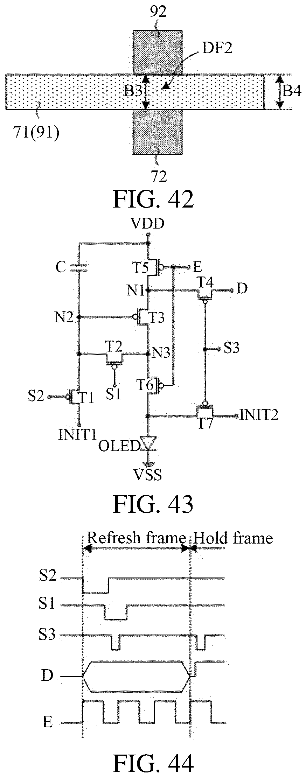

FIG. 42 is a schematic diagram of a structure of a region where a second fracture is located according to an exemplary embodiment of the present disclosure, and is an enlarged view of a region C4 in FIG. 38. As shown in FIG. 42, the second fracture DF2 may be disposed between the second connection line 72 and the second power supply trace 92 in one unit column, thereby achieving insulation between the second connection line 72 and the second power supply trace 92.

In an exemplary implementation mode, a third width B3 of the second fracture DF2 may be smaller than a fourth width B4 of the first connection line 71 or the first power supply trace 91, and the third width B3 and the fourth width B4 may be dimensions in the second direction Y.

In an exemplary implementation mode, an orthographic projection of the second fracture DF2 on the base substrate may be within a range of an orthographic projection of the first connection line 71 or the first power supply trace 91 on the base substrate, that is, both edges of the second fracture DF2 are within a coverage of the first connection line 71 or the first power supply trace 91.

In another exemplary implementation mode, a width B3 of the second fracture DF2 may be equal to a width B4 of the first connection line 71 or the first power supply trace 91, and a boundary of the orthographic projection of the second fracture DF2 on the base substrate is substantially flush with a boundary of the orthographic projection of the first connection line 71 or the first power supply trace 91 on the base substrate, forming a structure similar to "pattern complementarity".

In an exemplary implementation mode, when a pattern of an anode is formed subsequently, orthographic projections of the first fracture surface DF1 and the second fracture surface DF2 on the base substrate are not overlapped with an orthographic projection of the anode on the base substrate, that is, both the first fracture surface DF1 and the second fracture surface DF2 are located outside a coverage of the anode.

So far, preparation of a drive structure layer on the base substrate is completed. In a plane parallel to the display substrate, the drive structure layer may include a plurality of circuit units, wherein each circuit unit may include a pixel drive circuit, and a first scan signal line, a second scan signal line, a third scan signal line, a light emitting control line, a data signal line, a first power supply line, a first initial signal line, and a second initial signal line that are connected with the pixel drive circuit. In a plane perpendicular to the display substrate, the drive structure layer may at least include a first insulation layer, a semiconductor layer, a second insulation layer, a first conductive layer, a third insulation layer, a second conductive layer, a fourth insulation layer, a third conductive layer, a first planarization layer, a fourth conductive layer which are stacked sequentially on the base substrate.

In an exemplary implementation mode, the base substrate may be a flexible base substrate, or may be a rigid base substrate. The rigid base substrate may be made of, but is not limited to, one or more of glass and quartz. The flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fibers. In an exemplary implementation mode, the flexible base substrate may include a first flexible material layer, a first inorganic material layer, a semiconductor layer, a second flexible material layer, and a second inorganic material layer which are stacked, wherein materials of the first flexible material layer and the second flexible material layer may be Polyimide (PI), Polyethylene Terephthalate (PET), or a surface-treated polymer soft film, or the like, materials of the first inorganic material layer and the second inorganic material layer may be Silicon Nitride (SiNx) or Silicon Oxide (SiOx), or the like, for improving a water and oxygen resistance capability of the base substrate, and a material of the semiconductor layer may be amorphous silicon (a-si).

In an exemplary implementation mode, the first conductive layer, the second conductive layer, the third conductive layer, and the fourth conductive layer may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure or a multi-layer composite structure, such as Mo/Cu/Mo. The first insulation layer, the second insulation layer, the third insulation layer, and the fourth insulation layer may be made of any one or more of Silicon Oxide (SiOx), Silicon Nitride (SiNx), and Silicon Oxynitride (SiON), and may be a single layer, a multi-layer, or a composite layer. The first insulation layer is referred to as a Buffer layer, the second insulation layer and the third insulation layer are referred to as Gate Insulation (GI) layers, and the fourth insulation layer is referred to as an Interlayer Dielectric (ILD) layer. The first planarization layer may be made of an organic material, such as resin. An active layer may be made of a material such as amorphous Indium Gallium Zinc Oxide (a-IGZO), Zinc Oxynitride (ZnON), Indium Zinc Tin Oxide (IZTO), amorphous Silicon (a-Si), poly Silicon (p-Si), hexathiophene, or polythiophene. That is, the present disclosure is applicable to a transistor that is manufactured based on an oxide technology, a silicon technology, or an organic matter technology.

In an exemplary implementation mode, after the preparation of the drive circuit layer is completed, a light emitting structure layer and an encapsulation structure layer may be sequentially prepared on the drive structure layer, which will not be repeated here.

In a display substrate, a display region includes a trace region provided with a data connection line and a normal region not provided with a data connection line. Since the data connection line of the trace region has a relatively high reflection capability under irradiation of external light, while a reflection capability of another metal line in the normal region is relatively weak, so appearance of the normal region is obviously different from appearance of the trace region, which leads to a problem of poor appearance of the display substrate, and poor appearance is more obvious especially when a screen is off or in low gray scale display.

As may be seen from a structure and the preparation process of the display substrate described above, by disposing a data connection line and a power supply trace in a display region in the present disclosure, the power supply trace is disposed in a normal region not provided with a data connection line, so that a trace region and the normal region have substantially a same trace structure, and substantially a same display effect may be achieved in different regions under both transmitted light and reflected light, thus effectively avoiding poor appearance of the display substrate and improving display character and display quality. By disposing a dummy electrode in the display region in the present disclosure, morphology and a connection structure exhibited by the dummy electrode are substantially the same as those of a data connection electrode, a fan-out connection electrode, and a power supply connection electrode, so that different positions in the display substrate have substantially a same transfer connection structure, which may further avoid the poor appearance of the display substrate. In the present disclosure, a first connection line is used for padding a second fracture and a second connection line is used for shielding a first fracture, which effectively eliminates a difference of film layers of different regions, and may further avoid the poor appearance of the display substrate.

In the present disclosure, a structure of VSS in pixel is achieved by disposing a power supply trace line in a display region, which may greatly reduce a width of a bezel power supply lead, greatly reduces widths of left and right bezels, and increases a screen-to-body ratio, which is beneficial to achieve full-screen display. In the present disclosure, by disposing power supply traces in a mesh communication structure, not only a resistance of the power supply traces may be effectively reduced, voltage drop of a low voltage power supply signal may be effectively reduced, and low power consumption may be achieved, but also uniformity of power supply signals in the display substrate may be effectively improved, effectively improving display uniformity, and improving display character and display quality. The preparation process in the present disclosure may be compatible well with an existing preparation process, is simple in process implementation, is easy to implement, and has a high production efficiency, a low production cost, and a high yield.

The aforementioned structure shown in the present disclosure and the preparation process thereof are merely exemplary description. In an exemplary implementation mode, corresponding structures may be changed and patterning processes may be added or reduced according to actual needs, which is not limited here in the present disclosure.

In an exemplary implementation mode, the display substrate in the present disclosure may be applied to a display apparatus with a pixel drive circuit, such as an OLED, a quantum dot display (QLED), a light emitting diode display (Micro LED or Mini LED) or a Quantum Dot Light Emitting Diode display (QDLED), which is not limited here in the present disclosure.

FIG. 43 is a schematic diagram of an equivalent circuit of a pixel drive circuit according to an exemplary embodiment of the present disclosure. As shown in FIG. 43, the pixel drive circuit may include a storage capacitor C and a first transistor T1 to a seventh transistor T7, and the pixel drive circuit is connected with a data signal line D, a first scan signal line S1, a second scan signal line S2, a third scan signal line S3, a light emitting signal line E, a first initial signal line INIT1, a second initial signal line INIT2, a first power supply line VDD, and a light emitting device OLED, respectively.

In an exemplary implementation mode, a first end of the storage capacitor C is connected with the first power supply line VDD, and a second end (second node N2) of the storage capacitor C is connected with a gate electrode of the third transistor (drive transistor) T3. A gate electrode of the first transistor (first initialization transistor) T1 is connected with the second scan signal line S2, a first electrode of the first transistor T1 is connected with the first initial signal line INIT1, and a second electrode of the first transistor T1 is connected with the gate electrode of the third transistor T3. A gate electrode of the second transistor (compensation transistor) T2 is connected with the first scan signal line S1, a first electrode of the second transistor T2 is connected with the gate electrode of the third transistor T3, and a second electrode of the second transistor T2 is connected with a second electrode (third node N3) of the third transistor T3. The gate electrode of the third transistor (drive transistor) T3 is connected with the second end of the storage capacitor C, a first electrode (first node N1) of the third transistor T3 is connected with a second electrode of the fourth transistor T4, and the second electrode of the third transistor T3 is connected with a first electrode of the sixth transistor T6. A gate electrode of the fourth transistor (writing transistor) T4 is connected with the third scan signal line S3, a first electrode of the fourth transistor T4 is connected with the data signal line D, and the second electrode of the fourth transistor T4 is connected with the first electrode of the third transistor T3. A gate electrode of the fifth transistor (light emitting transistor) T5 is connected with the light emitting signal line E, a first electrode of the fifth transistor T5 is connected with the first power supply line VDD, and a second electrode of the fifth transistor T5 is connected with the first electrode of the third transistor T3. A gate electrode of the sixth transistor (light emitting control transistor) T6 is connected with the light emitting signal line E, the first electrode of the sixth transistor T6 is connected with the second electrode of the third transistor T3, and a second electrode of the sixth transistor T6 is connected with a first electrode of a light emitting device OLED. A gate electrode of the seventh transistor (second initialization transistor) T7 is connected with the third scan signal line S3, a first electrode of the seventh transistor T7 is connected with the second initial signal line INIT2, and a second electrode of the seventh transistor T7 is connected with the first electrode of the light emitting device OLED.

In an exemplary implementation mode, the first transistor T1 to the seventh transistor T7 may be P-type transistors, or may be N-type transistors. Use of a same type of transistors in a pixel drive circuit may simplify a process flow, reduce process difficulties of a display panel, and improve a yield of products. In some possible implementation modes, the first transistor T1 to the seventh transistor T7 may include a P-type transistor and an N-type transistor.

In an exemplary implementation mode, for the first transistor T1 to the seventh transistor T7, low temperature poly silicon thin film transistors may be adopted, or oxide thin film transistors may be adopted, or a low temperature poly silicon thin film transistor and an oxide thin film transistor may be adopted. An active layer of a low temperature poly silicon thin film transistor may be made of Low Temperature Poly Silicon (LTPS for short), and an active layer of an oxide thin film transistor may be made of an oxide semiconductor (Oxide). The low temperature poly silicon thin film transistor has advantages such as, a high mobility, fast charging, and the oxide thin film transistor has advantages such a low drain current. The low temperature poly silicon thin film transistor and the oxide thin film transistor are integrated on one display substrate to form an LTPS + Oxide (LTPO for short) display substrate, so that advantages of the low temperature poly silicon thin film transistor and the oxide thin film transistor may be utilized, low-frequency drive may be achieved, power consumption may be reduced, and display quality may be improved.

In an exemplary implementation mode, a pixel drive circuit according to an exemplary embodiment of the present disclosure may include a high frequency display mode and a low frequency display mode. FIG. 44 is a working timing diagram of a pixel drive circuit according to an exemplary embodiment of the present disclosure. Taking a case that the first transistor T1 to the seventh transistor T7 are P-type transistors as an example, a working timing of a low-frequency display mode is illustrated. As shown in FIG. 44, in a case of the low frequency display mode, a working timing of the pixel drive circuit may include a working timing of a frame refresh phase and a working timing of a frame hold phase.

In an exemplary implementation mode, in the frame refresh phase, a working process of the pixel drive circuit may include: during a reset period in the frame refresh phase, a signal of the second scan signal line S2 enables the first transistor T1 to be turned on, a first initial voltage of the first initial signal line INIT1 is supplied to a second node N2, the storage capacitor C is initialized, and an original data voltage in the storage capacitor is cleared. Signals of the first scan signal line S1, the third scan signal line S3, and the light emitting signal line E enable the second transistor T2, the fourth transistor T4, the fifth transistor T5, the sixth transistor T6, and the seventh transistor T7 to be turned off.

During a data writing period in the frame refresh phase, signals of the first scan signal line S 1 and the third scan signal line S3 enable the second transistor T2, the fourth transistor T4, and the seventh transistor T7 to be turned on. During this period, since a second end of the storage capacitor C is at a low level, the third transistor T3 is turned on, and the second transistor T2 and the fourth transistor T4 are turned on, so that a data voltage output by the data signal line D is supplied to the second end of the storage capacitor C through the turned-on third transistor T3 and the turned-on second transistor T2. The seventh transistor T7 is turned on, so that a second initial voltage of the second initial signal line INIT2 is supplied to a first electrode of the OLED to initialize (reset) the first electrode of the OLED and clear its internal pre-stored voltage, thereby completing initialization. Signals of the second scan signal line S3 and the light emitting signal line E enable the first transistor T1, the fifth transistor T5, and the sixth transistor T6 to be turned off.

During a light emitting period in the frame refresh phase, a signal of the light emitting signal line E enables the fifth transistor T5 and the sixth transistor T6 to be turned on, and a power voltage output by the first power supply line VDD provides a drive voltage to the first electrode of the OLED through the turned-on fifth transistor T5, the third transistor T3, and the sixth transistor T6, to drive the OLED to emit light.

In an exemplary implementation mode, in the frame hold phase, a working process of the pixel drive circuit may include: during a reset period in the frame hold phase, signals of the first scan signal line S1, the second scan signal line S2, the third scan signal line S3, and the light emitting signal line E enable the first transistors T1 to the seventh transistors T7 to be turned off.

During a data writing period in the frame hold phase, a signal of the third scan signal line S3 enables the fourth transistor T4 and the seventh transistor T7 to be turned on. The fourth transistor T4 is turned on, so that a data voltage output by the data signal line D is input to a first terminal of the third transistor T3. The seventh transistor T7 is turned on, so that a second initial voltage of the second initial signal line INIT2 is supplied to a first electrode of the OLED to initialize (reset) the first electrode of the OLED and clear its internal pre-stored voltage, thereby completing initialization.

During a light emitting period in the frame hold phase, a signal of the light emitting signal line E enables the fifth transistor T5 and the sixth transistor T6 to be turned on, and a power voltage output by the first power supply line VDD provides a drive voltage to the first electrode of the OLED through the turned-on fifth transistor T5, the third transistor T3, and the sixth transistor T6, to drive the OLED to emit light.

In an exemplary implementation mode, the first scan signal line S1 turns on the second transistor T2 only in the frame refresh phase, and the third scan signal line S3 turns on the fourth transistor T4 in the frame refresh phase and the frame hold phase, respectively. Therefore, a data voltage may be input to the first terminal of the third transistor T3 during the data writing period of the frame hold phase, and an influence of voltage jump of the first node N1 on light emission brightness of the OLED may be weakened at the moment of entering the light emitting phase (the fifth transistor T5 is turned on).

In an exemplary implementation mode, in a case of a high frequency display mode, the pixel drive circuit may also perform the working timing of the frame refresh phase in the frame hold phase, which is not limited here in the present disclosure.

The present disclosure also provides a drive method of a display substrate configured to drive the aforementioned display substrate. In an exemplary implementation mode, the display substrate includes a plurality of circuit units, wherein at least one circuit unit may include a pixel drive circuit, the pixel drive circuit at least includes a compensation transistor, a drive transistor, and a data writing transistor, wherein a gate electrode of the compensation transistor is connected with a first scan signal line, a first electrode of the compensation transistor is connected with a gate electrode of the drive transistor, a second electrode of the compensation transistor is connected with a second electrode of the drive transistor, a gate electrode of the data writing transistor is connected with a third scan signal line, a first electrode of the data writing transistor is connected with a data signal line, and a second electrode of the data writing transistor is connected with a first electrode of the drive transistor; the drive method may include: in a frame refresh phase, the first scan signal line controls the compensation transistor to be turned on, the third scan signal line controls the data writing transistor to be turned on, and a data voltage output by the data signal line is supplied to the gate electrode of the drive transistor; in a frame hold phase, the third scan signal line controls the data writing transistor to be turned on, and the data voltage output by the data signal line is supplied to the first electrode of the drive transistor.

The present disclosure also provides a preparation method of a display substrate, for preparing the display substrate according to the above embodiments. In an exemplary implementation mode, the display substrate includes a plurality of circuit units, a plurality of data signal lines, and a plurality of data connection lines, wherein the data connection lines include a first connection line extending along a first direction and a second connection line extending along a second direction, the data signal lines extend along the second direction, and the first direction and the second direction intersect; the preparation method may include: forming a data connection electrode in at least one circuit unit, forming a fan-out connection electrode in at least one circuit unit, and forming a data signal line, a first connection line, and a second connection line, wherein the second connection line is connected with the first connection line through the fan-out connection electrode, and the first connection line is connected with the data signal line through the data connection electrode; an orthographic projection of the data connection electrode on a plane of the display substrate is at least partially overlapped with an orthographic projection of the data signal line on the plane of the display substrate, an orthographic projection of the fan-out connection electrode on the plane of the display substrate is at least partially overlapped with an orthographic projection of the second connection line on the plane of the display substrate, wherein there is a first distance between the data connection electrode and the first connection line, and there is a second distance between the fan-out connection electrode and the first connection line, the first distance and the second distance are greater than 0, the first distance and the second distance are dimensions in the second direction.

The present disclosure also provides a display apparatus which includes the aforementioned display substrate. The display apparatus may be any product or component with a display function, such as a mobile phone, a tablet computer, a television, a display, a laptop computer, a digital photo frame, or a navigator, and the embodiments of the present invention are not limited thereto.

Although implementation modes disclosed in the present disclosure are described as above, the described contents are only implementation modes which are used for facilitating understanding of the present disclosure, but are not intended to limit the present invention. Any skilled person in the art to which the present disclosure pertains may make any modification and variation in forms and details of implementation without departing from the spirit and scope of the present disclosure. However, the patent protection scope of the present invention should be subject to the scope defined in the appended claims.

## Claims

1. A display substrate, comprising a plurality of circuit units, a plurality of data signal lines, and a plurality of data connection lines, wherein the data connection lines comprise a first connection line extending along a first direction and a second connection line extending along a second direction, the data signal lines extend along the second direction, and the first direction and the second direction intersect; at least one circuit unit comprises a data connection electrode, at least one circuit unit comprises a fan-out connection electrode, wherein the second connection line is connected with the first connection line through the fan-out connection electrode, and the first connection line is connected with a data signal line through the data connection electrode; an orthographic projection of the data connection electrode on a plane of the display substrate is at least partially overlapped with an orthographic projection of the data signal line on the plane of the display substrate, an orthographic projection of the fan-out connection electrode on the plane of the display substrate is at least partially overlapped with an orthographic projection of the second connection line on the plane of the display substrate, wherein there is a first distance between the data connection electrode and the first connection line, and there is a second distance between the fan-out connection electrode and the first connection line, the first distance and the second distance are greater than 0, and the first distance and the second distance are dimensions in the second direction.

2. The display substrate according to claim 1, wherein the data connection electrode and the fan-out connection electrode connected with a same first connection line are respectively disposed on two sides of the first connection line.

3. The display substrate according to claim 1, wherein at least one circuit unit comprises a data connection block, wherein the data connection electrode is connected with the first connection line through the data connection block, and an orthographic projection of the data connection block on the plane of the display substrate is at least partially overlapped with the orthographic projection of the data signal line on the plane of the display substrate.

4. The display substrate according to claim 3, wherein the first connection line, the data connection block, and the data connection electrode are connected with each other to be of an integral structure.

5. The display substrate according to claim 1, wherein at least one circuit unit comprises a fan-out connection block, wherein the fan-out connection electrode is connected with the first connection line through the fan-out connection block, and an orthographic projection of the fan-out connection block on the plane of the display substrate is at least partially overlapped with the orthographic projection of the second connection line on the plane of the display substrate.

6. The display substrate according to claim 5, wherein the first connection line, the fan-out connection block, and the fan-out connection electrode are connected with each other to be of an integral structure.

7. The display substrate according to claim 1, wherein at least one circuit unit comprises a dummy electrode, wherein a position and a shape of the dummy electrode in one circuit unit are the same as a position and a shape of the fan-out connection electrode in another circuit unit.

8. The display substrate according to claim 7, wherein an orthographic projection of the dummy electrode on the plane of the display substrate is at least partially overlapped with the orthographic projection of the second connection line on the plane of the display substrate.

9. The display substrate according to claim 1, wherein the display substrate further comprises a plurality of first power supply traces extending along the first direction and a plurality of second power supply traces extending along the second direction; at least one circuit unit comprises a power supply connection electrode, wherein a second power supply trace is connected with a first power supply trace through the power supply connection electrode, and an orthographic projection of the power supply connection electrode on the plane of the display substrate is at least partially overlapped with an orthographic projection of the second power supply trace on the plane of the display substrate.

10. The display substrate according to claim 9, wherein at least one circuit unit comprises a power supply connection block, wherein the power supply connection electrode is connected with the first power supply trace through the power supply connection block, and an orthographic projection of the power supply connection block on the plane of the display substrate is at least partially overlapped with the orthographic projection of the second power supply trace on the plane of the display substrate.

11. The display substrate according to claim 10, wherein the first power supply trace, the power supply connection block, and the power supply connection electrode are connected with each other to be of an integral structure.

12. The display substrate according to claim 9, wherein at least one circuit unit comprises a dummy electrode, wherein a position and a shape of the dummy electrode in one circuit unit are the same as a position and a shape of the power supply connection electrode in another circuit unit.

13. The display substrate according to claim 12, wherein an orthographic projection of the dummy electrode on the plane of the display substrate is at least partially overlapped with the orthographic projection of the second power supply trace on the plane of the display substrate.

14. The display substrate according to claim 9, wherein the first power supply trace and the first connection line are disposed in a same layer, at least one first power supply trace and at least one first connection line are disposed in at least one circuit row, a first fracture is disposed between the first connection line and the first power supply trace, and an orthographic projection of the first fracture on the plane of the display substrate is at least partially overlapped with the orthographic projection of the second power supply trace on the plane of the display substrate, or the orthographic projection of the first fracture on the plane of the display substrate is at least partially overlapped with the orthographic projection of the second connection line on the plane of the display substrate.

15. The display substrate according to claim 14, wherein a first width of the first fracture is less than or equal to a second width of the second power supply trace or the second connection line, wherein the first width and the second width are dimensions in the first direction, and the orthographic projection of the first fracture on the plane of the display substrate is within a range of the orthographic projection of the second power supply trace or the second connection line on the plane of the display substrate.

16. The display substrate according to claim 9, wherein the second power supply trace and the second connection line are disposed in a same layer, at least one second power supply trace and at least one second connection line are disposed in at least one circuit column, a second fracture is disposed between the second connection line and the second power supply trace, and an orthographic projection of the second fracture on the plane of the display substrate is at least partially overlapped with an orthographic projection of the first connection line or the first power supply trace on the plane of the display substrate.

17. The display substrate according to claim 16, wherein a third width of the second fracture is equal to a fourth width of the first connection line or the first power supply trace, wherein the third width and the fourth width are dimensions in the second direction, and a boundary of an orthographic projection of the second fracture on the plane of the display substrate is flush with a boundary of the orthographic projection of the first connection line or the first power supply trace on the plane of the display substrate.

18. The display substrate according to claim 9, wherein the display substrate comprises a display region and a bonding region located on one side of the display region in the second direction, wherein the bonding region is provided with a bonding power supply lead, the bonding power supply lead is configured to continuously provide a high-level signal or a low-level signal, and at least one second power supply trace of the display region is connected with the bonding power supply lead of the bonding region.

19. The display substrate according to claim 18, wherein the display substrate further comprises a bezel region located on another side of the display region, wherein the bezel region is provided with a bezel power supply lead, the bezel power supply lead is configured to continuously provide a high-level signal or a low-level signal, and a plurality of first power supply traces of the display region are connected with the bezel power supply lead of the bezel region.

20. The display substrate according to any one of claims 1 to 19, wherein at least one circuit unit at least comprises a pixel drive circuit, wherein the pixel drive circuit at least comprises a storage capacitor and a plurality of transistors; in a plane perpendicular to the display substrate, the circuit unit comprises a semiconductor layer, a first conductive layer, a second conductive layer, a third conductive layer, and a fourth conductive layer sequentially disposed on a base substrate, the semiconductor layer at least comprises active layers of the plurality of transistors, the first conductive layer at least comprises gate electrodes of the plurality of transistors and a first electrode plate of the storage capacitor, the second conductive layer at least comprises a second electrode plate of the storage capacitor, the third conductive layer at least comprises the first connection line, and the fourth conductive layer at least comprises the data signal line and the second connection line.

21. The display substrate according to claim 20, wherein the third conductive layer further comprises a data connection electrode and a fan-out connection electrode respectively connected with the first connection line, wherein the data signal line is connected with the data connection electrode through a first connection hole, and the second connection line is connected with the fan-out connection electrode through a second connection hole.

22. The display substrate according to claim 20, wherein the third conductive layer further comprises a first power supply trace extending along the first direction and a power supply connection electrode connected with the first power supply trace, the fourth conductive layer further comprises a second power supply trace extending along the second direction, and the second power supply trace is connected with the power supply connection electrode through a third connection hole.

23. The display substrate according to claim 22, wherein a first fracture is disposed between the first connection line and the first power supply trace, the first fracture is covered by the second power supply trace or the second connection line, and a second fracture is disposed between the second connection line and the second power supply trace, and a boundary of an orthographic projection of the second fracture on the plane of the display substrate is flush with a boundary of an orthographic projection of the first connection line or the first power supply trace on the plane of the display substrate.

24. The display substrate according to claim 20, wherein the third conductive layer further comprises a dummy electrode, wherein the second connection line is connected with the dummy electrode through a connection hole.

25. The display substrate according to claim 20, wherein the plurality of transistors comprise at least a first transistor as a first initialization transistor, a second transistor as a compensation transistor, a third transistor as a drive transistor, a fourth transistor as a data writing transistor, a fifth transistor and a sixth transistor as light emitting control transistors, and a seventh transistor as a second initialization transistor, wherein the second transistor and the fourth transistor being respectively located on two sides of the third transistor in the second direction.

26. The display substrate according to claim 25, wherein the first transistor comprises a first active layer, the second transistor comprises a second active layer, the third transistor comprises a third active layer, the fourth transistor comprises a fourth active layer, the fifth transistor comprises a fifth active layer, the sixth transistor comprises a sixth active layer, the seventh transistor comprises a seventh active layer, wherein the first active layer to the third active layer and the fifth active layer to the seventh active layer are connected with each other to be of an integral structure, and the fourth active layer is disposed separately.

27. The display substrate according to claim 26, wherein the fourth active layer is disposed on a side of the fifth active layer in the first direction, wherein a first region of the fourth active layer is disposed on a side of a channel region of the fourth active layer away from the third active layer, and a second region of the fourth active layer is disposed on a side of the channel region of the fourth active layer close to the third active layer.

28. The display substrate according to claim 27, wherein a first region of the fifth active layer is located between the second region of the fourth active layer and a second region of the sixth active layer.

29. The display substrate according to claim 26, wherein the storage capacitor comprises a first electrode plate and a second electrode plate, wherein an orthographic projection of the second electrode plate on the base substrate is at least partially overlapped with an orthographic projection of the first electrode plate on the base substrate, and the orthographic projection of the second electrode plate on the base substrate is at least partially overlapped with an orthographic projection of a connection point of a first region of the third active layer, a second region of the fourth active layer, and a second region of the fifth active layer on the base substrate.

30. The display substrate according to claim 29, wherein the second electrode plate is connected with a protrusion, the protrusion is disposed at a corner of the second electrode plate close to the fourth active layer, wherein an orthographic projection of the protrusion on the base substrate is at least partially overlapped with the orthographic projection of the connection point of the first region of the third active layer, the second region of the fourth active layer, and the second region of the fifth active layer on the base substrate.

31. The display substrate according to claim 29, wherein the pixel drive circuit is connected with a light emitting control line and a first power supply line, wherein the light emitting control line is configured to control turn-on or turn-off of the fifth transistor and the sixth transistor, the first power supply line is connected with the second electrode plate through a first electrode of the fifth transistor, and an orthographic projection of the first electrode of the fifth transistor on the base substrate is at least partially overlapped with an orthographic projection of the light emitting control line on the base substrate.

32. A display apparatus, comprising a display substrate according to any one of claims 1 to 31.

33. A drive method for driving a display substrate according to any one of claims 1 to 31, wherein the display substrate comprises a plurality of circuit units, wherein at least one circuit unit comprises a pixel drive circuit, the pixel drive circuit at least comprises a compensation transistor, a drive transistor, and a data writing transistor, wherein a gate electrode of the compensation transistor is connected with a first scan signal line, a first electrode of the compensation transistor is connected with a gate electrode of the drive transistor, a second electrode of the compensation transistor is connected with a second electrode of the drive transistor, a gate electrode of the data writing transistor is connected with a third scan signal line, a first electrode of the data writing transistor is connected with a data signal line, and a second electrode of the data writing transistor is connected with a first electrode of the drive transistor; the drive method comprises:

in a frame refresh phase, controlling, by the first scan signal line, the compensation transistor to be turned on, controlling, by the third scan signal line, the data writing transistor to be turned on, and providing a data voltage output by the data signal line to the gate electrode of the drive transistor;
in a frame hold phase, controlling, by the third scan signal line, the data writing transistor to be turned on, and providing the data voltage output by the data signal line the first electrode of the drive transistor.

34. A preparation method of a display substrate, wherein the display substrate comprises a plurality of circuit units, a plurality of data signal lines, and a plurality of data connection lines, wherein the data connection lines comprise a first connection line extending along a first direction and a second connection line extending along a second direction, the data signal lines extend along the second direction, and the first direction and the second direction intersect; the preparation method comprises:
forming a data connection electrode in at least one circuit unit, forming a fan-out connection electrode in at least one circuit unit, and forming a data signal line, a first connection line, and a second connection line, wherein the second connection line is connected with the first connection line through the fan-out connection electrode, and the first connection line is connected with the data signal line through the data connection electrode; an orthographic projection of the data connection electrode on a plane of the display substrate is at least partially overlapped with an orthographic projection of the data signal line on the plane of the display substrate, an orthographic projection of the fan-out connection electrode on the plane of the display substrate is at least partially overlapped with an orthographic projection of the second connection line on the plane of the display substrate, wherein there is a first distance between the data connection electrode and the first connection line, there is a second distance between the fan-out connection electrode and the first connection line, the first distance and the second distance are greater than 0, and the first distance and the second distance are dimensions in the second direction.

FIG. 1

FIG. 2

P          P3 P1   P2 P4

FIG. 3

302   301   303   304      401     402     403

104{

103{

102{

101

FIG. 4

VDD

C

T5 ∘— E

N1        T4   ∘ D

N2        T3

S1

T2   N3

T6 ∘— E

S2   T1

S1        T7  ∘ INIT2

INIT1   OLED

S1

VSS

FIG. 5

47

FIG. 6A

FIG. 6B

FIG. 7A

FIG. 7B

FIG. 8A

FIG. 8B

FIG. 9A

FIG. 9B

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

FIG. 23

FIG. 24

FIG. 25

FIG. 26

FIG. 27

FIG. 28

FIG. 29

FIG. 30

FIG. 31

FIG. 32

FIG. 33

FIG. 34

FIG. 35

FIG. 36

X
Y

91
32
22
31
21
41
25
33
42
24
45
52
23
44
32

72  51      60  92

FIG. 37

X
Y

51  60  92
71
32
22
31
21
41
25
33
42
24
45
52
23
32

C3    DF1
91    71    81  82

FIG. 38

FIG. 39

FIG. 40

FIG. 41

92

DF2

B3 B4

71(91)

72

FIG. 42

VDD

C

T5 E

N1 T4 D

N2 T3

T2 N3 S3

S2 T1 S1

T6

INIT1 T7 INIT2

OLED

VSS

FIG. 43

Refresh frame Hold frame

S2

S1

S3

D

E

FIG. 44

## INTERNATIONAL SEARCH REPORT

| | International application No. |
|---|---|
| | **PCT/CN2023/091300** |

**A.    CLASSIFICATION OF SUBJECT MATTER**

G09G3/32(2016.01)i;  H10K50/80(2023.01)n

According to International Patent Classification (IPC) or to both national classification and IPC

**B.    FIELDS SEARCHED**

Minimum documentation searched (classification system followed by classification symbols)

IPC:G09G3/-,H10K50/-,  H01L27/-

Documentation searched other than minimum documentation to the extent that such documents are included in the fields searched

Electronic data base consulted during the international search (name of data base and, where practicable, search terms used)

CNTXT, ENTXT, ENTXTC, VEN, WPABSC: 胡明, 邱海军, 王梦奇, 于子阳, 蒋志亮, 京东方, 边, 布线, 第二, 电极, 电路, 叠, 反射, 距离, 框, 连接, 连接线, 驱动, 全面屏, 扇出, 数据, 投影, 无, 显示效果, 线, 像素, 窄, 重合, data, frame, frameless, full, narrow, Projection, screen, second, Project+, Electrode?, line+, Electrode+, circuit+, fan+, pix+, Projection+, wire+, data?, drive+

**C.    DOCUMENTS CONSIDERED TO BE RELEVANT**

| Category* | Citation of document, with indication, where appropriate, of the relevant passages | Relevant to claim No. |
|---|---|---|
| PX | CN 114937686 A (BOE TECHNOLOGY GROUP CO., LTD.; CHENGDU BOE OPTOELECTRONICS TECHNOLOGY CO., LTD.) 23 August 2022 (2022-08-23) description, paragraphs 0061-0360, and figures 6-44 | 1-34 |
| A | CN 112310125 A (HEFEI BOE JOINT TECHNOLOGY CO., LTD.; BOE TECHNOLOGY GROUP CO., LTD.) 02 February 2021 (2021-02-02) entire document | 1-34 |
| A | CN 110189725 A (XIAMEN TIANMA MICRO-ELECTRONICS CO., LTD.) 30 August 2019 (2019-08-30) entire document | 1-34 |
| A | CN 114050179 A (BOE TECHNOLOGY GROUP CO., LTD.) 15 February 2022 (2022-02-15) entire document | 1-34 |
| A | US 2022037447 A1 (SAMSUNG DISPLAY CO., LTD.) 03 February 2022 (2022-02-03) entire document | 1-34 |

☐ Further documents are listed in the continuation of Box C.        ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **12 July 2023** | **20 July 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/091300**

| Patent document cited in search report | | | Publication date (day/month/year) | Patent family member(s) | | | Publication date (day/month/year) |
|---|---|---|---|---|---|---|---|
| CN | 114937686 | A | 23 August 2022 | CN | 114937686 | B | 02 December 2022 |
| CN | 112310125 | A | 02 February 2021 | CN | 112310125 | B | 09 August 2022 |
| | | | | WO | 2022089071 | A1 | 05 May 2022 |
| | | | | US | 2023043145 | A1 | 09 February 2023 |
| CN | 110189725 | A | 30 August 2019 | | None | | |
| CN | 114050179 | A | 15 February 2022 | BR | 112021012544 | A2 | 14 September 2021 |
| | | | | JP | 2022554043 | A | 28 December 2022 |
| | | | | EP | 4053903 | A1 | 07 September 2022 |
| | | | | RU | 2770179 | C1 | 14 April 2022 |
| | | | | AU | 2020376100 | A1 | 22 July 2021 |
| | | | | AU | 2020376100 | B2 | 08 December 2022 |
| | | | | MX | 2021008023 | A | 05 August 2021 |
| | | | | US | 2021376046 | A1 | 02 December 2021 |
| | | | | KR | 20210053814 | A | 12 May 2021 |
| | | | | KR | 102476703 | B1 | 14 December 2022 |
| | | | | WO | 2021083298 | A1 | 06 May 2021 |
| US | 2022037447 | A1 | 03 February 2022 | JP | 2022500684 | A | 04 January 2022 |
| | | | | KR | 20200031194 | A | 24 March 2020 |
| | | | | EP | 3852146 | A1 | 21 July 2021 |
| | | | | EP | 3852146 | A4 | 22 June 2022 |
| | | | | WO | 2020054994 | A1 | 19 March 2020 |

Form PCT/ISA/210 (patent family annex) (July 2022)

**EP 4 421 789 A1**

**Patent documents cited in the description**

- CN 2022093952 W

- CN 202210874018